# EUROPEAN PATENT SPECIFICATION

(11) **EP 4 023 654 B1**
(45) Date of publication and mention of the grant of the patent: **05.11.2025**
(21) Application number: 21211086.0
(22) Date of filing: 29.11.2021
(51) Int. Cl.: H10K 50/11, H10K 85/60

(54) **EMITTING COMPOUND AND ORGANIC LIGHT EMITTING DEVICE INCLUDING THE SAME**
EMITTIERENDE VERBINDUNG UND ORGANISCHE LICHTEMITTIERENDE VORRICHTUNG DAMIT
COMPOSÉ ÉLECTROLUMINESCENT ET DISPOSITIF ÉLECTROLUMINESCENT ORGANIQUE LE COMPRENANT

(30) Priority: 29.12.2020 KR 20200186022
(43) Date of publication of application: 06.07.2022
(73) Proprietor: LG Display Co., Ltd., SEOUL, 07336 (KR)
(72) Inventor: Choi, Su-Na, Paju-si, Gyeonggi-do 10845 (KR); Song, In-Bum, Paju-si, Gyeonggi-do 10845 (KR); Seo, Jeong-Dae, Paju-si, Gyeonggi-do 10845 (KR)
(74) Representative: Ter Meer Steinmeister & Partner

(56) References cited:
- EP-A1- 3 660 024
- EP-A1- 3 680 244
- WO-A1-2020/080872
- WO-A1-2020/111830
- CN-A- 111 647 009
- US-A1- 2020 058 885

## Description

### BACKGROUND

### Field of the Disclosure

The present disclosure relates to an emitting compound, and more specifically, to an emitting compound having high emitting efficiency and lifespan and an organic light emitting device including the same.

### Description of the Background

As requests for a flat panel display device having a small occupied area have been increased, an organic light emitting display device including an organic light emitting diode (OLED) has been the subject of recent research and development.

The OLED emits light by injecting electrons from a cathode as an electron injection electrode and holes from an anode as a hole injection electrode into an emitting material layer (EML), combining the electrons with the holes, generating an exciton, and transforming the exciton from an excited state to a ground state. A flexible substrate, for example, a plastic substrate, can be used as a base substrate where elements are formed. In addition, the organic light emitting display device can be operated at a voltage (e.g., 10V or below) lower than a voltage required to operate other display devices. Moreover, the organic light emitting display device has advantages in the power consumption and the color sense.

For example, the organic light emitting display device may include a red pixel region, a green pixel region and a blue pixel region, and the OLED may be formed in each of the red, green and blue pixel regions.

However, the OLED in the blue pixel does not provide sufficient emitting efficiency and lifespan such that the organic light emitting display device has a limitation in the emitting efficiency and the lifespan. The Document US 2020/058885 A1 discloses a luminescent compound comprising a condensed heterostructure.

### SUMMARY

The present disclosure is directed to an emitting compound and an organic light emitting device including the emitting compound that substantially obviates one or more of the problems associated with the limitations and disadvantages of the related conventional art.

These objects are solved by the features of the independent claim. Additional features and advantages of the present disclosure are set forth in the description which follows, and will be apparent from the description, or evident by practice of the present disclosure. The features and other advantages of the present disclosure are realized and attained by the features described herein as well as in the appended drawings.

To achieve these and other advantages in accordance with the purpose of the aspects of the present disclosure, as described herein, an aspect of the present disclosure is an emitting compound represented by Formula 1: 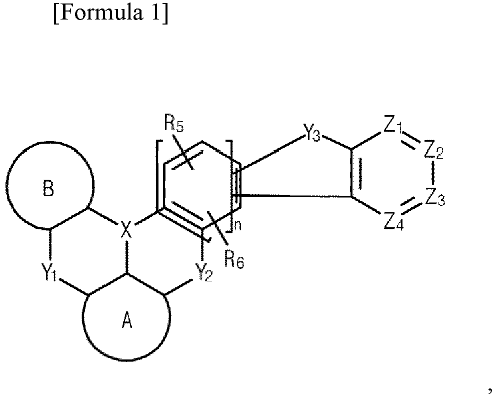 wherein n is 0 or 1, and X is one of B, P=O and P=S, wherein each of Y₁ and Y₂ is independently selected from the group consisting of NR₁, C(R₂)₂, O, S, Se and Si(R₃)₂, and Y₃ is O or S, wherein each of Z₁ to Z₄ is independently N or CR₄, and at least three of Z₁ to Z₄ are CR₄, wherein each of R₁ to R₃ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, wherein each of R₄ to R₆ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, or adjacent two of R₄ to R₆ are connected to each other to form a fused ring, and at least one of R₄ to R₆ is C1 to C10 alkyl substituted with deuterium, and wherein each of A and B rings is independently selected from the group consisting of substituted or unsubstituted six-membered cycloalkyl ring, substituted or unsubstituted six-membered aromatic ring and substituted or unsubstituted six-membered hetroaromatic ring.

Another aspect of the present disclosure is an organic light emitting device comprising a substrate; and an organic light emitting diode positioned on the substrate and including a first electrode; a second electrode facing the first electrode; and a first emitting material layer including a first compound and positioned between the first and second electrodes, wherein the first compound is the above emitting compound.

According to another aspect, an emitting compound is represented by Formula 1: 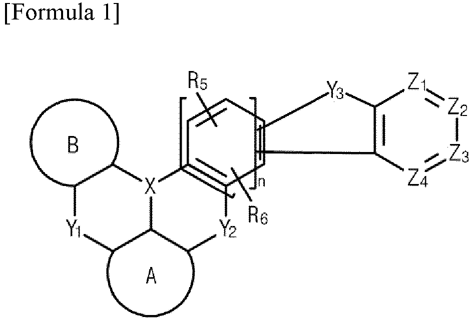
wherein n is 0 or 1,
X is one of B, P=O and P=S,
each of Y₁ and Y₂ is independently selected from the group consisting of NR₁, C(R₂)₂, O, S, Se and Si(R₃)₂, and
Y₃ is O or S,
wherein each of Z₁ to Z₄ is independently N or CR₄, and at least three of Z₁ to Z₄ are CR₄,
wherein each of R₁ to R₃ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl,
wherein each of R₄ to R₆ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, or adjacent two of R₄ to R₆ are connected to each other to form a fused ring, and at least one of R₄ to R₆ is C1 to C10 alkyl substituted with deuterium, and
wherein each of A and B rings is independently selected from the group consisting of substituted or unsubstituted six-membered cycloalkyl ring, substituted or unsubstituted six-membered aromatic ring and substituted or unsubstituted six-membered heteroaromatic ring. In the present invention Formula 1 is represented by one of Formula 2-1, Formula 3-1, Formula 4-1 and Formula 5-1.

The Formula 1 may be represented by Formula 2-1:

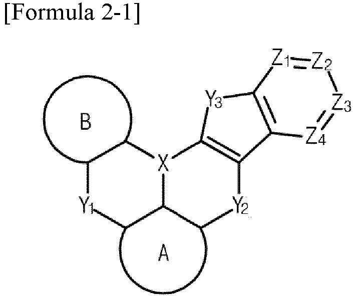

The Formula 2-1 may be represented by Formula 2-2: 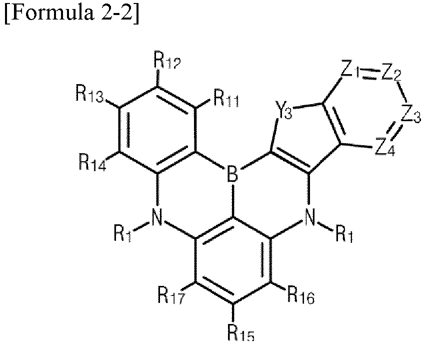
wherein in the Formula 2-2, one of Z₁ to Z₄ is N, and three of Z₁ to Z₄ are CR₄,
wherein at least one of three R₄ is deuterium-substituted C1 to C10 alkyl group, and
wherein each of R₁₁ to R₁₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

The Formula 1 may be represented by Formula 3-1:

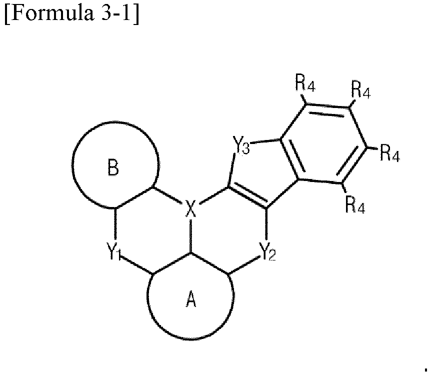

The Formula 3-1 may be represented by Formula 3-2: 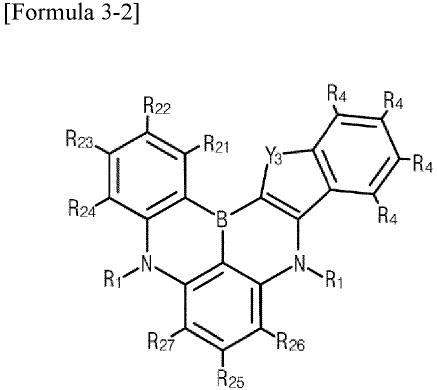
wherein in the Formula 3-2, adjacent two of R₄ are connected to each other to form a fused ring, and at least one of the other two R₄ is deuterium-substituted C1 to C10 alkyl, and
wherein each of R₂₁ to R₂₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

The Formula 1 may be represented by Formula 4-1:

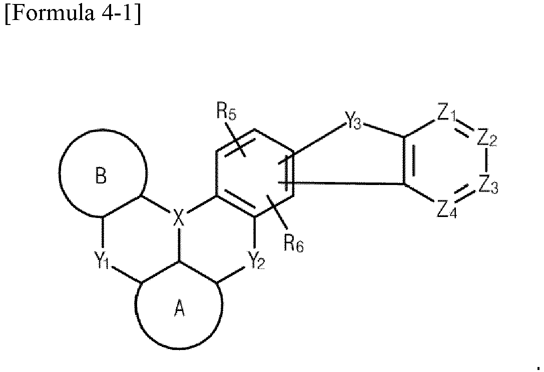

The Formula 4-1 may be represented by one of Formulas 4-2 to 4-4: 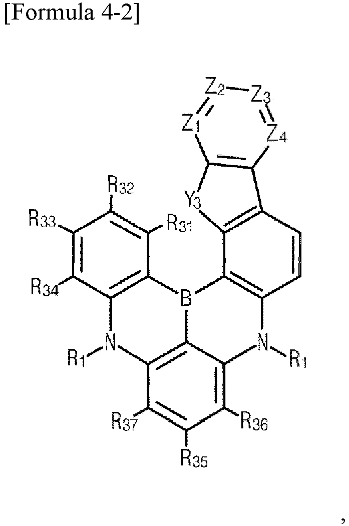 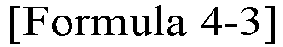 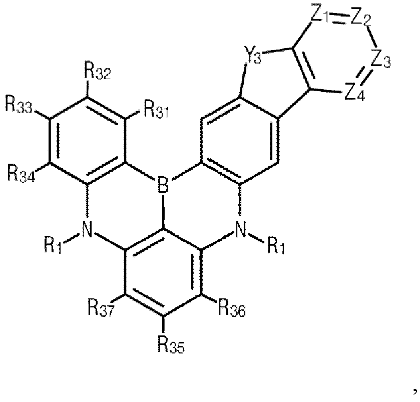 , and 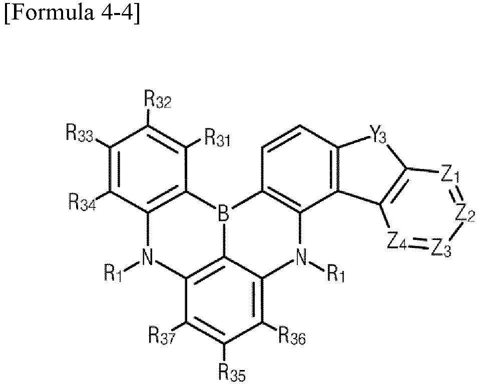 ,
wherein in the Formulas 4-2 to 4-4, one of Z₁ to Z₄ is N, and three of Z₁ to Z₄ are CR₄,
wherein at least one of three R₄ is deuterium-substituted C1 to C10 alkyl group, and
wherein each of R₃₁ to R₃₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

The Formulas 4-2 to 4-4 may be respectively represented by Formulas 4-5 to 4-7: 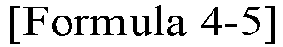 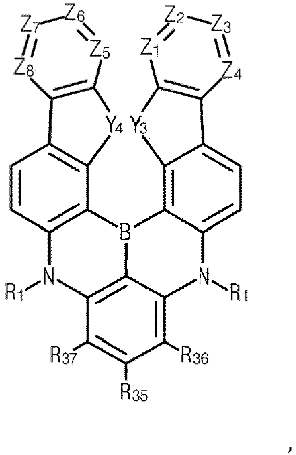 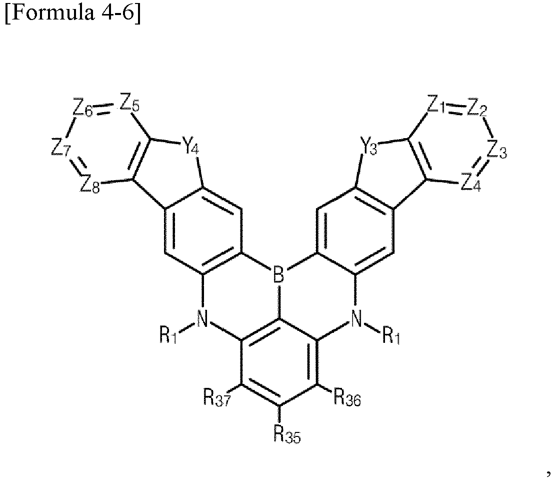 and 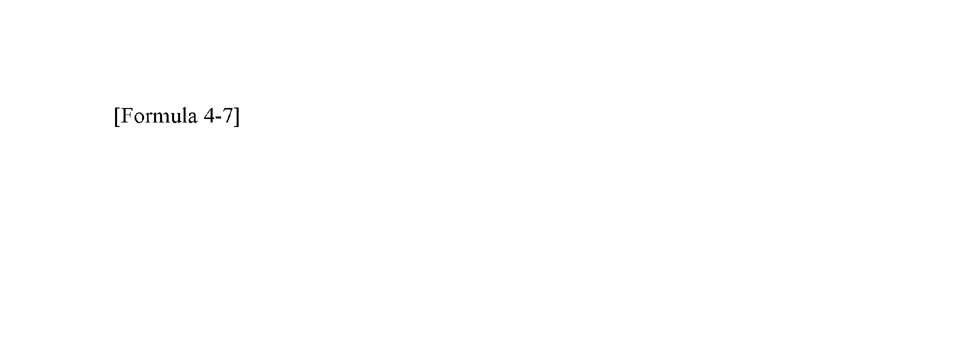 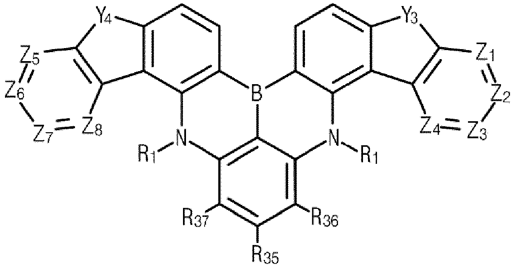
wherein in the Formulas 4-5 to 4-7, Y₄ is O or S,
wherein one of Z₅ to Z₈ is N, and the other three of Z₅ to Z₈ are CR₇,
wherein each of three R₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, and at least one of three R₇ is deuterium -substituted C1 to C10 alkyl group, and
wherein each of R₃₅ to R₃₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

The Formula 1 may be represented by Formula 5-1:

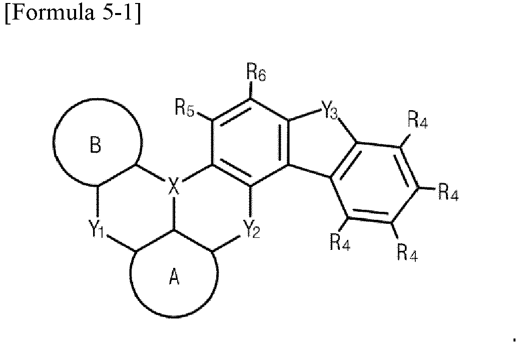

The Formula 5-1 may be represented by Formula 5-2: 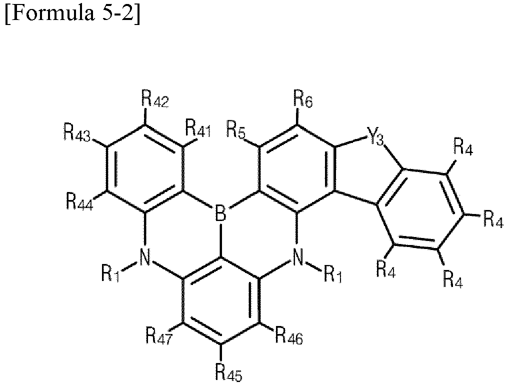
wherein in the Formula 5-2, adjacent two of four R₄ or R₅ and R₆ is connected to form a fused ring, and at least one of the other four of R₄, R₅ and R₆ is deuterium-substituted C1 to C10 alkyl group, and
wherein each of R₄₁ to R₄₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

The Formula 5-1 may be represented by Formula 5-3: 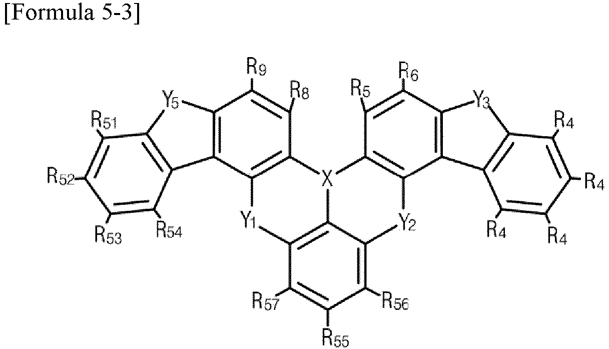
wherein in the Formula 5-3, Y₅ is O or S,
wherein adjacent two of four R₄ or R₅ and R₆ is connected to form a fused ring, and at least one of the other four of R₄, R₅ and R₆ is deuterium-substituted C1 to C10 alkyl group,
wherein each of R₈, R₉ and R₅₁ to R₅₄ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, or adjacent two of R₅₁ to R₅₄ or R₈ and R₉ is connected to form a fused ring,
wherein at least one of the other four of R₈, R₉ and R₅₁ to R₅₄ is deuterium-substituted C1 to C10 alkyl group, and
wherein each of R₅₅ to R₅₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

The Formula 5-3 may be represented by Formula 5-4:

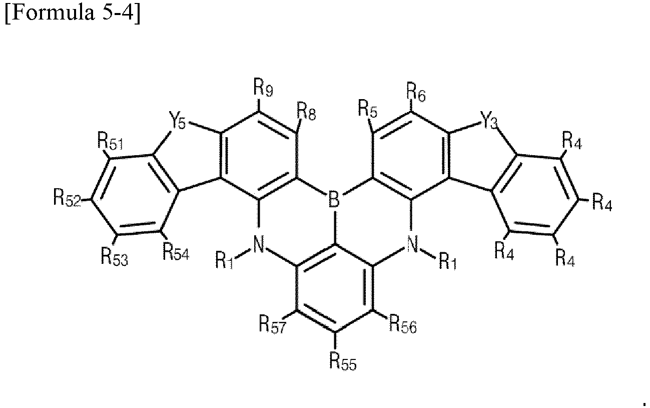

The emitting compound may be one compound selected from the group of compounds represented by Formula 6:

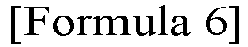

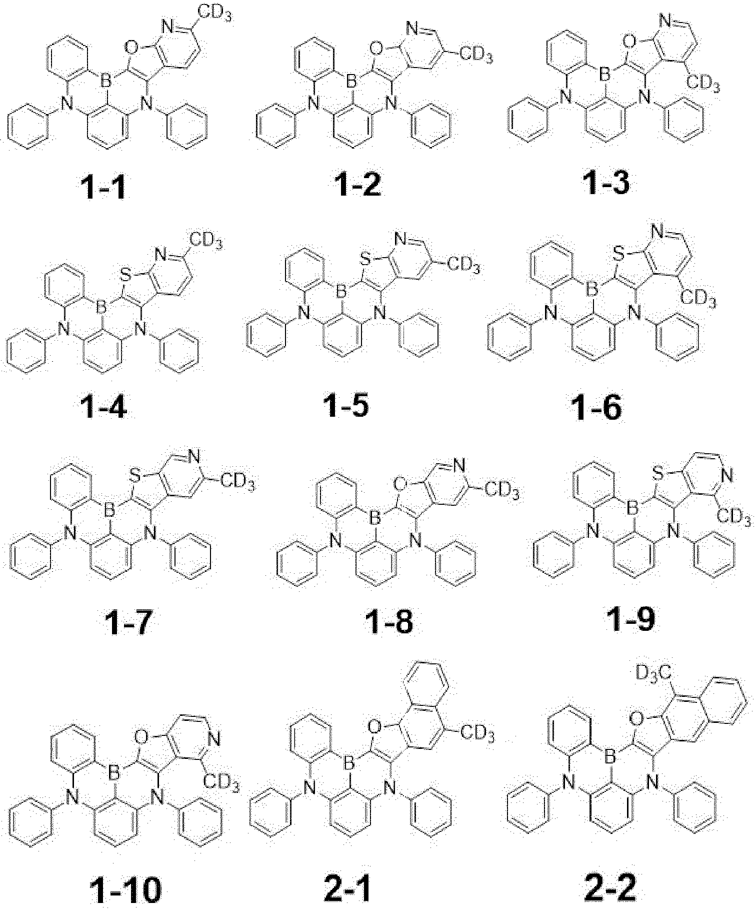

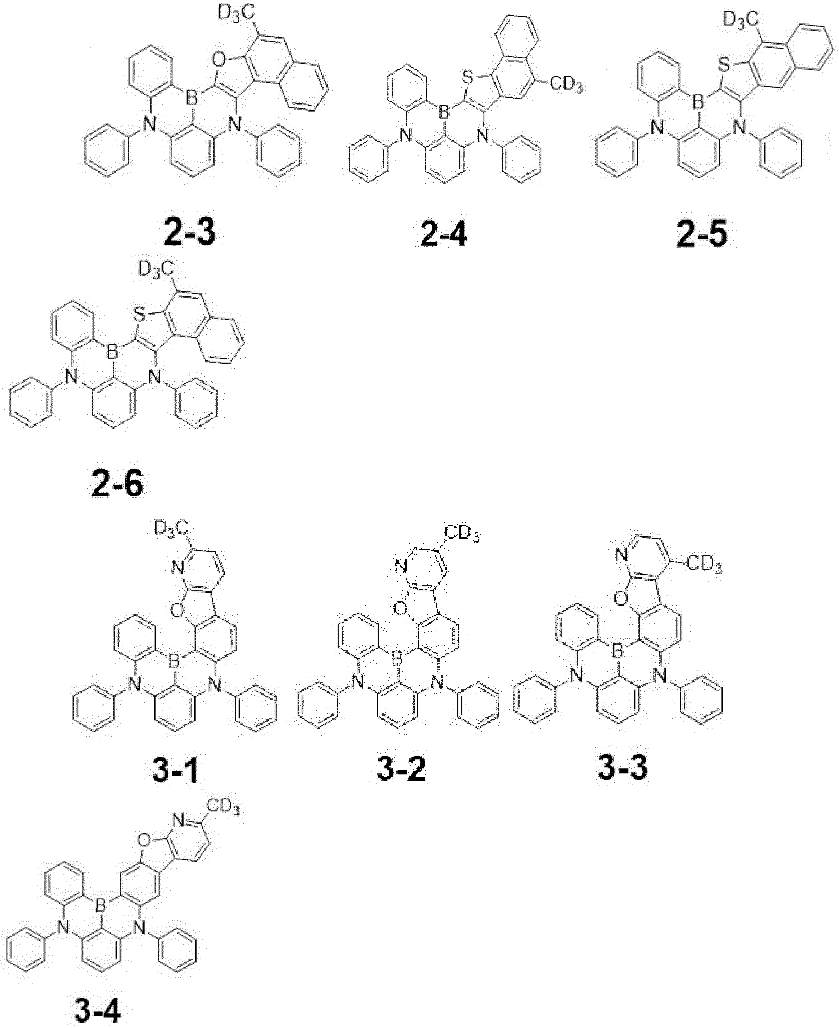

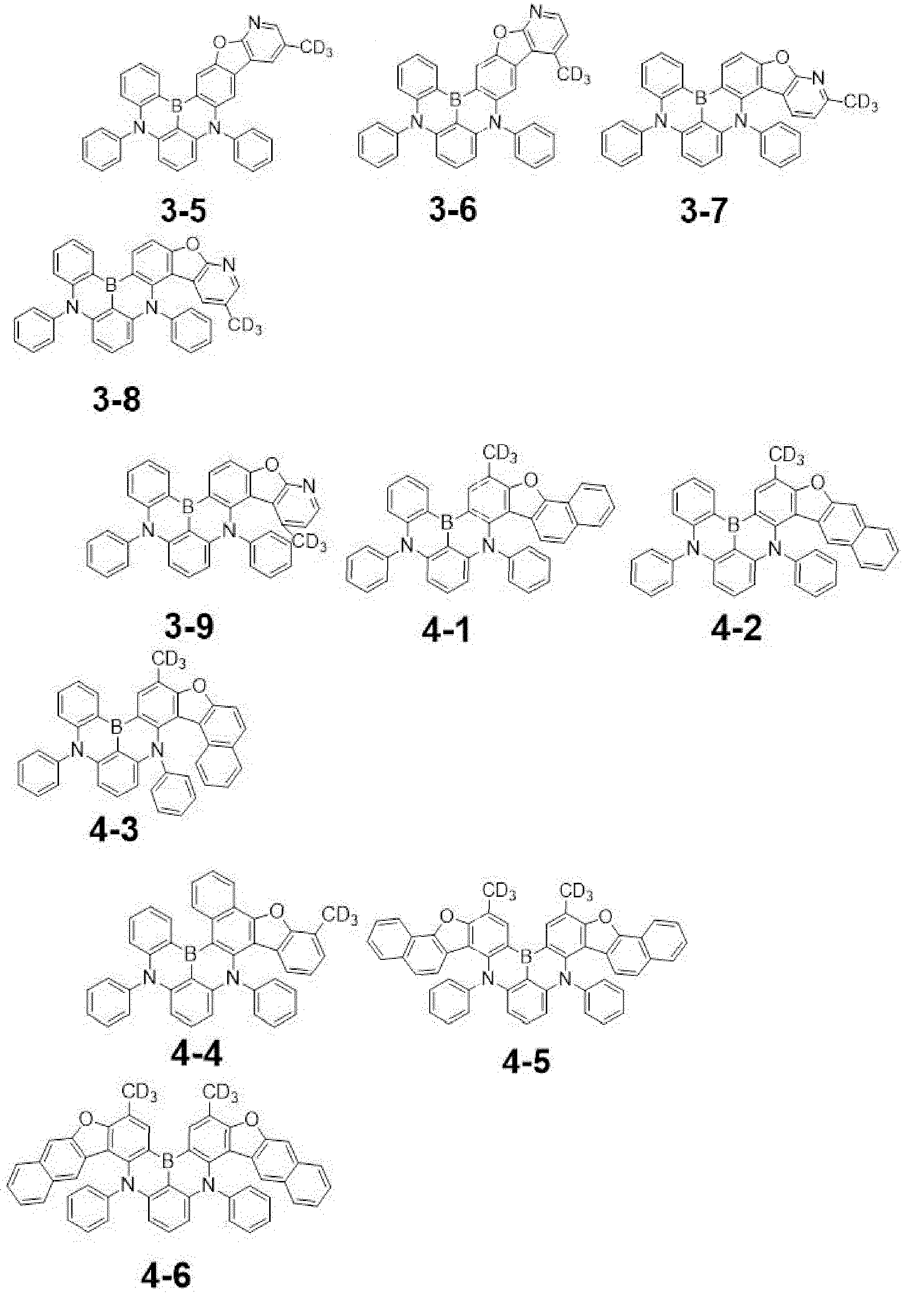

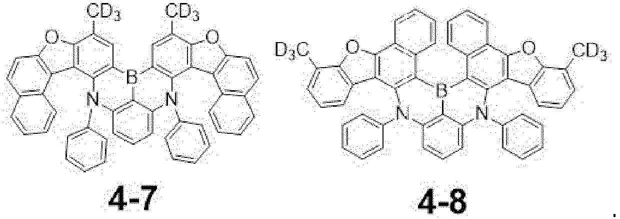

According to another aspect, an organic light emitting device, comprises: a substrate; and an organic light emitting diode positioned on the substrate and including a first electrode; a second electrode facing the first electrode; and a first emitting material layer including a first compound and positioned between the first and second electrodes, wherein the first compound is the emitting compound according to any one of the above described aspects and embodiments.

The first emitting material layer may further include a second compound,
wherein the second compound is represented by Formula 7: 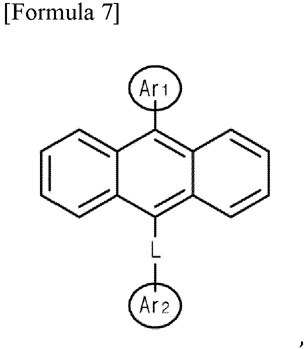
wherein each of Ar₁ and Ar₂ is independently C6 to C30 aryl group or C5 to C30 heteroaryl group, L is a single bond or C6 to C30 arylene group, and
wherein hydrogens are not deuterated or partially or wholly deuterated.

The organic light emitting diode may further include: a second emitting material layer including a third compound and positioned between the first emitting material layer and the second electrode; and a first charge generation layer between the first and second emitting material layers, and wherein the third compound is the emitting compound according to any one of the above described aspects and embodiments.

The organic light emitting diode may further include: a third emitting material layer positioned between the first charge generation layer and the second emitting material layer; and a second charge generation layer between the second and third emitting material layers, and wherein the third emitting material layer emits a yellow-green light or red and green lights.

The organic light emitting diode may further include: a second emitting material layer emitting a yellow-green light and positioned between the first emitting material layer and the second electrode; and a charge generation layer between the first and second emitting material layers.

A red pixel, a green pixel and a blue pixel may be defined on the substrate. The organic light emitting diode may correspond to each of the red, green and blue pixels. The organic light emitting device may further include a color filter layer disposed between the substrate and the organic light emitting diode or on the organic light emitting diode and corresponding to the red, green and blue pixels.

The first compound may be one compound selected from the group of compounds represented by Formula 8:

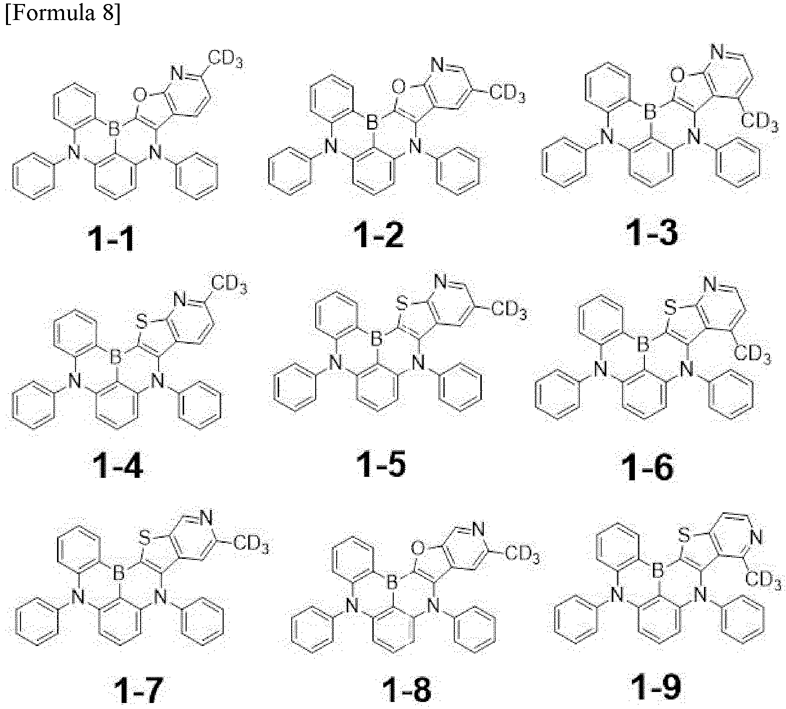

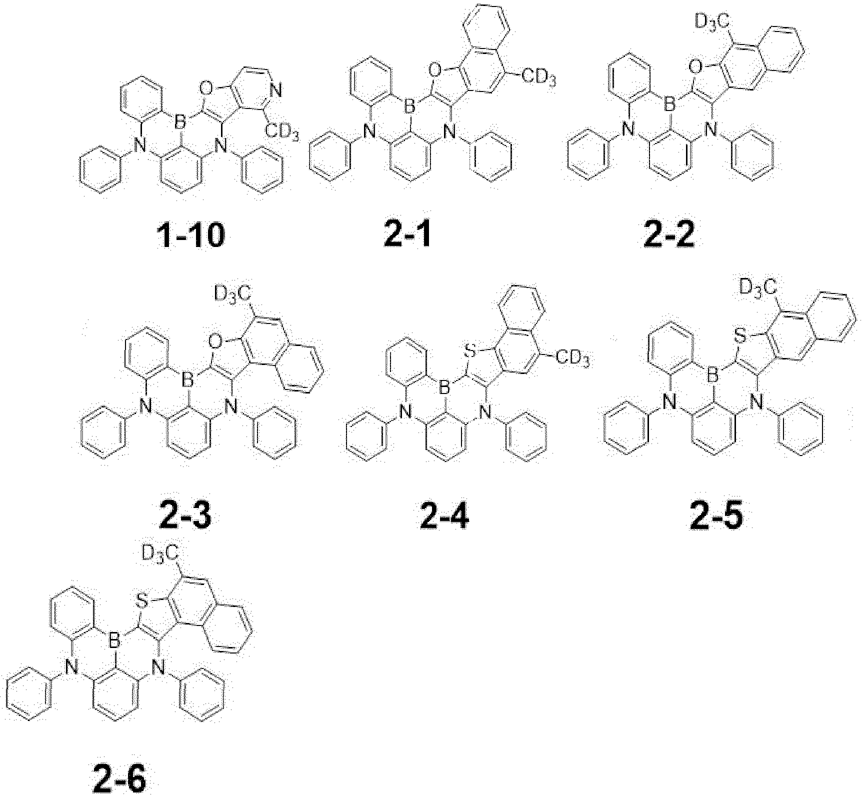

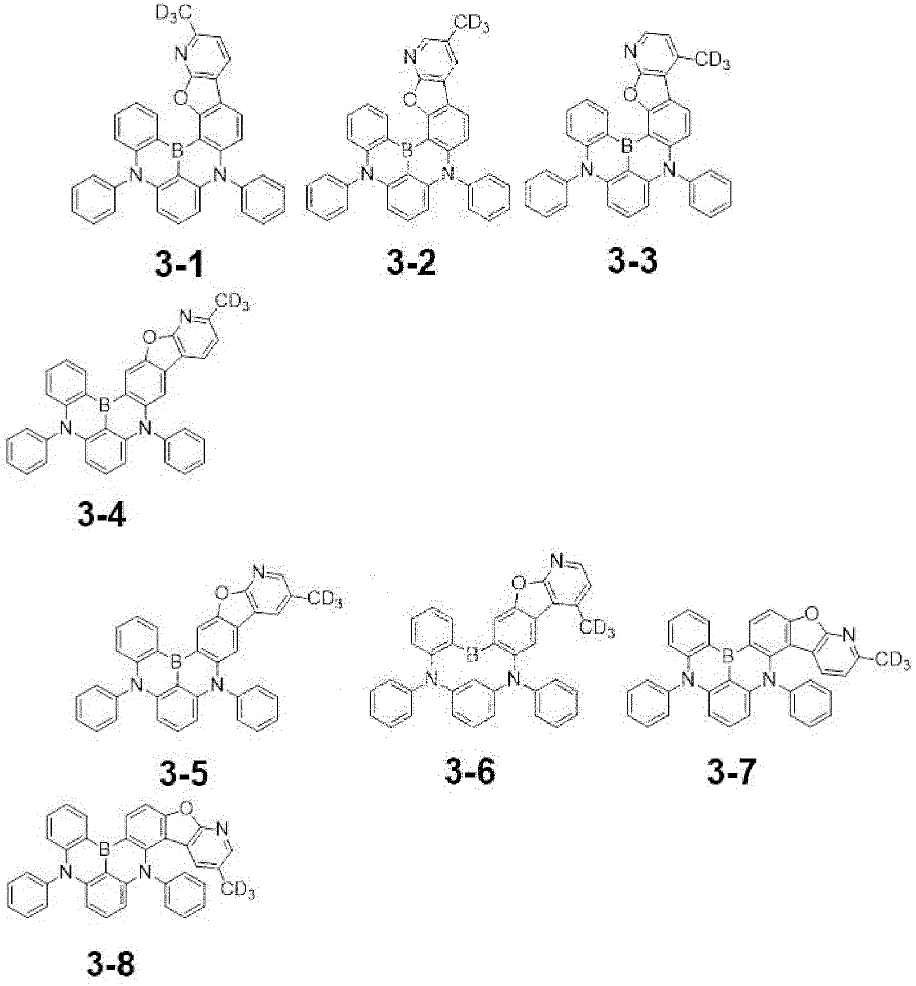

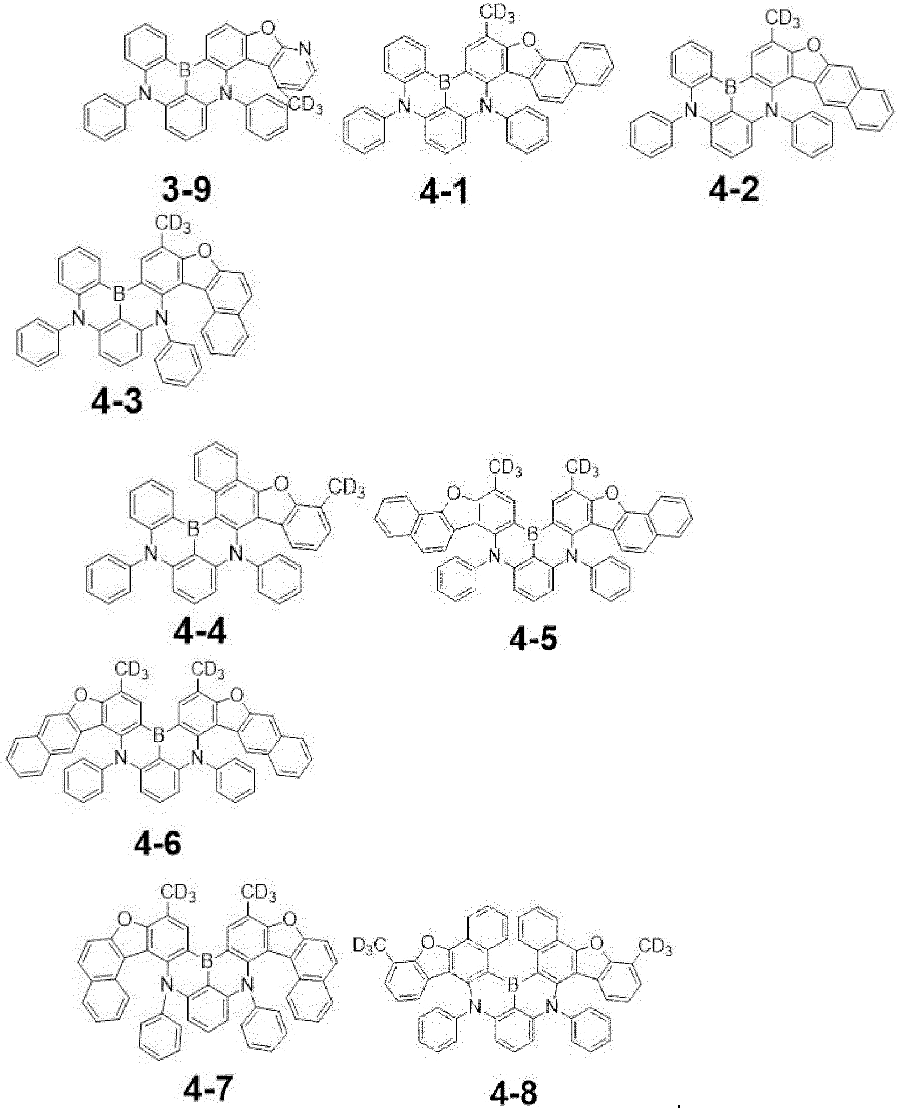

It is to be understood that both the foregoing general description and the following detailed description are exemplary and explanatory and are intended to further explain the present disclosure as claimed.

### BRIEF DESCRIPTION OF THE DRAWINGS

The accompanying drawings, which are included to provide a further understanding of the present disclosure and are incorporated in and constitute a part of this specification, illustrate aspects of the present disclosure and together with the description serve to explain the principles of the present disclosure.
FIG. 1 is a schematic circuit diagram illustrating an organic light emitting display device of the present disclosure;
FIG. 2 is a schematic cross-sectional view illustrating an organic light emitting display device according to a first aspect of the present disclosure;
FIG. 3 is a schematic cross-sectional view illustrating an OLED having a single emitting part for the organic light emitting display device according to the first aspect of the present disclosure;
FIG. 4 is a schematic cross-sectional view illustrating an OLED having a tandem structure of two emitting parts for the organic light emitting display device according to the first aspect of the present disclosure;
FIG. 5 is a schematic cross-sectional view illustrating an organic light emitting display device according to a second aspect of the present disclosure;
FIG. 6 is a schematic cross-sectional view illustrating an OLED having a tandem structure of two emitting parts for the organic light emitting display device according to the second aspect of the present disclosure;
FIG. 7 is a schematic cross-sectional view illustrating an OLED having a tandem structure of three emitting parts for the organic light emitting display device according to the second aspect of the present disclosure; and
FIG. 8 is a schematic cross-sectional view illustrating an organic light emitting display device according to a third aspect of the present disclosure.

### DETAILED DESCRIPTION

Reference will now be made in detail to some of the examples and aspects, which are illustrated in the accompanying drawings.

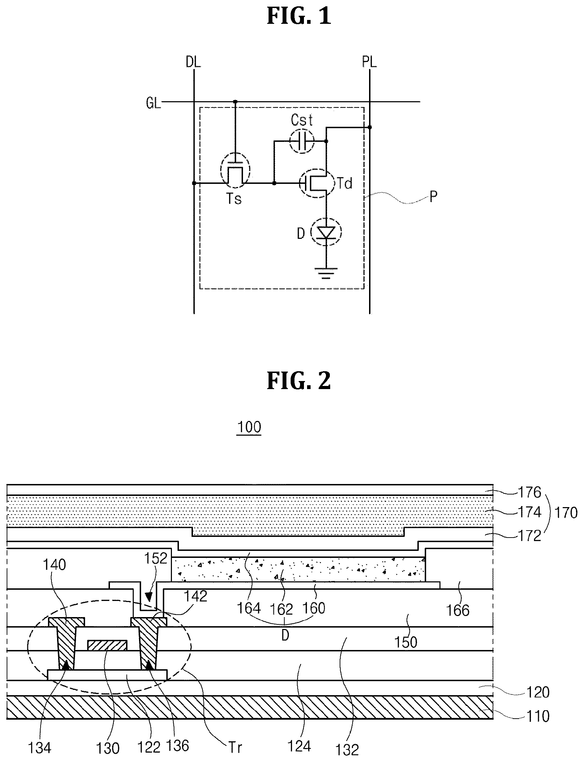

FIG. 1 is a schematic circuit diagram illustrating an organic light emitting display device of the present disclosure.

As illustrated in FIG. 1, a gate line GL and a data line DL, which cross each other to define a pixel (pixel region) P, and a power line PL are formed in an organic light emitting display device. A switching thin film transistor (TFT) Ts, a driving TFT Td, a storage capacitor Cst and an OLED D are formed in the pixel region P. The pixel region P may include a red pixel, a green pixel and a blue pixel.

The switching thin film transistor Ts is connected to the gate line GL and the data line DL, and the driving thin film transistor Td and the storage capacitor Cst are connected between the switching thin film transistor Ts and the power line PL. The OLED D is connected to the driving thin film transistor Td. When the switching thin film transistor Ts is turned on by the gate signal applied through the gate line GL, the data signal applied through the data line DL is applied a gate electrode of the driving thin film transistor Td and one electrode of the storage capacitor Cst through the switching thin film transistor Ts.

The driving thin film transistor Td is turned on by the data signal applied into the gate electrode so that a current proportional to the data signal is supplied from the power line PL to the OLED D through the driving thin film transistor Td. The OLED D emits light having a luminance proportional to the current flowing through the driving thin film transistor Td. In this case, the storage capacitor Cst is charge with a voltage proportional to the data signal so that the voltage of the gate electrode in the driving thin film transistor Td is kept constant during one frame. Therefore, the organic light emitting display device can display a desired image.

FIG. 2 is a schematic cross-sectional view illustrating an organic light emitting display device according to a first aspect of the present disclosure.

As illustrated in FIG. 2, the organic light emitting display device 100 includes a substrate 110, a TFT Tr and an OLED D connected to the TFT Tr. For example, the organic light emitting display device 100 may include a red pixel, a green pixel and a blue pixel, and the OLED D may be formed in each of the red, green and blue pixels. Namely, the OLEDs D emitting red light, green light and blue light may be provided in the red, green and blue pixels, respectively.

The substrate 110 may be a glass substrate or a flexible substrate. For example, the flexible substrate may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 120 is formed on the substrate, and the TFT Tr is formed on the buffer layer 120. The buffer layer 120 may be omitted.

A semiconductor layer 122 is formed on the buffer layer 120. The semiconductor layer 122 may include an oxide semiconductor material or polycrystalline silicon.

When the semiconductor layer 122 includes the oxide semiconductor material, a light-shielding pattern (not shown) may be formed under the semiconductor layer 122. The light to the semiconductor layer 122 is shielded or blocked by the light-shielding pattern such that thermal degradation of the semiconductor layer 122 can be prevented. On the other hand, when the semiconductor layer 122 includes polycrystalline silicon, impurities may be doped into both sides of the semiconductor layer 122.

A gate insulating layer 124 is formed on the semiconductor layer 122. The gate insulating layer 124 may be formed of an inorganic insulating material such as silicon oxide or silicon nitride.

A gate electrode 130, which is formed of a conductive material, e.g., metal, is formed on the gate insulating layer 124 to correspond to a center of the semiconductor layer 122.

In FIG. 2, the gate insulating layer 124 is formed on an entire surface of the substrate 110. Alternatively, the gate insulating layer 124 may be patterned to have the same shape as the gate electrode 130.

An interlayer insulating layer 132, which is formed of an insulating material, is formed on the gate electrode 130. The interlayer insulating layer 132 may be formed of an inorganic insulating material, e.g., silicon oxide or silicon nitride, or an organic insulating material, e.g., benzocyclobutene or photo-acryl.

The interlayer insulating layer 132 includes first and second contact holes 134 and 136 exposing both sides of the semiconductor layer 122. The first and second contact holes 134 and 136 are positioned at both sides of the gate electrode 130 to be spaced apart from the gate electrode 130.

The first and second contact holes 134 and 136 are formed through the gate insulating layer 124. Alternatively, when the gate insulating layer 124 is patterned to have the same shape as the gate electrode 130, the first and second contact holes 134 and 136 is formed only through the interlayer insulating layer 132.

A source electrode 140 and a drain electrode 142, which are formed of a conductive material, e.g., metal, are formed on the interlayer insulating layer 132.

The source electrode 140 and the drain electrode 142 are spaced apart from each other with respect to the gate electrode 130 and respectively contact both sides of the semiconductor layer 122 through the first and second contact holes 134 and 136.

The semiconductor layer 122, the gate electrode 130, the source electrode 140 and the drain electrode 142 constitute the TFT Tr. The TFT Tr serves as a driving element. Namely, the TFT Tr may correspond to the driving TFT Td (of FIG. 1).

In the TFT Tr, the gate electrode 130, the source electrode 140, and the drain electrode 142 are positioned over the semiconductor layer 122. Namely, the TFT Tr has a coplanar structure.

Alternatively, in the TFT Tr, the gate electrode may be positioned under the semiconductor layer, and the source and drain electrodes may be positioned over the semiconductor layer such that the TFT Tr may have an inverted staggered structure. In this instance, the semiconductor layer may include amorphous silicon.

Although not shown, the gate line and the data line cross each other to define the pixel, and the switching TFT is formed to be connected to the gate and data lines. The switching TFT is connected to the TFT Tr as the driving element.

In addition, the power line, which may be formed to be parallel to and spaced apart from one of the gate and data lines, and the storage capacitor for maintaining the voltage of the gate electrode of the TFT Tr in one frame may be further formed.

A passivation layer 150, which includes a drain contact hole 152 exposing the drain electrode 142 of the TFT Tr, is formed to cover the TFT Tr.

A first electrode 160, which is connected to the drain electrode 142 of the TFT Tr through the drain contact hole 152, is separately formed in each pixel and on the passivation layer 150. The first electrode 160 may be an anode and may be formed of a conductive material, e.g., a transparent conductive oxide (TCO), having a relatively high work function. For example, the first electrode 160 may be formed of indium-tin-oxide (ITO), indium-zinc-oxide (IZO), indium-tin-zinc-oxide (ITZO), tin oxide (SnO), zinc oxide (ZnO), indium-copper-oxide (ICO) or aluminum-zinc-oxide (Al:ZnO, AZO).

When the organic light emitting display device 100 is operated in a bottom-emission type, the first electrode 160 may have a single-layered structure of the transparent conductive material layer. When the Organic light emitting display device 100 is operated in a top-emission type, a reflection electrode or a reflection layer may be formed under the first electrode 160. For example, the reflection electrode or the reflection layer may be formed of silver (Ag) or aluminum-palladium-copper (APC) alloy. In this instance, the first electrode 160 may have a triple-layered structure of ITO/Ag/ITO or ITO/APC/ITO.

A bank layer 166 is formed on the passivation layer 150 to cover an edge of the first electrode 160. Namely, the bank layer 166 is positioned at a boundary of the pixel and exposes a center of the first electrode 160 in the pixel.

An organic emitting layer 162 is formed on the first electrode 160. The organic emitting layer 162 may have a single-layered structure of an emitting material layer including an emitting material. To increase an emitting efficiency of the OLED D and/or the organic light emitting display device 100, the organic emitting layer 162 may have a multi-layered structure.

The organic emitting layer 162 is separated in each of the red, green and blue pixels. As illustrated below, the organic emitting layer 162 in the blue pixel includes an emitting compound of Formula 1 such that the emitting efficiency and the lifespan of the OLED D in the blue pixel are improved.

A second electrode 164 is formed over the substrate 110 where the organic emitting layer 162 is formed. The second electrode 164 covers an entire surface of the display area and may be formed of a conductive material having a relatively low work function to serve as a cathode. For example, the second electrode 164 may be formed of aluminum (Al), magnesium (Mg), calcium (Ca), silver (Ag) or their alloy or combination. In the top-emission type organic light emitting display device 100, the second electrode 164 may have a thin profile (small thickness) to provide a light transmittance property (or a semi-transmittance property).

The first electrode 160, the organic emitting layer 162 and the second electrode 164 constitute the OLED D.

An encapsulation film 170 is formed on the second electrode 164 to prevent penetration of moisture into the OLED D. The encapsulation film 170 includes a first inorganic insulating layer 172, an organic insulating layer 174 and a second inorganic insulating layer 176 sequentially stacked, but it is not limited thereto. The encapsulation film 170 may be omitted.

The Organic light emitting display device 100 may further include a polarization plate (not shown) for reducing an ambient light reflection. For example, the polarization plate may be a circular polarization plate. In the bottom-emission type organic light emitting display device 100, the polarization plate may be disposed under the substrate 110. In the top-emission type organic light emitting display device 100, the polarization plate may be disposed on or over the encapsulation film 170.

In addition, in the top-emission type organic light emitting display device 100, a cover window (not shown) may be attached to the encapsulation film 170 or the polarization plate. In this instance, the substrate 110 and the cover window have a flexible property such that a flexible organic light emitting display device may be provided.

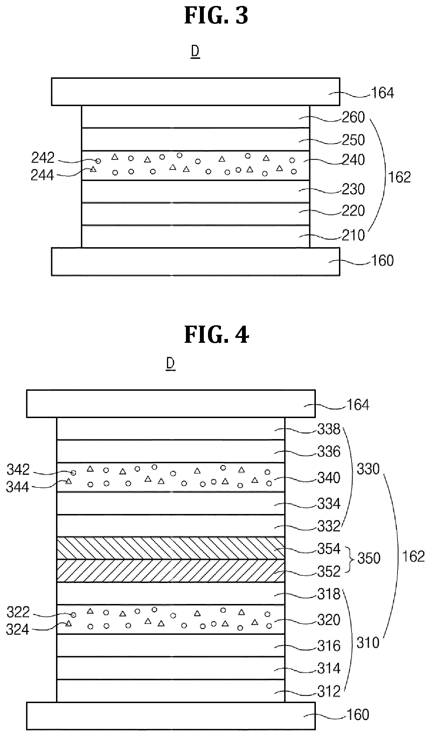

FIG. 3 is a schematic cross-sectional view illustrating an OLED having a single emitting unit for the organic light emitting display device according to the first aspect of the present disclosure.

As illustrated in FIG. 3, the OLED D includes the first and second electrodes 160 and 164, which face each other, and the organic emitting layer 162 therebetween. The organic emitting layer 162 includes an emitting material layer (EML) 240 between the first and second electrodes 160 and 164. The organic light emitting display device 100 (of FIG. 2) may include a red pixel, a green pixel and a blue pixel, and the OLED D may be positioned in the blue pixel.

One of the first and second electrodes 160 and 164 is an anode, and the other one of the first and second electrodes 160 and 164 is cathode. In addition, one of the first and second electrodes 160 and 164 may be a transparent (or a semi-transparent) electrode, and the other one of the first and second electrodes 160 and 164 may be a reflection electrode.

The organic emitting layer 162 may further include an electron blocking layer (EBL) 230 between the first electrode 160 and the EML 240 and a hole blocking layer (HBL) 250 between the EML 240 and the second electrode 164.

In addition, the organic emitting layer 162 may further include a hole transporting layer (HTL) 220 between the first electrode 160 and the EBL 230.

Moreover, the organic emitting layer 162 may further include a hole injection layer (HIL) 210 between the first electrode 160 and the HTL 220 and an electron injection layer (EIL) 260 between the second electrode 164 and the HBL 250.

The EML 240 includes an emitting compound 242 as a first compound. The emitting compound is a polycyclic aromatic compound and is represented by Formula 1, wherein Formula 1 in the present invention is represented by one of Formula 2-1, Formula 3-1, Formula 4-1 and Formula 5-1.

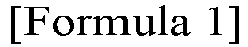

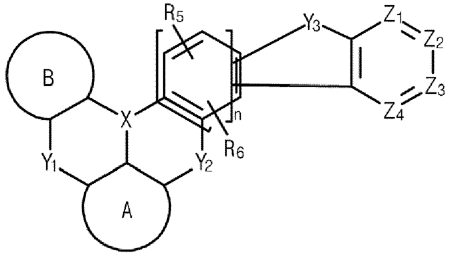

In Formula 1, n is 0 or 1, and X is one of B, P=O and P=S. Each of Y₁ and Y₂ is independently selected from the group consisting of NR₁, C(R₂)₂, O, S, Se and Si(R₃)₂, and Y₃ is O or S. Each of Z₁ to Z₄ is independently N or CR₄, and at least three of Z₁ to Z₄ are CR₄. Each of R₁ to R₃ is independently selected from the group consisting of hydrogen, deuterium (D), C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl. In addition, each of R₄ to R₆ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, or adjacent two of R₄ to R₆ are connected (combined) to each other to form a fused ring. At least one of R₄ to R₆ is C1 to C10 alkyl substituted with deuterium.

Each of A and B rings is independently selected from the group consisting of substituted or unsubstituted six-membered cycloalkyl ring, substituted or unsubstituted six-membered aromatic ring and substituted or unsubstituted six-membered hetroaromatic ring.

The fused ring may be C6 to C30 aromatic ring or C5 to C30 heteroaromatic (fused) ring. For example, the fused ring of C6 to C30 aromatic ring may be benzene ring or naphthalene ring.

In each of the A and B rings, hydrogen may be substituted by at least one of D, C1 to C10 alkyl group unsubstituted or substituted with deuterium, C6 to C30 aryl group and C5 to C30 heteroaryl group.

For example, in Formula 1, n may be 0. Namely, the five-membered ring including Y₃ may be directly connected to X and Y₂, and the emitting compound in Formula 1 may be represented by Formula 2-1.

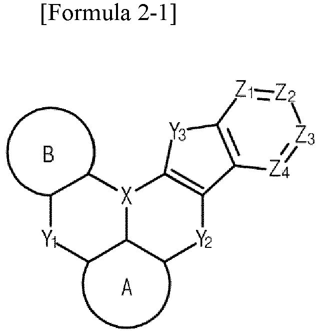

In addition, in Formula 2-1, X may be B, each of Y₁ and Y₂ may be NR₁, and each of the A and B rings may be a benzene ring. Namely, the emitting compound in Formula 1 may be represented by Formula 2-2.

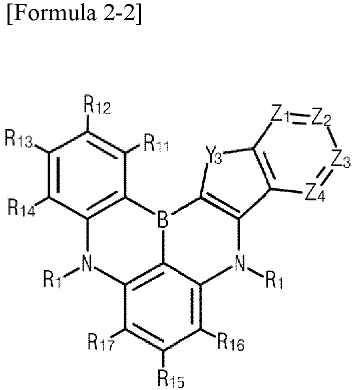

In Formula 2-2, one of Z₁ to Z₄ is N, and three of Z₁ to Z₄ are CR₄. At least one of three R₄ is D-substituted C1 to C10 alkyl group. Each of R₁₁ to R₁₇ is independently selected from the group consisting of hydrogen, deuterium (D), C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

For example, in Formula 2-2, R₁ may be C6 to C30 aryl, e.g., phenyl. In Formula 2-1 and 2-2 one of three R₄ is D-substituted C1 to C10 alkyl, e.g., CD3, and the other two of three R₄ are hydrogen. In addition, R₁₁ to R₁₇ may be hydrogen. The compound of Formula 2-1 or Formula 2-2 may be one of the compounds 1-1 to 1-10 in Formula 6.

Alternatively, in Formula 1, n may be O, and Z₁ to Z₄ may be CR₄. Namely, the emitting compound in Formula 1 may be represented by Formula 3-1.

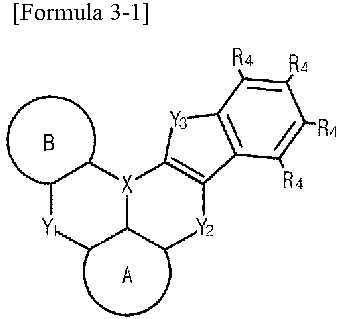

In addition, in Formula 3-1, X may be B, each of Y₁ and Y₂ may be NR₁, and each of the A and B rings may be a benzene ring. Namely, the emitting compound in Formula 1 may be represented by Formula 3-2.

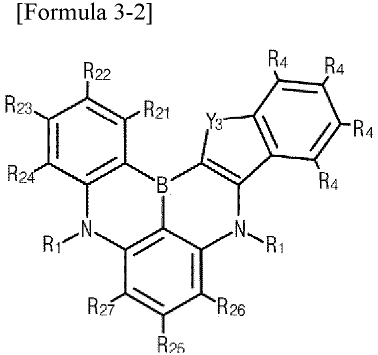

In Formula 3-1 and 3-2, adjacent two of R₄ are connected to each other to form a fused ring, and at least one of the other two R₄ is D-substituted C1 to C10 alkyl. In addition, each of R₂₁ to R₂₇ is independently selected from the group consisting of hydrogen, D, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

For example, in Formula 3-2, R₁ may be C6 to C30 aryl, e.g., phenyl. In Formula 3-1 and 3-2 one of the other two R₄ is CD₃, and the other one of the other two R₄ is hydrogen. In addition, the fused ring formed by adjacent two of R₄ may be C6 to C30 aromatic ring, e.g., benzene ring, and R₂₁ to R₂₇ may be hydrogen. The compound of Formula 3-1 or Formula 3-2 may be one of the compounds 2-1 to 2-6 in Formula 6.

Alternatively, in Formula 1, n may be 1. Namely, the emitting compound in Formula 1 may be represented by Formula 4-1.

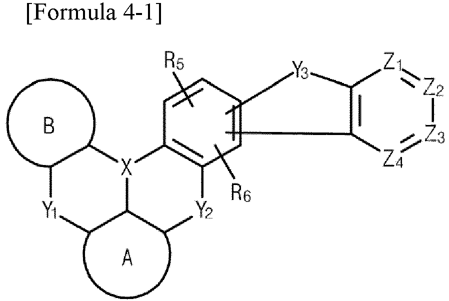

In addition, in Formula 4-1, X may be B, each of Y₁ and Y₂ may be NR₁, and each of the A and B rings may be a benzene ring. In this instance, depending on a combing position of the five-membered ring including Y₃, the emitting compound in Formula 4-1 may be represented by one of Formulas 4-2 to 4-4.

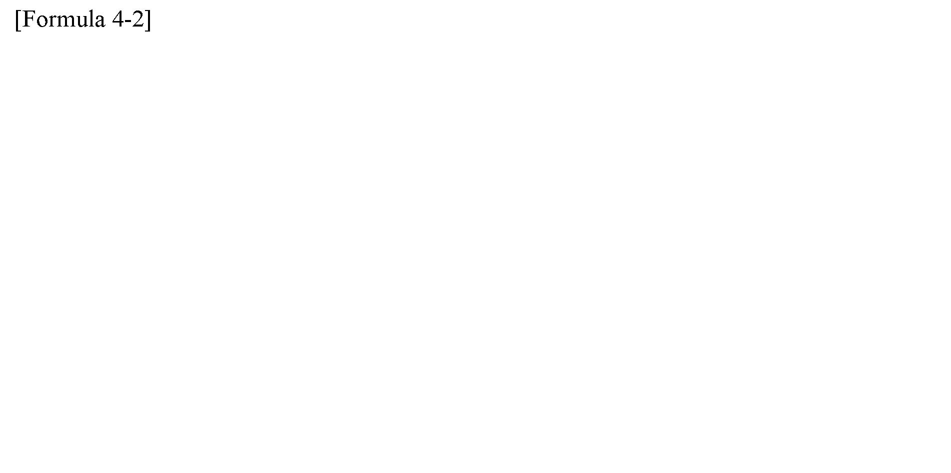

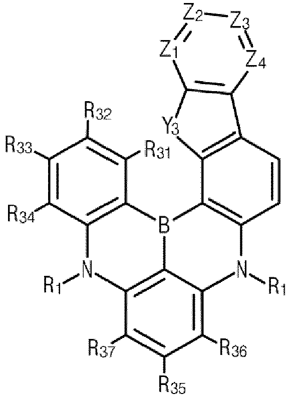

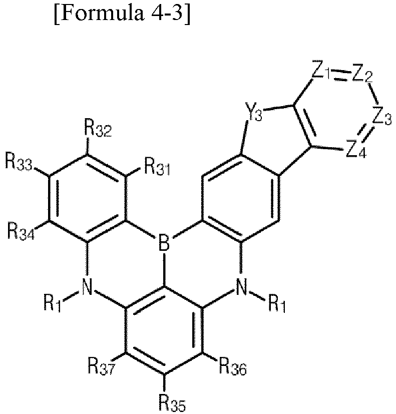

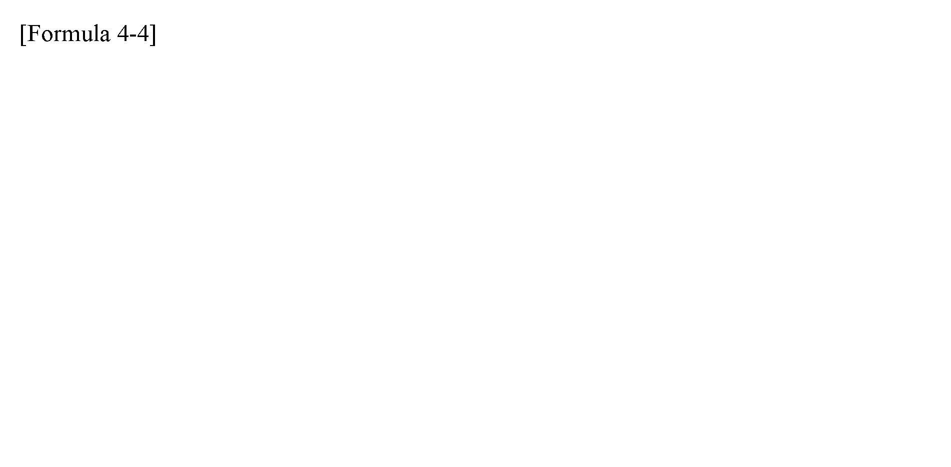

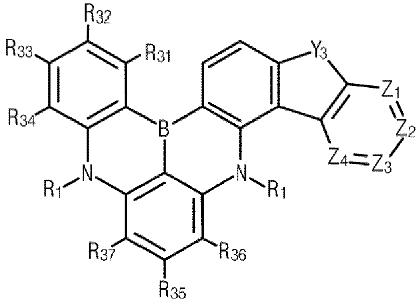

In Formulas 4-2 to 4-4, one of Z₁ to Z₄ is N, and three of Z₁ to Z₄ are CR₄. At least one of three R₄ is D-substituted C1 to C10 alkyl group. Each of R₃₁ to R₃₇ is independently selected from the group consisting of hydrogen, deuterium (D), C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

For example, in Formulas 4-2 to 4-4, R₁ may be C6 to C30 aryl, e.g., phenyl. In Formula 4-1 and 4-4 one of three R4 is a D-substituted C1 to C10 alkyl, e.g., CD3, and the other two of three R₄ are hydrogen. In addition, R₃₁ to R₃₇ may be hydrogen. The compound of Formulas 4-1 to Formula 4-4 may be one of the compounds 3-1 to 3-9 in Formula 6.

Alternatively, in each of Formulas 4-2 to 4-4, adjacent two of R₃₁ to R₃₄ may be connected to each other to form a hetero-fused ring. Namely, the emitting compound of the present disclosure may be represented by one of Formulas 4-5 to 4-7.

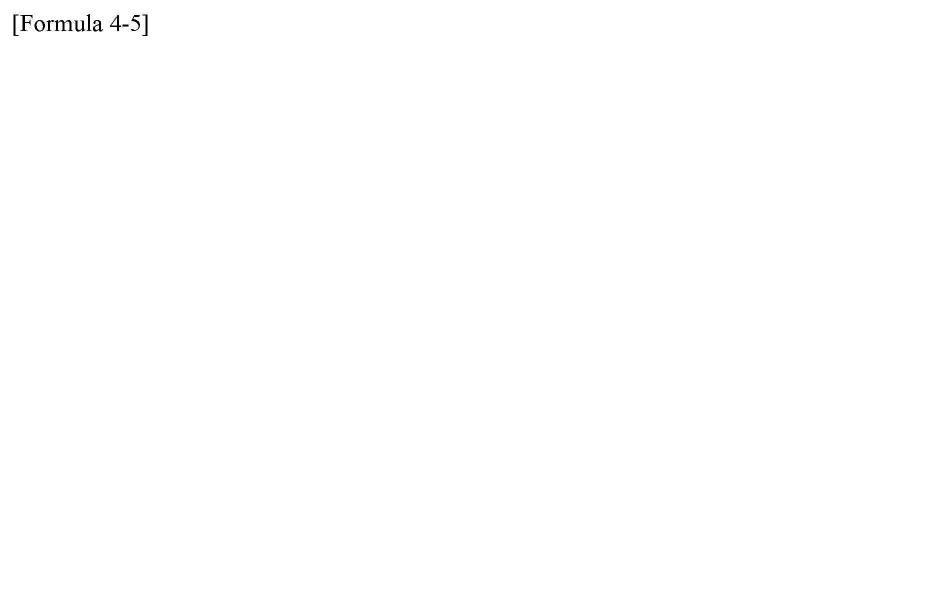

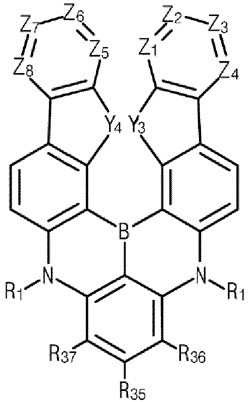

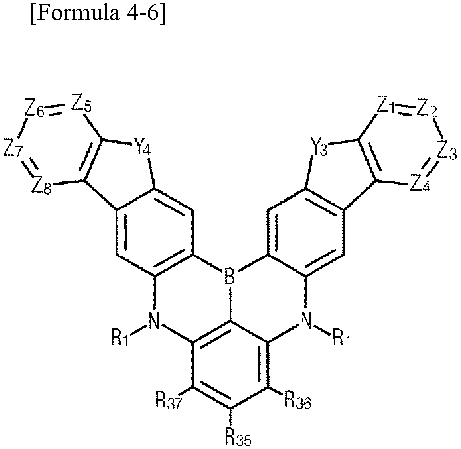

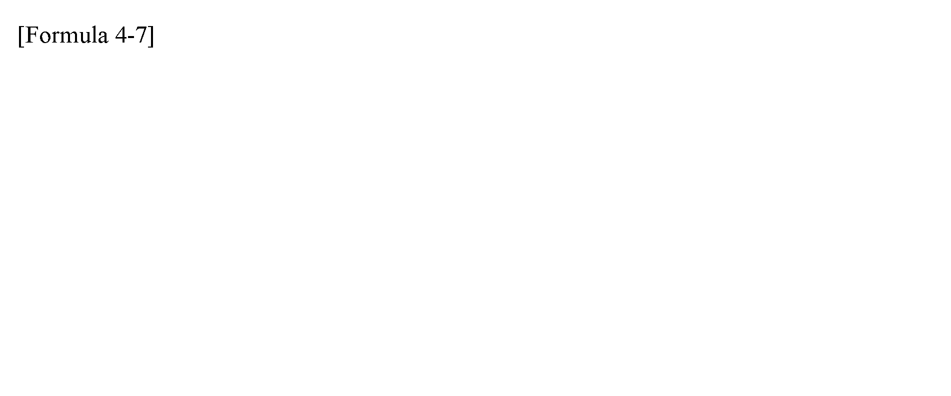

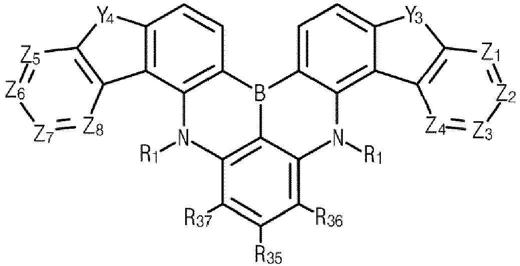

In each of Formulas 4-5 to 4-7, Y₄ is O or S. One of Z₅ to Z₈ is N, and the other three of Z₅ to Z₈ are CR₇. Each of three R₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, and at least one of three R₇ is D-substituted C1 to C10 alkyl group.

Each of R₃₅ to R₃₇ is independently selected from the group consisting of hydrogen, deuterium (D), C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

For example, in each of Formulas 4-5 to 4-7, R₁ may be C6 to C30 aryl, e.g., phenyl. One of three R₇ may be D-substituted C1 to C10 alkyl, e.g., CD3, and the other two of three R₇ may be hydrogen. In addition, R₃₅ to R₃₇ may be hydrogen.

Alternatively, in Formula 1, n may be 1, and Z₁ to Z₄ are CR₄. Namely, the emitting compound in Formula 1 may be represented by Formula 5-1.

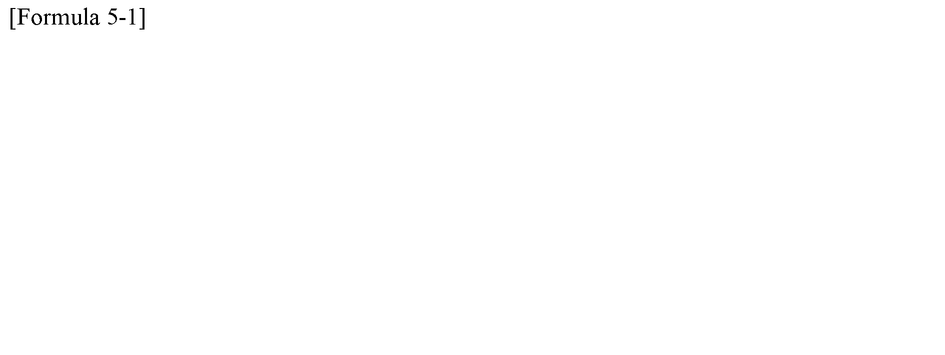

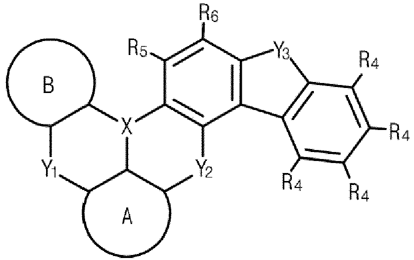

In addition, in Formula 5-1, X may be B, each of Y₁ and Y₂ may be NR₁, and each of the A and B rings may be a benzene ring. Namely, the emitting compound in Formula 1 may be represented by one of Formula 5-2.

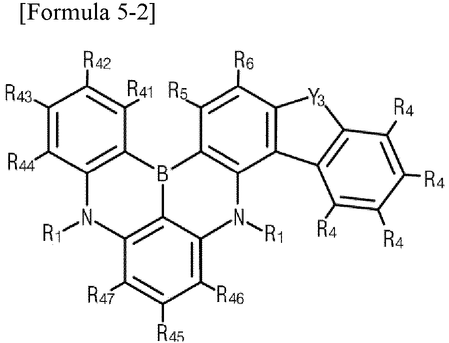

In Formula 5-1 and Formula 5-2, adjacent two of four R₄ or R₅ and R₆ is connected to form a fused ring, and at least one of the other four of R₄, R₅ and R₆ is D-substituted C1 to C10 alkyl group. Each of R₄₁ to R₄₇ is independently selected from the group consisting of hydrogen, deuterium (D), C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

For example, in Formula 5-2, R₁ may be C6 to C30 aryl, e.g., phenyl. In Formula 5-1 and 5-2 one of the other four of R₄, R₅ and R₆ is a D-substituted C1 to C10 alkyl, e.g., CD3, and the other of the other four of R₄, R₅ and R₆ is hydrogen. The fused ring formed by adjacent two of four R₄ or R₅ and R₆ may be C6 to C30 aromatic ring, e.g., benzene ring, and R₄₁ to R₄₇ may be hydrogen. The compound of Formula 5-1 or Formula 5-2 may be one of the compounds 4-1 to 4-4 in Formula 6.

Alternatively, in Formula 5-1, the A ring may be benzene ring, and the B ring may be heteroaromatic fused ring. Namely, the emitting compound in Formula 5-1 may be represented by Formula 5-3.

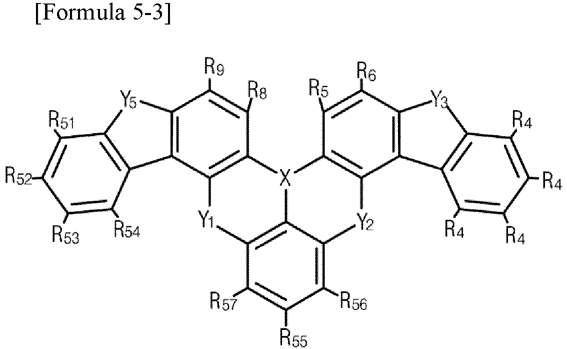

In Formula 5-3, Y₅ is O or S. Adjacent two of four R₄ or R₅ and R₆ is connected to form a fused ring, and at least one of the other four of R₄, R₅ and R₆ is D-substituted C1 to C10 alkyl group. Each of R₈, R₉ and R₅₁ to R₅₄ is independently selected from the group consisting of hydrogen, deuterium (D), C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, or adjacent two of R₅₁ to R₅₄ or R₈ and R₉ is connected to form a fused ring. At least one of the other four of R₈, R₉ and R₅₁ to R₅₄ is D-substituted C1 to C10 alkyl group. Each of R₅₅ to R₅₇ is independently selected from the group consisting of hydrogen, deuterium (D), C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

In Formula 5-3, X may be B, each of Y₁ and Y₂ may be NR₁. Namely, the emitting compound in Formula 5-3 may be represented by Formula 5-4.

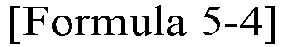

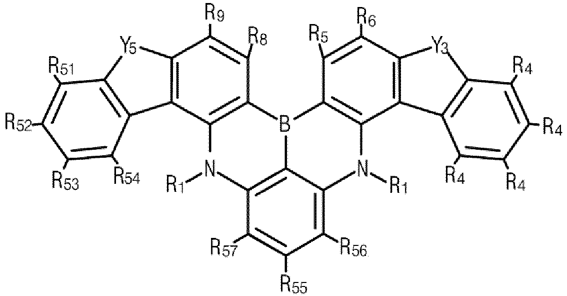

For example, in Formula 5-4, R₁ may be C6 to C30 aryl, e.g., phenyl. One of the other four of R₄, R₅ and R₆ may be D-substituted C1 to C10 alkyl, e.g., CD3, and the other of the other four of R₄, R₅ and R₆ may be hydrogen. Each of the fused ring formed by adjacent two of four R₄ or R₅ and R₆ and the fused ring formed by adjacent two of R₅₁ to R₅₄ or R₈ and R₉ may be C6 to C30 aromatic ring, e.g., benzene ring, and R₅₅ to R₅₇ may be hydrogen. The compound of Formula 5-3 or Formula 5-4 may be one of the compounds 4-5 to 4-8 in Formula 6.

The emitting compound of the present disclosure may be one of compounds in Formula 6.

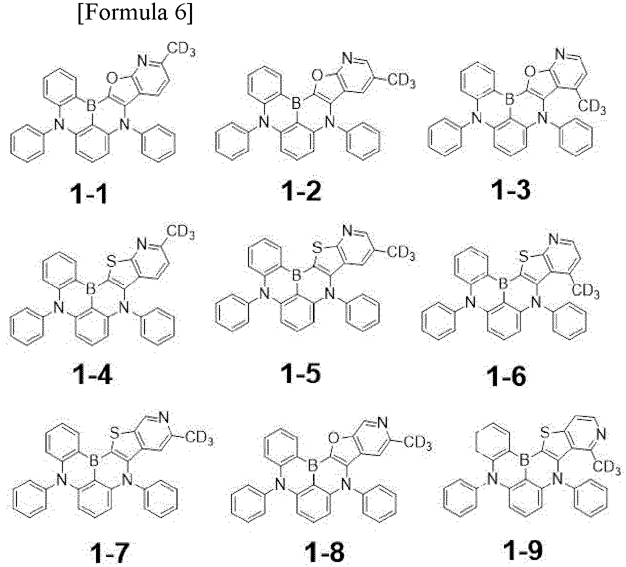

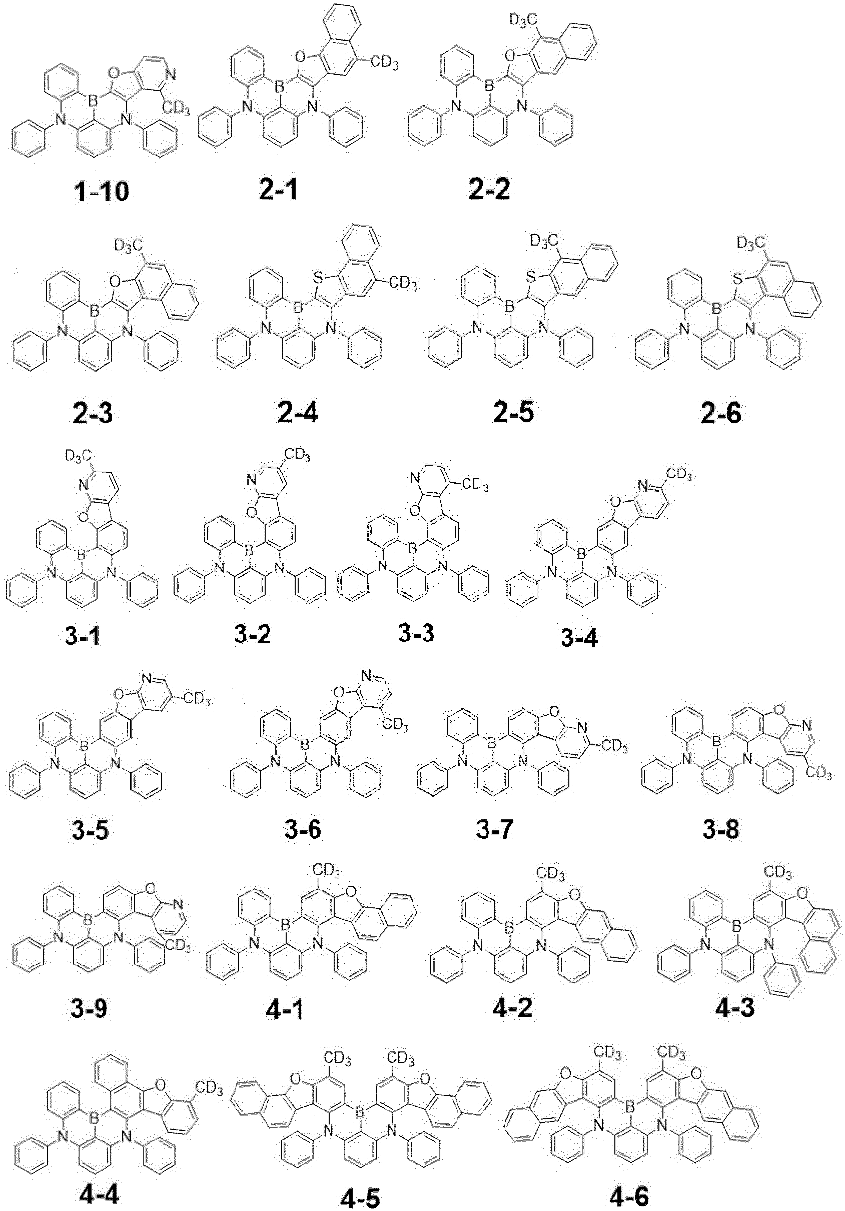

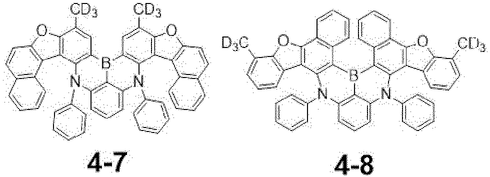

The emitting compound in Formulas 1 to 6 provides blue emission and is used for the EML 240 in the OLED D. As a result, the lifespan of the OLED D and the organic light emitting device 100 is significantly increased.

### Synthesis of the host

### 1. Synthesis of compound 1-1

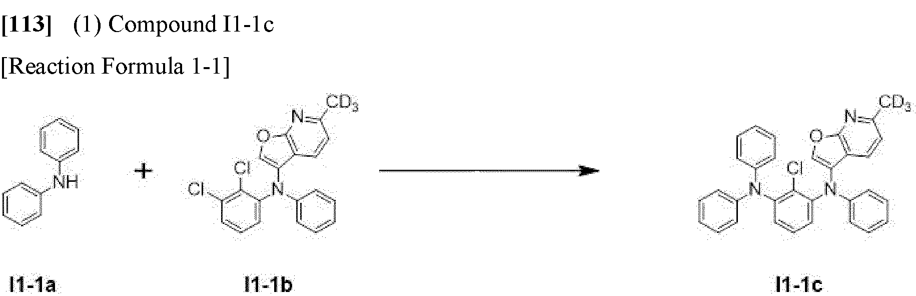

In the 500 mL reactor, the compound I1-1a 8.5 g (50 mmol), the compound I1-1b 18.6 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred/refluxed for 5 hours. After completion of the reaction, the resultant was filtered and concentrated. The mixture was separated by column chromatography to obtain 17.2 g of the compound I1-1c. (Yield 68%)

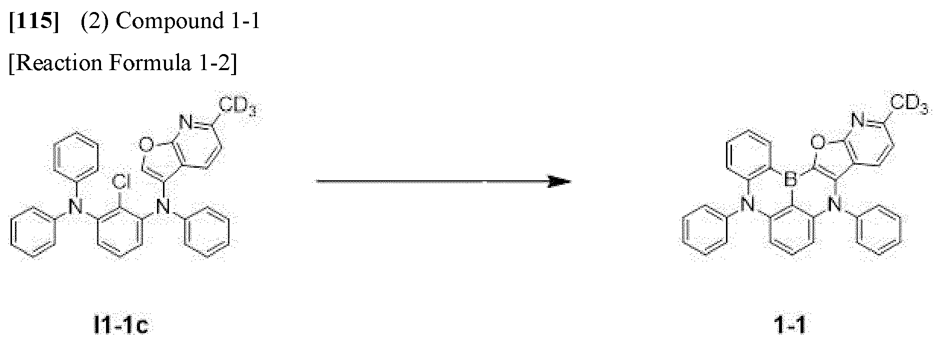

In the 500 mL reactor, the compound I1-1c 6.3 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78°C. After the dropwise addition, the mixture was stirred at room temperature (i.e. 25°C) for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.3 g of the compound 1-1. (Yield 21%)

### 2. Synthesis of compound 1-2

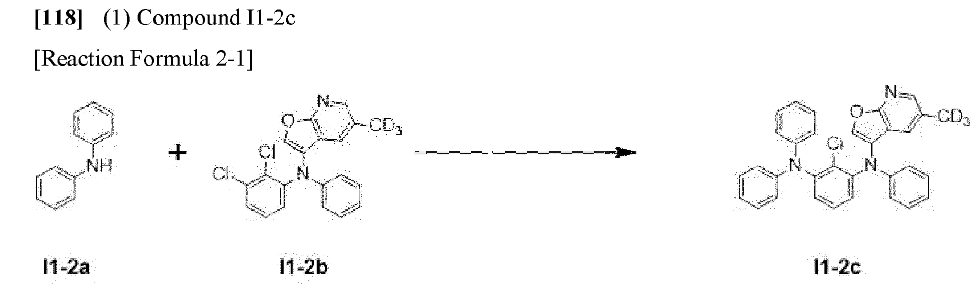

In the 500 mL reactor, the compound I1-2a 8.5 g (50 mmol), the compound I1-2b 18.6 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred/refluxed for 5 hours. After the reaction was completed, the resultant was filtered and concentrated. The mixture was separated by column chromatography to obtain 16.9 g of the compound I1-2c. (Yield 67%)

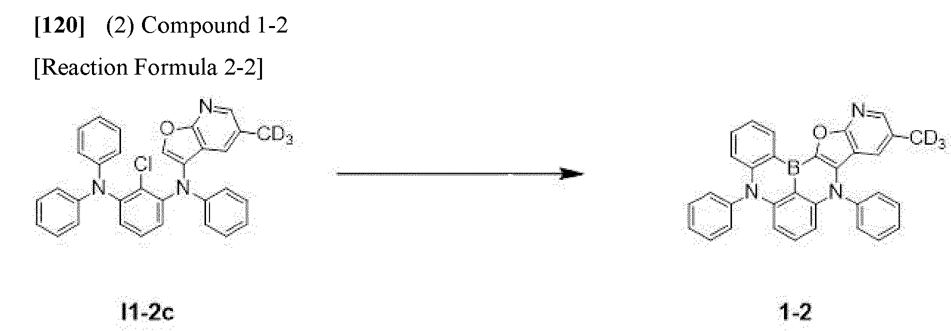

In the 500 mL reactor, the compound I1-2c 6.3 g (12.5 mmol) and tert-butylbenzene 60 mL were added to a 500 mL reactor. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.1 g of the compound 1-2. (Yield 19%)

### 3. Synthesis of compound 1-4

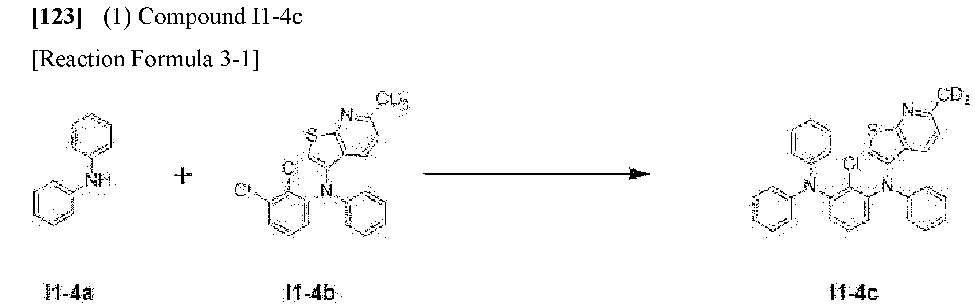

In the 500 mL reactor, the compound I1-4a 8.5 g (50 mmol), the compound I1-4b 19.4 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred/refluxed for 5 hours. After completion of the reaction, the resultant was filtered and concentrated. The mixture was separated by column chromatography to obtain 13.5 g of the compound I1-4c. (Yield 52%)

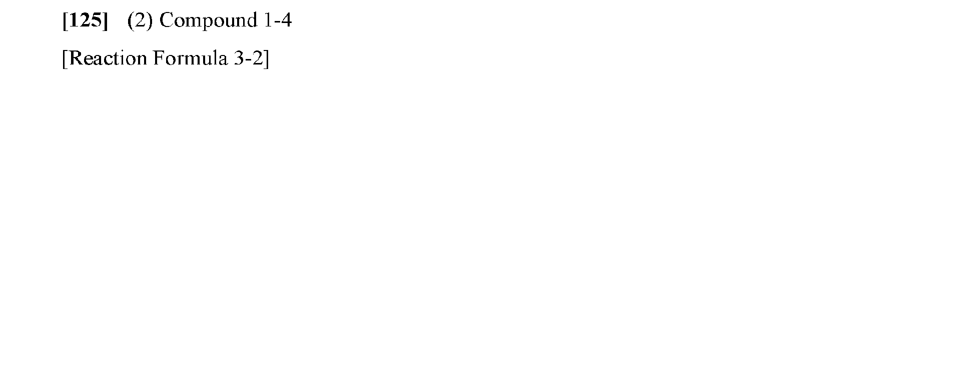

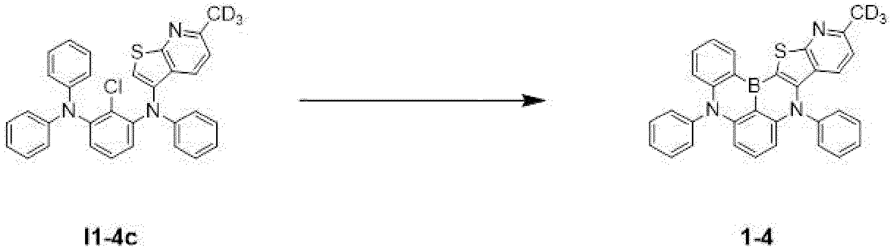

In the 500 mL reactor, the compound I1-4c 6.5 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 0.9 g of the compound 1-4. (Yield 15%)

### 4. Synthesis of compound 1-7

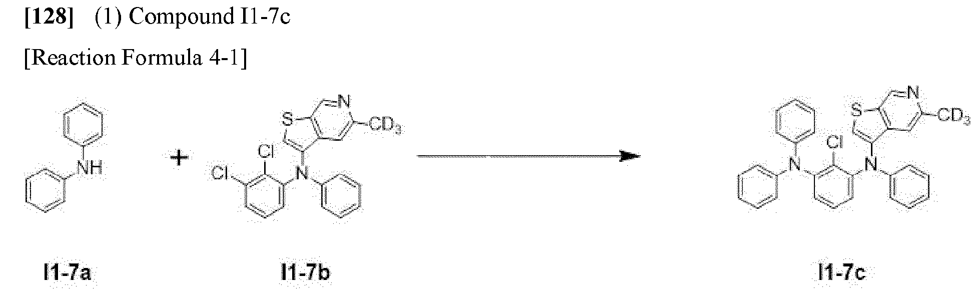

In the 500 mL reactor, the compound I1-7a 8.5 g (50 mmol), the compound I1-7b 19.4 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred/refluxed for 5 hours. After completion of the reaction, the resultant was filtered and concentrated. The mixture was separated by column chromatography to obtain 16.9 g of the compound I1-7c. (Yield 65%)

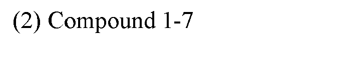

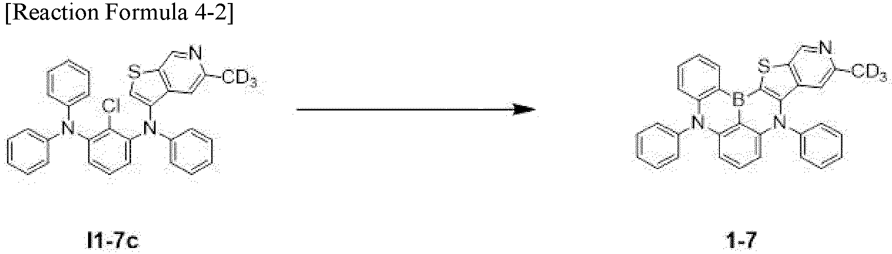

In the 500 mL reactor, the compound I1-7c 6.5 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.2 g of the compound 1-7. (Yield 20%)

### 5. Synthesis of compound 1-8

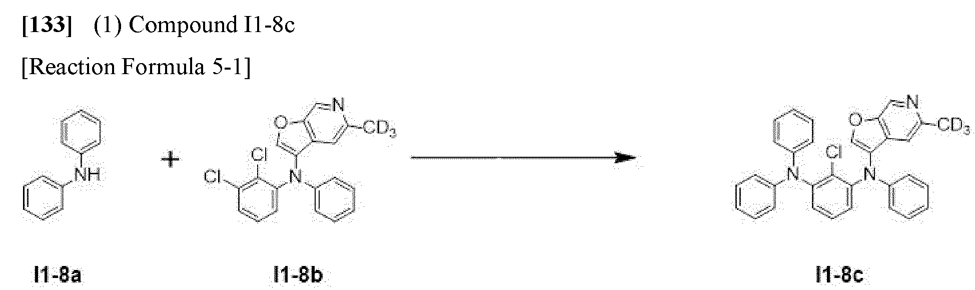

In the 500 mL reactor, the compound I1-8a 8.5 g (50 mmol), the compound I1-8b 18.6 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred/refluxed for 5 hours. After completion of the reaction, the resultant was filtered and concentrated. The mixture was separated by column chromatography to obtain 16.7 g of the compound I1-8c. (Yield 66%)

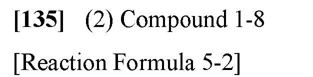

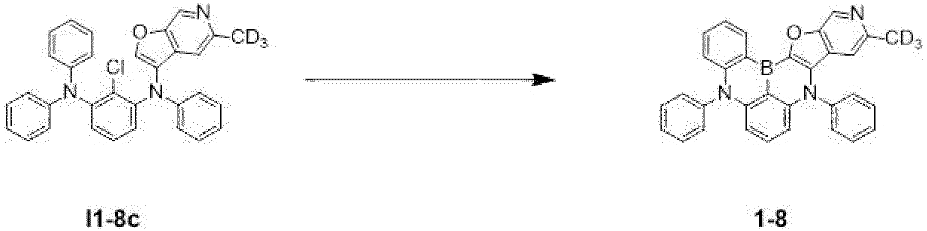

In the 500 mL reactor, the compound I1-8c 6.3 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.1 g of the compound 1-8. (Yield 18%)

### 6. Synthesis of compound 1-9

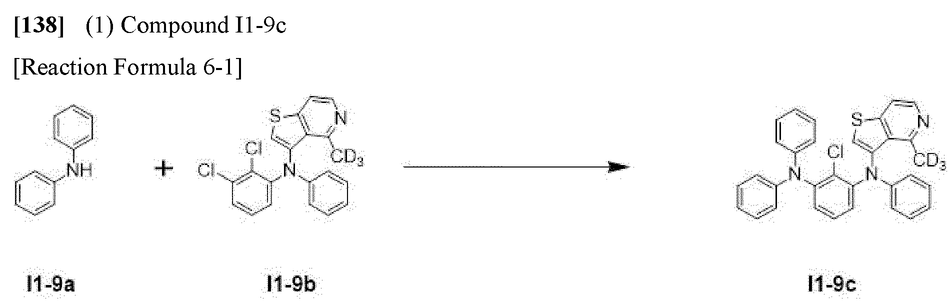

In the 500 mL reactor, the compound I1-9a 8.5 g (50 mmol), the compound I1-9b 19.4 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 18.5 g of the compound I1-9c. (Yield 71%)

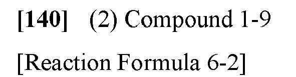

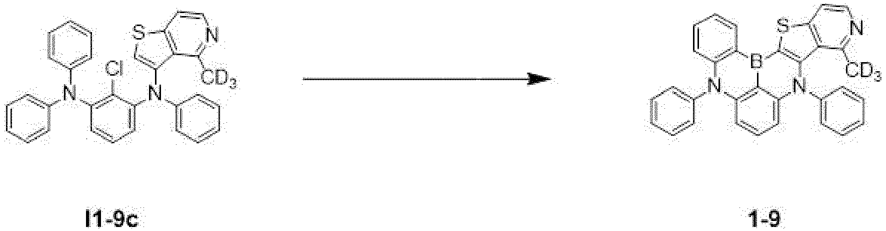

In the 500 mL reactor, the compound I1-9c 6.5 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.4 g of the compound 1-9. (Yield 23%)

### 7. Synthesis of compound 2-1

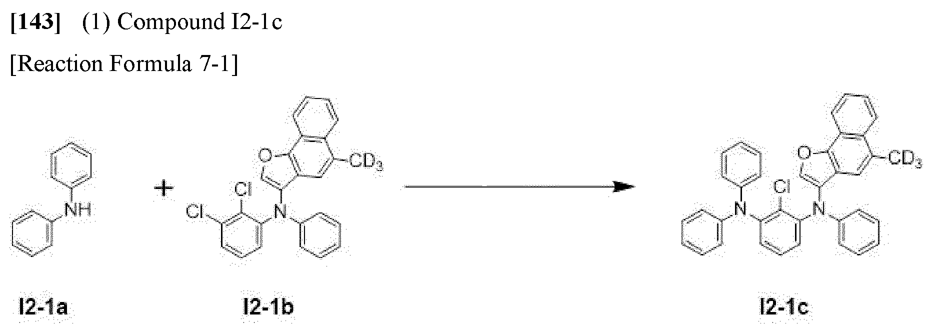

In the 500 mL reactor, the compound I2-1a 8.5 g (50 mmol), the compound I2-1b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After completion of the reaction, the resultant was filtered and concentrated. The mixture was separated by column chromatography to obtain 17.7 g of the compound I2-1c. (Yield 64%)

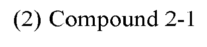

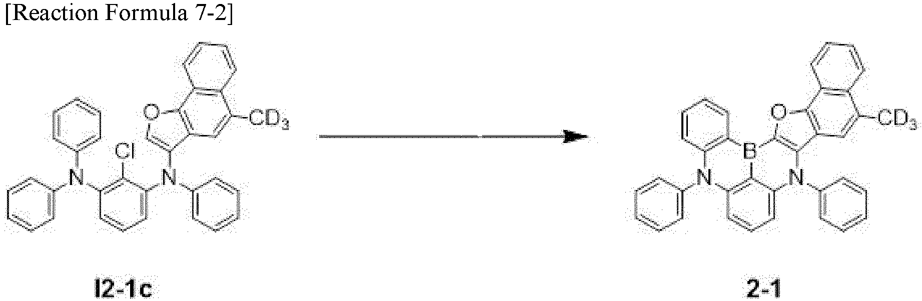

In the 500 mL reactor, the compound I2-1c 6.9 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.2 g of the compound 2-1. (Yield 18%)

### 8. Synthesis of compound 2-2

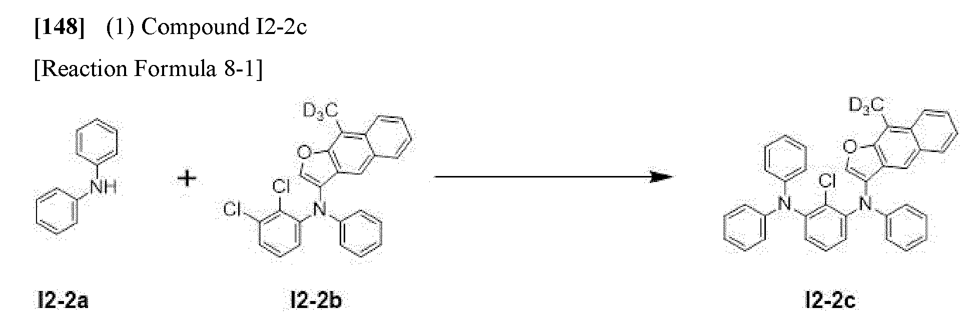

In the 500 mL reactor, the compound I2-2a 8.5 g (50 mmol), the compound I2-2b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 18.0 g of the compound I2-2c. (Yield 65%)

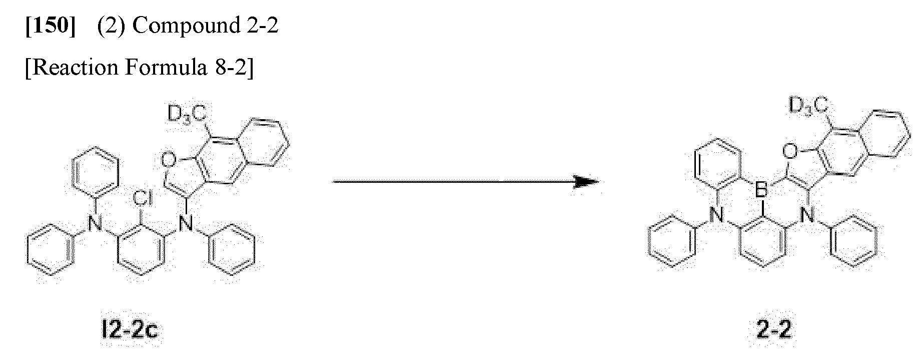

In the 500 mL reactor, the compound I2-2c 6.9 g (12.5 mmol) and tert-butylbenzene 60 mL were added to. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.1 g of the compound 2-2. (Yield 16%)

### 9. Synthesis of compound 2-3

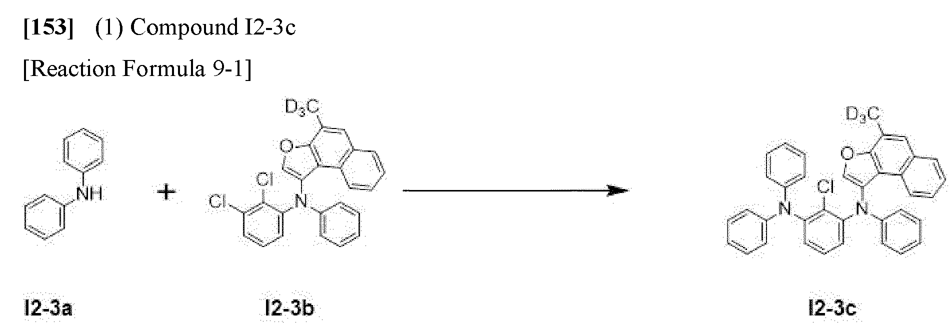

In the 500 mL reactor, the compound I2-3a 8.5 g (50 mmol), the compound I2-3b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 18.3 g of the compound I2-3c. (Yield 66%)

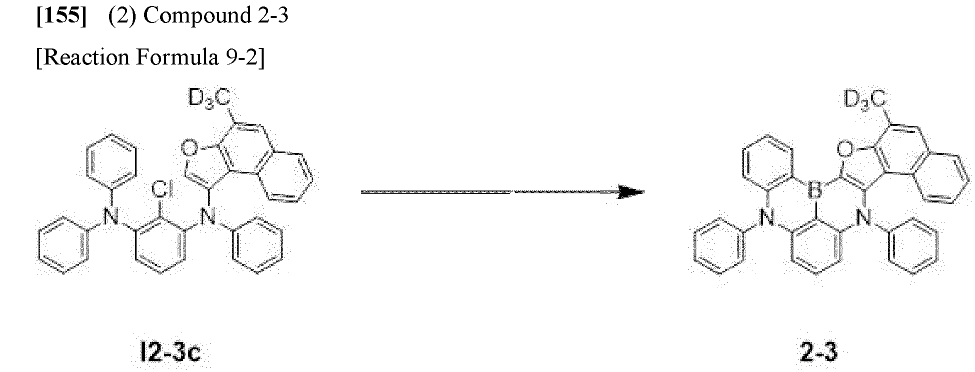

In the 500 mL reactor, the compound I2-3c 6.9 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.3 g of the compound 2-3. (Yield 19%)

### 10. Synthesis of compound 2-4

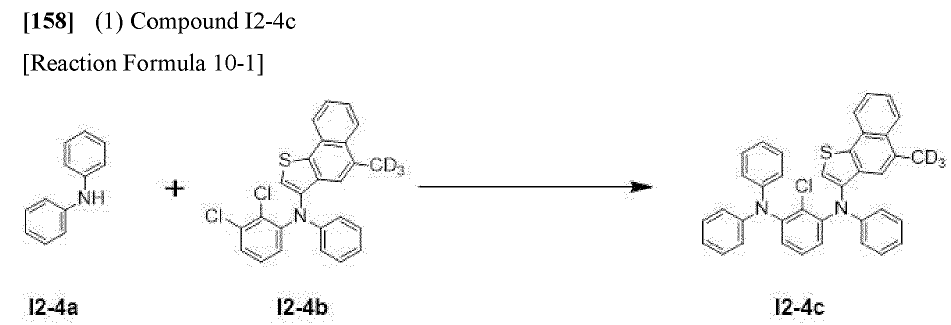

In the 500 mL reactor, the compound I2-4a 8.5 g (50 mmol), the compound I2-4b 21.9 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 18.5 g of the compound I2-4c. (Yield 65%)

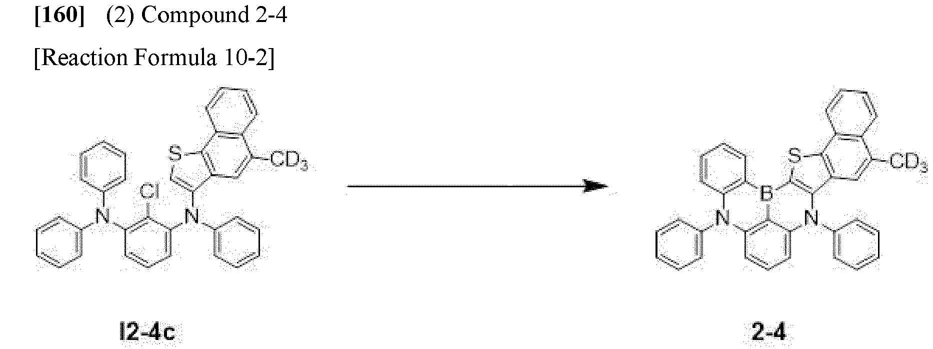

In the 500 mL reactor, the compound I2-4c 7.1 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.4 g of the compound 2-4. (Yield 20%)

### 11. Synthesis of compound 2-6

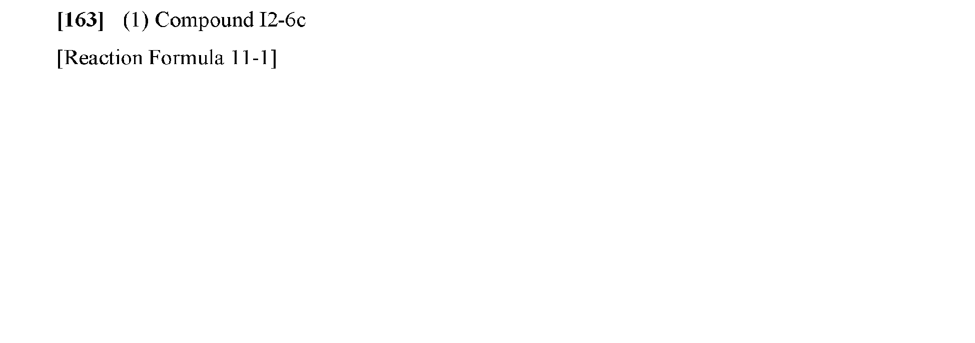

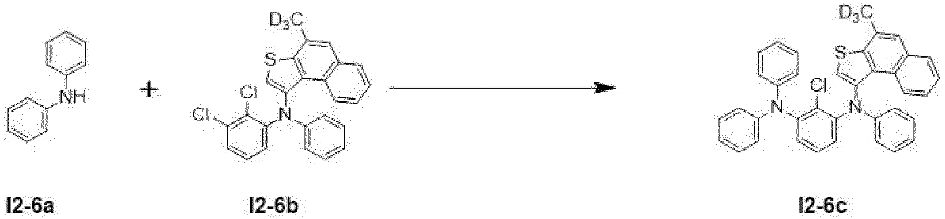

In the 500 mL reactor, the compound I2-6a 8.5 g (50 mmol), the compound I2-6b 21.9 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 18.5 g of the compound I2-6c. (Yield 65%)

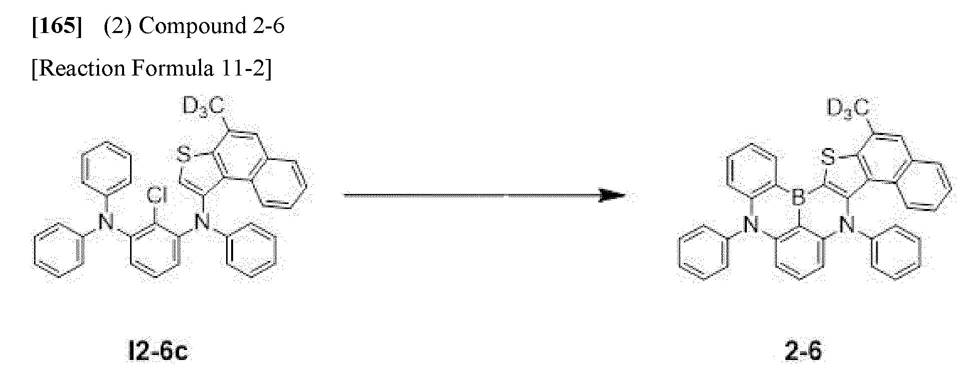

In the 500 mL reactor, the compound I2-6c 7.1 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.6 g of the compound 2-6. (Yield 24%)

### 12. Synthesis of compound 3-1

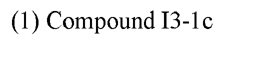

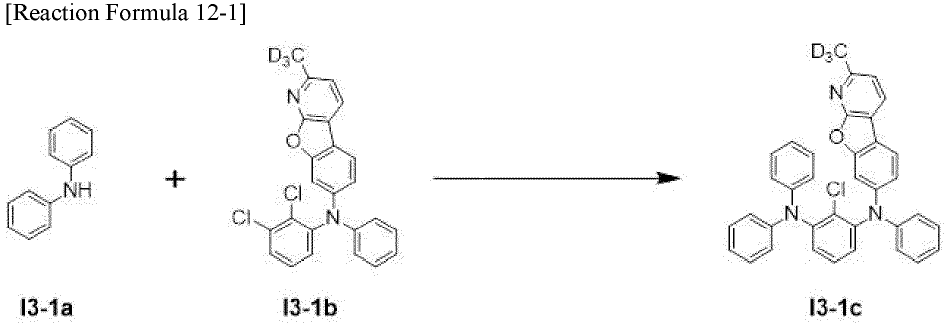

In the 500 mL reactor, the compound I3-1a 8.5 g (50 mmol), the compound I3-1b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 17.5 g of the compound I3-1c. (Yield 63%)

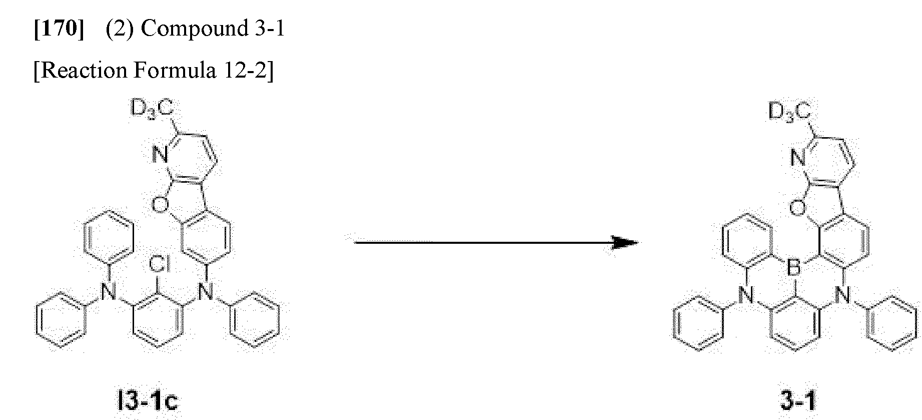

In the 500 mL reactor, the compound I3-1c 6.9 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.4 g of the compound 3-1. (Yield 21%)

### 13. Synthesis of compound 3-4

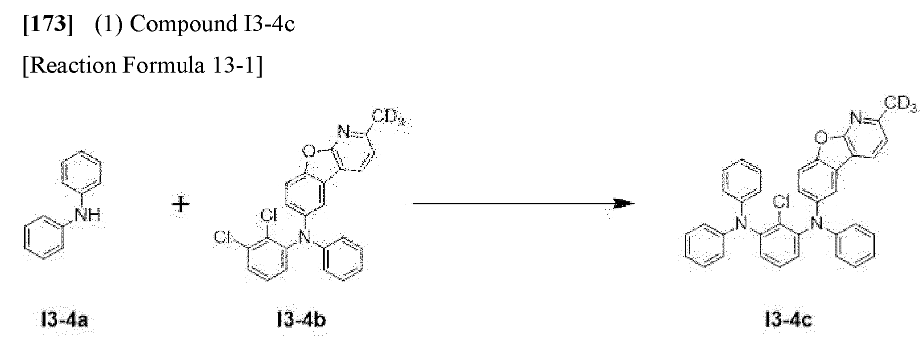

In the 500 mL reactor, the compound 13-4a 8.5 g (50 mmol), the compound 13-4b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 18.6 g of the compound 13-4c. (Yield 67%)

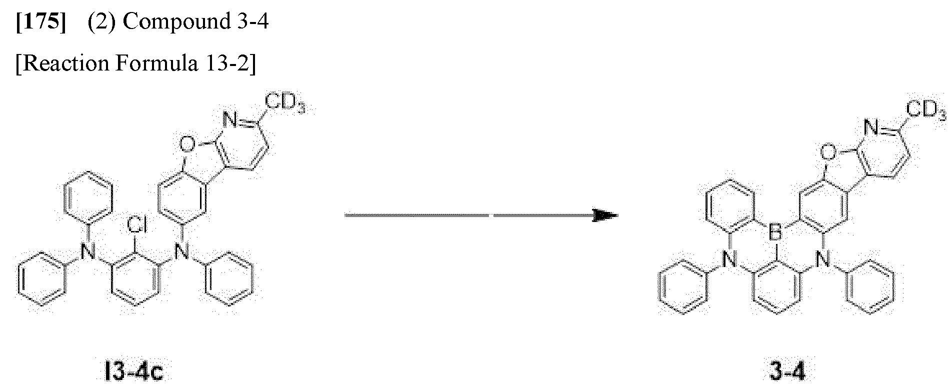

In the 500 mL reactor, the compound I3-4c 6.9 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.3 g of the compound 3-4. (Yield 19%)

### 14. Synthesis of compound 3-7

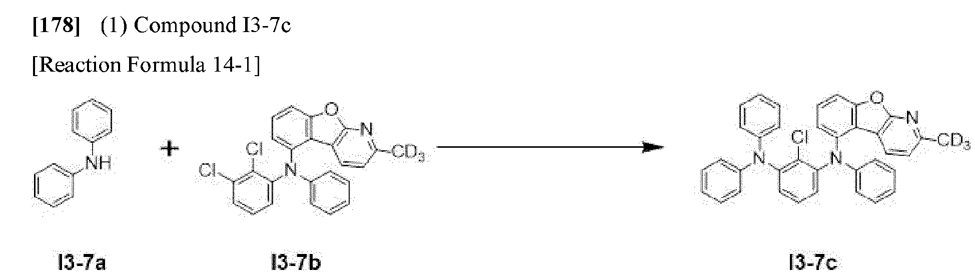

In the 500 mL reactor, the compound I3-7a 8.5 g (50 mmol), the compound I3-7b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 17.8 g of the compound I3-7c. (Yield 64%)

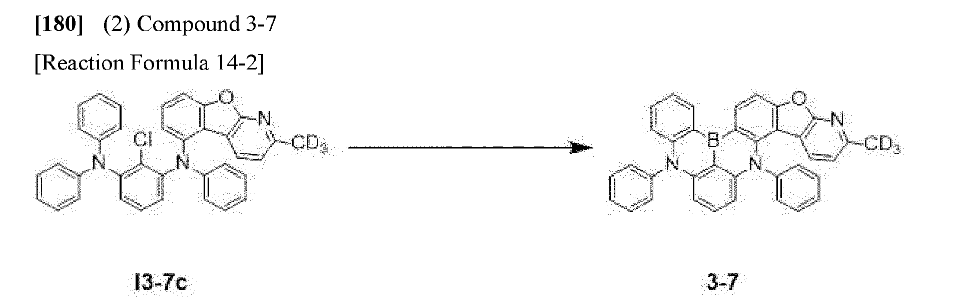

In the 500 mL reactor, the compound I3-7c 6.9 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.4 g of the compound 3-7. (Yield 21%)

### 15. Synthesis of compound 3-8

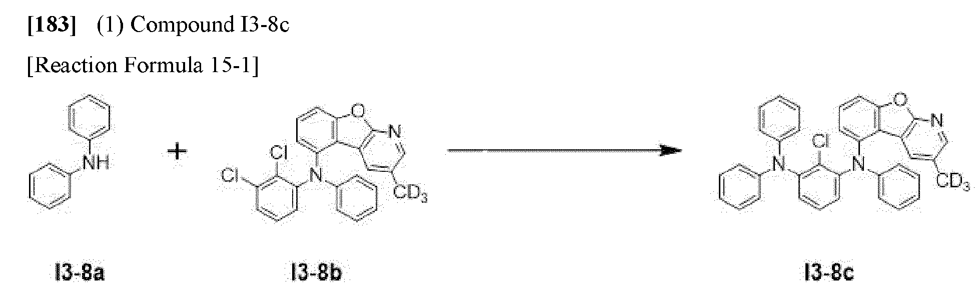

In the 500 mL reactor, the compound I3-8a 8.5 g (50 mmol), the compound I3-8b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 18.3 g of the compound I3-8c. (Yield 66%)

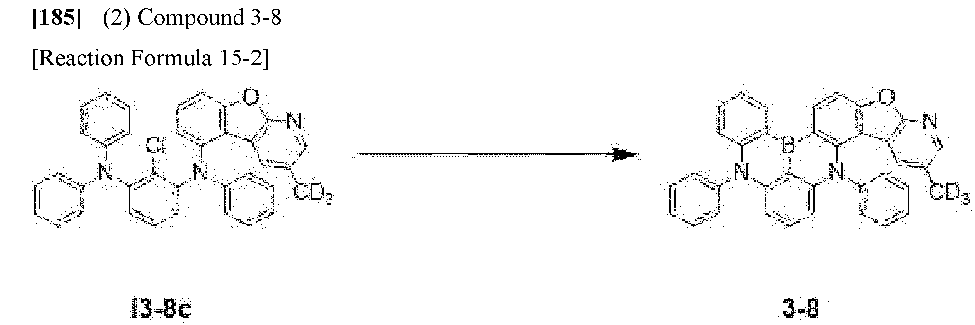

In the 500 mL reactor, the compound I3-8c 6.9 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.3 g of the compound 3-8. (Yield 20%)

### 16. Synthesis of compound 3-9

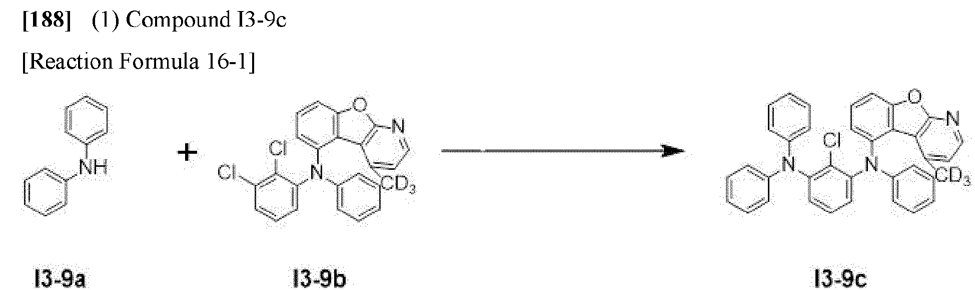

In the 500 mL reactor, the compound 13-9a 8.5 g (50 mmol), the compound 13-9b 21.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 19.1 g of the compound I3-9c. (Yield 69%)

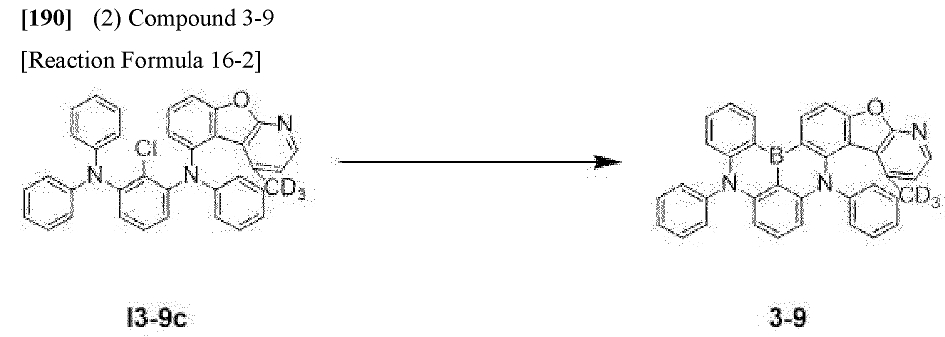

In the 500 mL reactor, the compound I3-9c 6.9 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.1 g of the compound 3-9. (Yield 17%)

### 17. Synthesis of compound 4-1

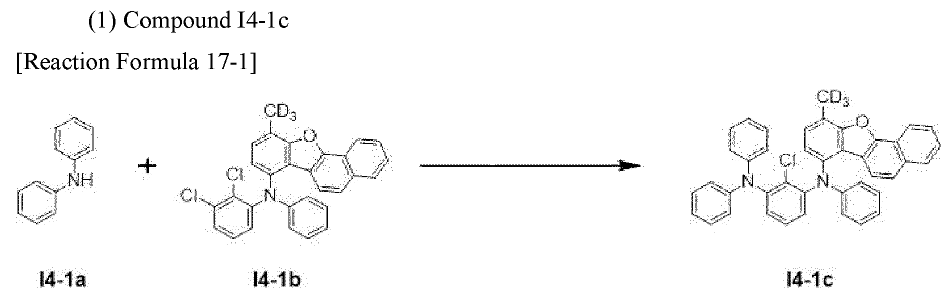

In the 500 mL reactor, the compound I4-1a 8.5 g (50 mmol), the compound 14-1b 23.6 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 17.8 g of the compound I4-1c. (Yield 59%)

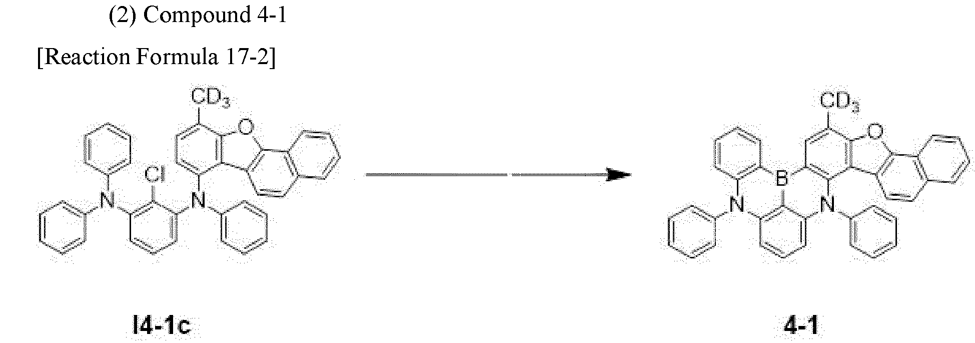

In the 500 mL reactor, the compound I4-1c 7.6 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.4 g of the compound 4-1. (Yield 19%)

### 18. Synthesis of compound 4-3

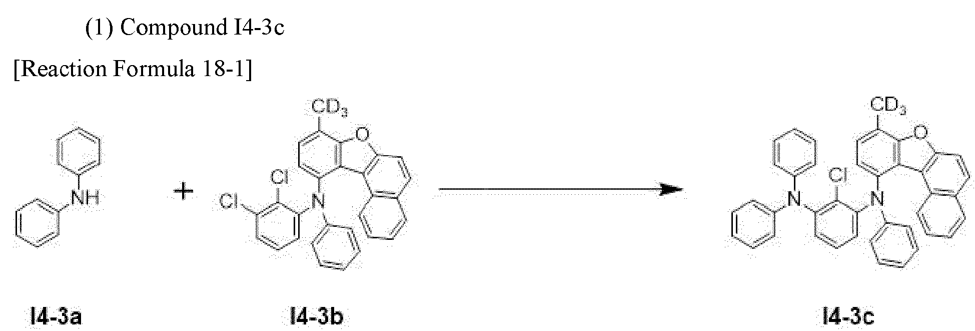

In the 500 mL reactor, the compound I4-3a 8.5 g (50 mmol), the compound I4-3b 23.6 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 20.5 g of the compound 14-3c. (Yield 68%)

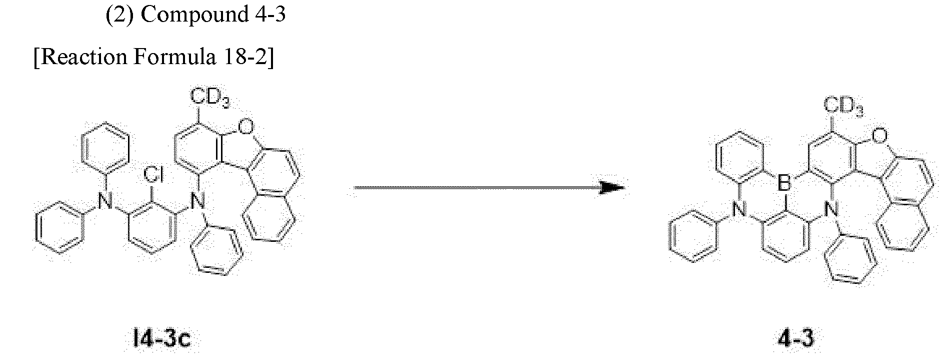

In the 500 mL reactor, the compound 14-3c 7.6 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.6 g of the compound 4-3. (Yield 22%)

### 19. Synthesis of compound 4-4

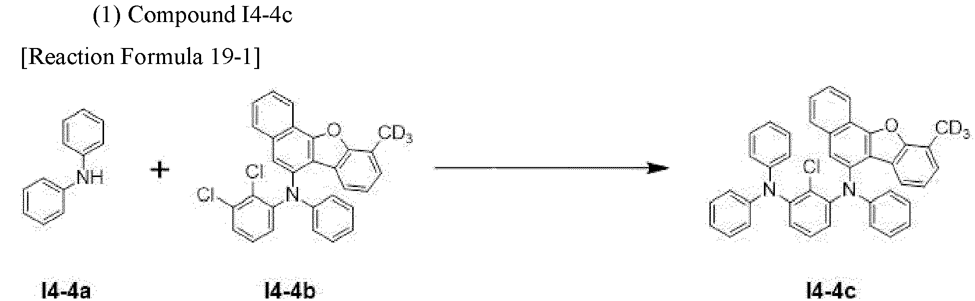

In the 500 mL reactor, the compound I4-4a 8.5 g (50 mmol), the compound I4-4b 23.6 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 20.8 g of the compound I4-4c. (Yield 69%)

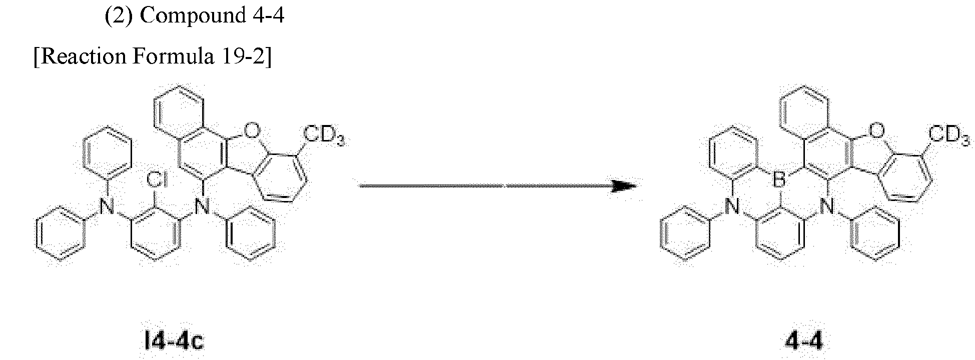

In the 500 mL reactor, the compound I4-4c 7.6 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.4 g of the compound 4-4. (Yield 19%)

### 20. Synthesis of compound 4-7

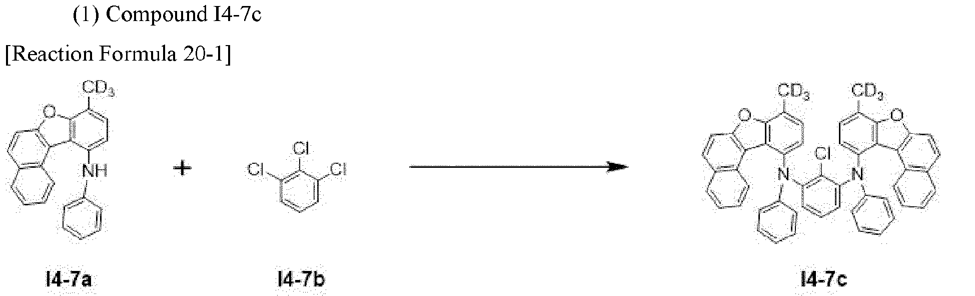

In the 500 mL reactor, the compound I4-7a 35.9 g (110 mmol), the compound 14-7b 9.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 26.6 g of the compound 14-7c. (Yield 70%)

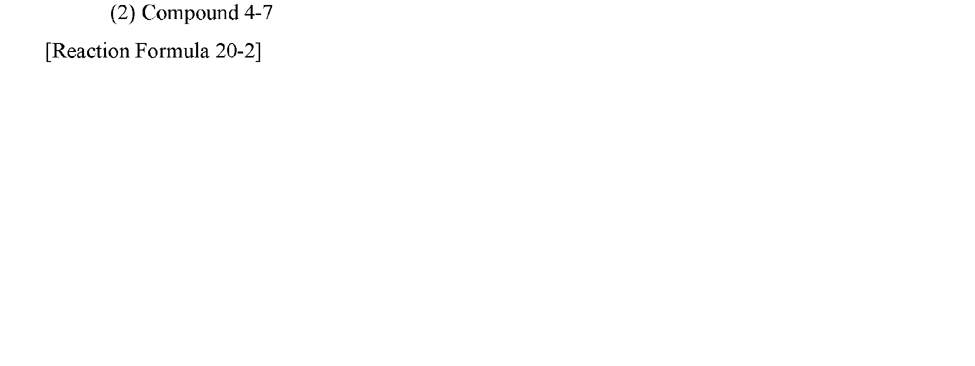

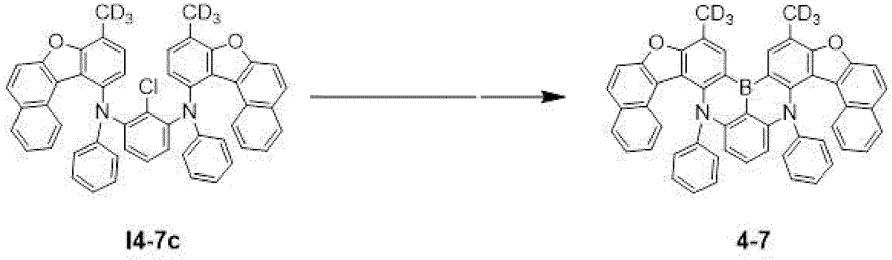

In the 500 mL reactor, the compound I4-7c 9.5 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.5 g of the compound 4-7. (Yield 16%)

### 21. Synthesis of compound 4-8

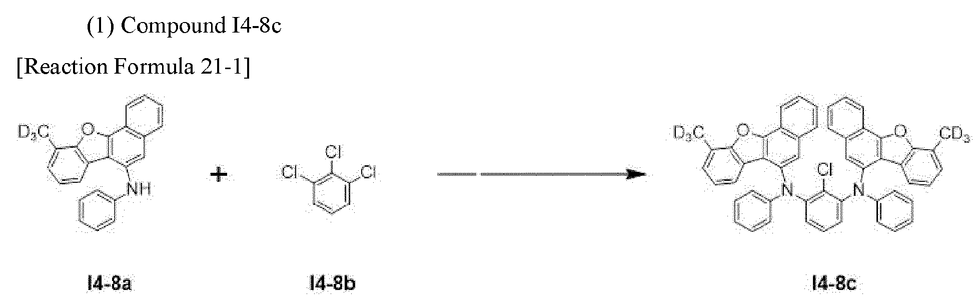

In the 500 mL reactor, the compound I4-8a 35.9 g (110 mmol), the compound I4-8b 9.1 g (50 mmol), palladium acetate 0.45 g (2 mmol), sodium tert-butoxide 18.9 g (196 mmol), tri-tert-butylphosphine 0.8 g (4 mmol) and 300 mL of toluene were added and stirred under reflux for 5 hours. After the reaction was completed, the resultant was filtered and concentrated. The mixture was separated by column chromatography to obtain 25.9 g of the compound I4-8c. (Yield 68%)

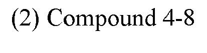

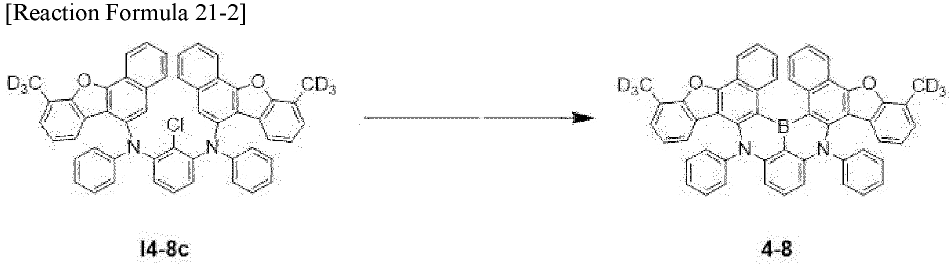

In the 500 mL reactor, the compound I4-8c 9.5 g (12.5 mmol) and tert-butylbenzene 60 mL were added. 45 mL (37.5 mmol) of n-butyllithium was dropwisely added at -78 °C. After dropwise addition, the mixture was stirred at 60°C for 3 hours. Then, nitrogen was blown at 60°C to remove heptane. Boron tribromide 6.3 g (25 mmol) was dropwisely added at -78 °C. After the dropwise addition, the mixture was stirred at room temperature for 1 hour, and 3.2 g (25 mmol) of N,N-diisopropylethylamine was dropwisely added at 0°C. After dropwise addition, the mixture was stirred at 120°C for 2 hours. After the reaction was completed, an aqueous sodium acetate solution was added thereto and stirred at room temperature. The mixture was extracted with ethyl acetate, the organic layer was concentrated, and separated by column chromatography to obtain 1.4 g of the compound 4-8. (Yield 15%)

In the EML 240, the first compound 242 acts as a dopant (emitter) to emit the blue light.

In addition, the EML 240 may further include a second compound 244 as a host. In this instance, in the EML 240, the first compound 242 may have a weight % of 0.1 to 30, or 0.1 to 10, and alternatively 1 to 5. The EML 240 may have a thickness of 10 to 500Å, or 50 to 400Å, and alternatively 100 to 300Å.

The second compound 244 as the host may be an anthracene derivative. For example, the second compound 244 may be represented by Formula 7.

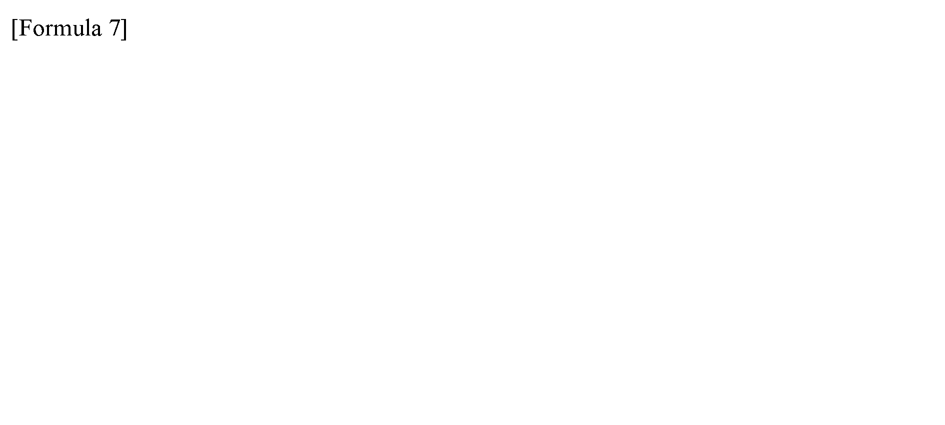

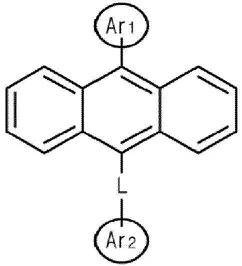

In Formula 7, each of Ar₁ and Ar₂ is independently C6 to C30 aryl group or C5 to C30 heteroaryl group. L is a single bond or C6 to C30 arylene group. In this instance, hydrogens in the anthracene derivative are not deuterated or partially or wholly deuterated. Namely, none, a part or all of the hydrogens in the anthracene derivative is substituted by deuterium.

In Formula 7, each of Ar₁ and Ar₂ may be selected from the group consisting of phenyl, naphthyl, dibenzofuranyl and fused dibenzofuranyl, and L may be the single bond or phenylene.

For example, Ar₁ may be selected from the group consisting of naphthyl, dibenzofuranyl, phenyl-dibenzofuranyl and fused dibenzofuranyl, and Ar₂ may be selected from the group consisting of phenyl and naphthyl. In an aspect, Ar₁ and Ar₂ may be naphthyl, and L may be the single bond or phenylene.

In Formula 7, the anthracene core may be partially or wholly deuterated, or each of Ar₁, Ar₂, L may be partially or wholly deuterated. Alternatively, each of the anthracene core, Ar₁, Ar₂, L may be partially or wholly deuterated.

The second compound 244 in Formula 7 may be one of compounds in Formula 8.

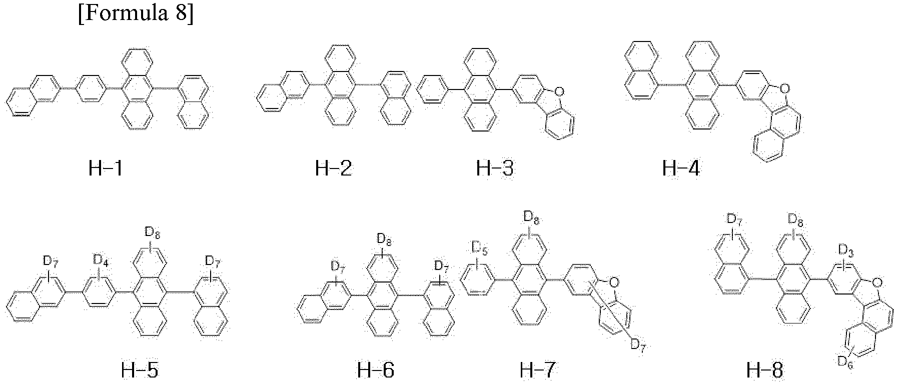

The HIL 210 may include at least one compound selected from the group consisting of 4,4',4"-tris(3-methylphenylamino)triphenylamine (MTDATA), 4,4',4"-tris(N,N-diphenylamino)triphenylamine (NATA), 4,4',4"-tris(N-(naphthalene-1-yl)-N-phenyl-amino)triphenylamine (1T-NATA), 4,4',4"-tris(N-(naphthalene-2-yl)-N-phenyl-amino)triphenylamine (2T-NATA), copper phthalocyanine(CuPc), tris(4-carbazoyl-9-yl-phenyl)amine (TCTA), N,N'-diphenyl-N,N'-bis(1-naphthyl)-1,1'-biphenyl-4,4"-diamine (NPB or NPD), 1,4,5,8,9,11-hexaazatriphenylenehexacarbonitrile(dipyrazino2,3-f:2'3'-hquinoxaline-2,3,6,7,10,11-hexacarbonitrile (HAT-CN), 1,3,5-tris4-(diphenylamino)phenylbenzene (TDAPB), poly(3,4-ethylenedioxythiphene)polystyrene sulfonate (PEDOT/PSS), and N-(biphenyl-4-yl)-9,9-dimethyl-N-(4-(9-phenyl-9H-carbazol-3-yl)phenyl)-9H-fluoren-2-amine. Alternatively, the HIL 210 may include a compound in Formula 15 as a host and a compound in Formula 16 as a dopant.

The HTL 220 may include at least one compound selected from the group consisting of N,N'-diphenyl-N,N'-bis(3-methylphenyl)-1,1'-biphenyl-4,4'-diamine (TPD), NPB (or NPD), 4,4'-bis(N-carbazolyl)-1,1'-biphenyl (CBP), polyN,N'-bis(4-butylpnehyl)-N,N'-bis(phenyl)-benzidine (poly-TPD), (poly(9,9-dioctylfluorenyl-2,7-diyl)-co-(4,4'-(N-(4-sec-butylphenyl)diphenylamine)) (TFB), di-4-(N,N-di-p-tolyl-amino)-phenylcyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, and N-(biphenyl-4-yl)-N-(4-(9-phenyl-9H-carbazol-3-yl)phenyl)biphenyl-4-amine. Alternatively, the HTL 220 may include a compound of Formula 15.

The EBL 230, which is disposed between the HTL 220 and the EML 240, is formed to prevent the electron toward the HTL 220. The EBL 230 includes the electron blocking material of the amine derivative. The electron blocking material is represented by Formula 9.

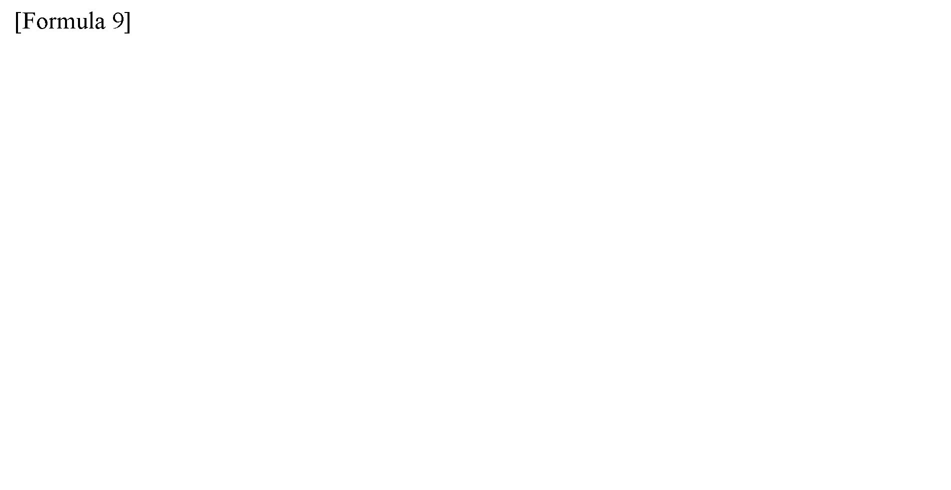

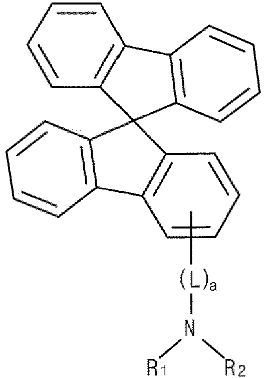

In Formula 9, L is C6 to C30 arylene group, and a is 0 or 1. Each of R₁ and R₂ is independently selected from the group consisting of C6 to C30 aryl group and C5 to C30 heteroaryl group.

For example, L may be phenylene, and each of R₁ and R₂ may be selected from the group consisting of biphenyl, fluorenyl, carbazolyl, phenylcarbazolyl, carbazolylphenyl, dibenzothiophenyl and dibenzofuranyl.

Namely, the electron blocking material may be an amine derivative substituted by spirofluorene (e.g., "spirofluorene-substituted amine derivative").

The electron blocking material of Formula 9 may be one of the followings of Formula 10:

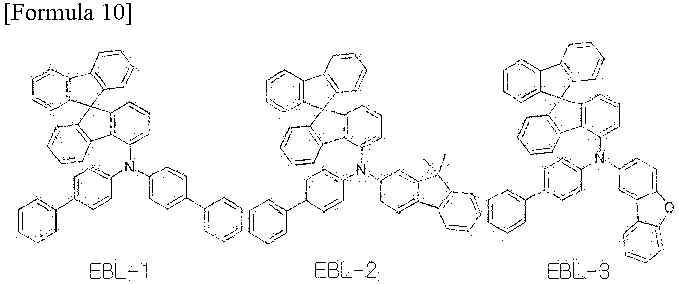

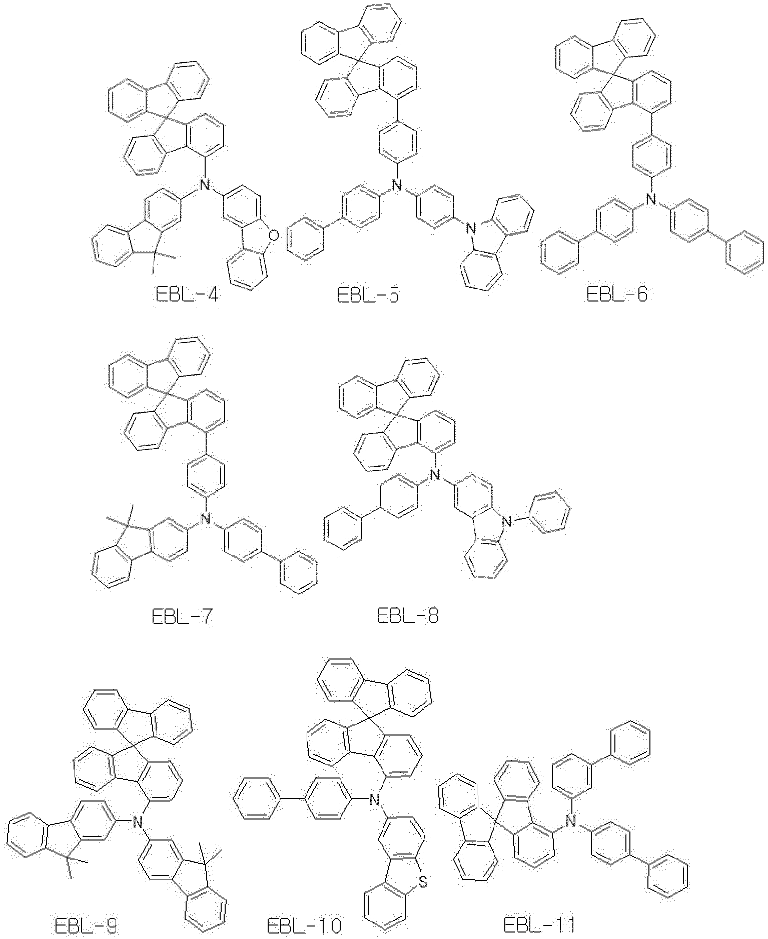

The HBL 250, which is disposed between the EML 240 and the EIL 260, is formed to prevent the hole toward the EIL 260. The HBL 250 includes the hole blocking material of the azine derivative. The azine derivative as the hole blocking material is represented by Formula 11.

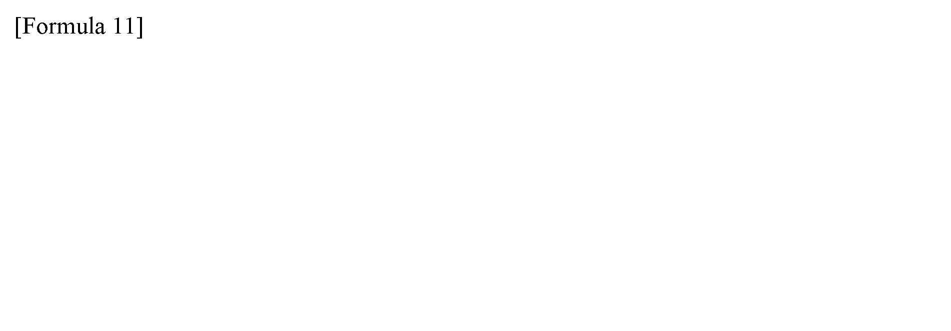

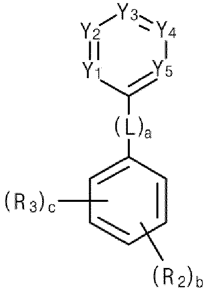

In Formula 11, each of Y₁ to Y₅ is independently CR₁ or N, and one to three of Y₁ to Y₅ is N. R₁ is independently C6~C30 aryl group. L is C₆~C₃₀ arylene group, and R₂ is C6~C30 aryl group or C5~C30 hetero aryl group. R₃ is hydrogen, or adjacent two of R₃ form a fused ring. "a" is 0 or 1, "b" is 1 or 2, and "c" is an integer of 0 to 4.

The hole blocking material of Formula 11 may be one of the followings of Formula 12.

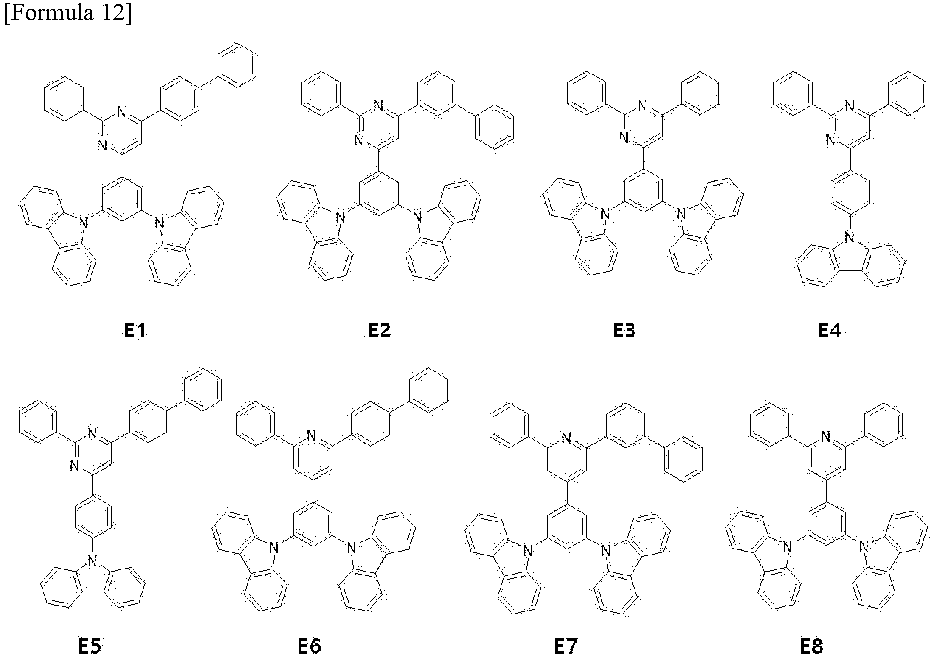

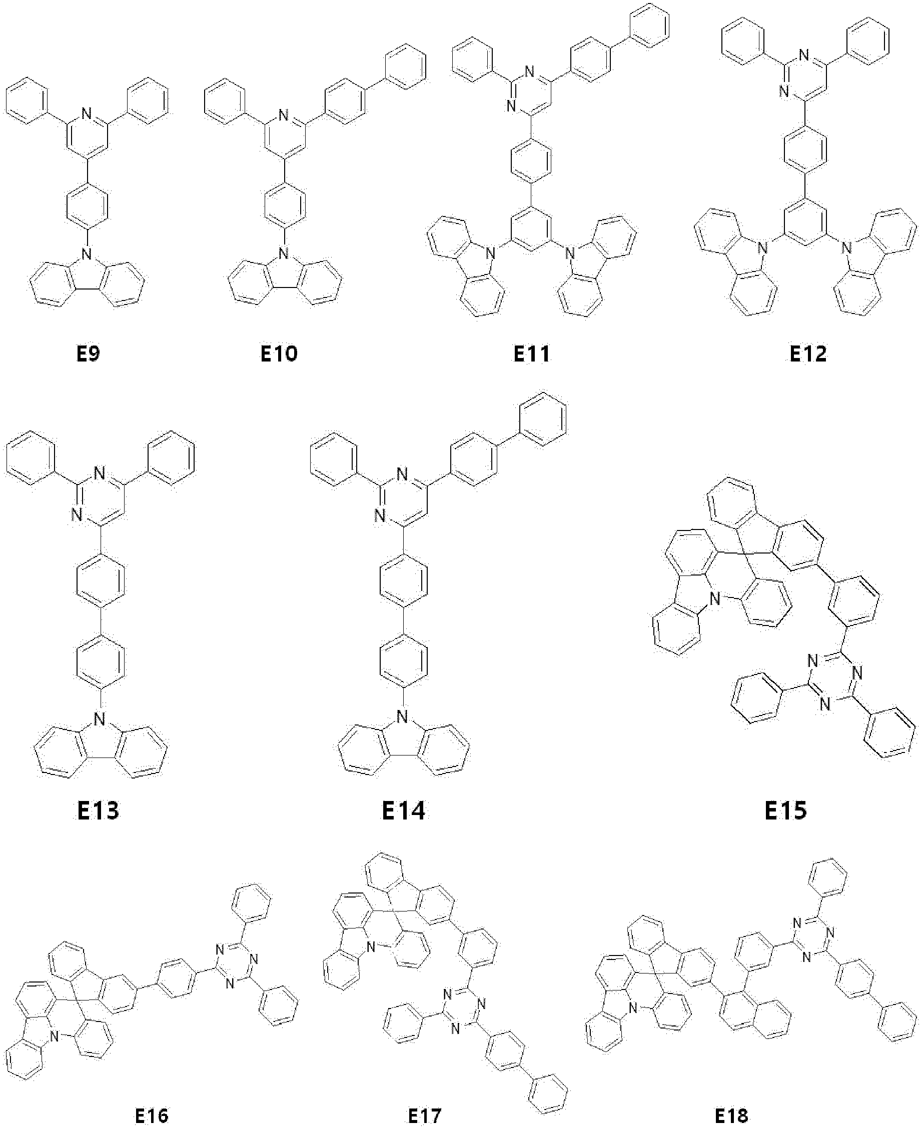

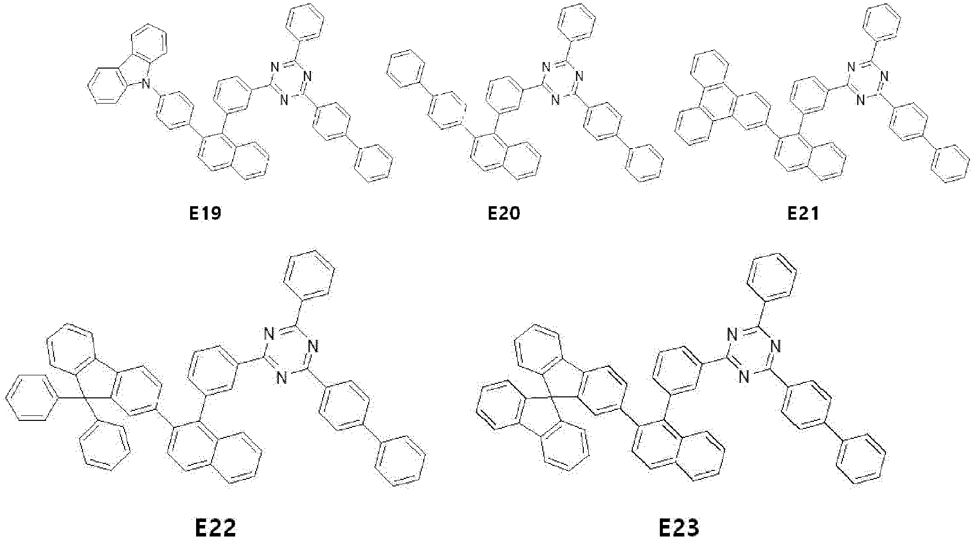

Alternatively, the HBL 250 may include the benzimidazole derivative as the hole blocking material. For example, the benzimidazole derivative as the hole blocking material is represented by Formula 13.

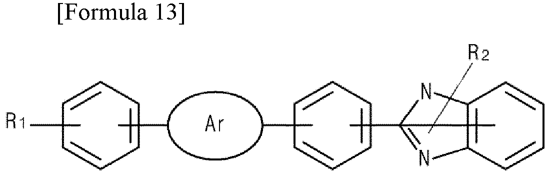

In Formula 13, Ar is C₁₀~C₃₀ arylene group, R₁ is C₆~C₃₀ aryl group or C₅~C₃₀ hetero aryl group, and R₂ is hydrogen, C₁~C₁₀ alkyl group or C₆~C₃₀ aryl group.

For example, Ar may be naphthylene or anthracenylene, R₁ may be benzimidazole or phenyl, and R₂ may be methyl, ethyl or phenyl.

The hole blocking material of Formula 13 may be one of the followings of Formula 14.

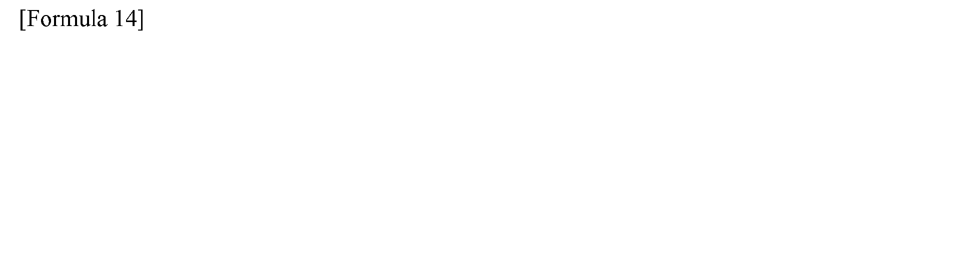

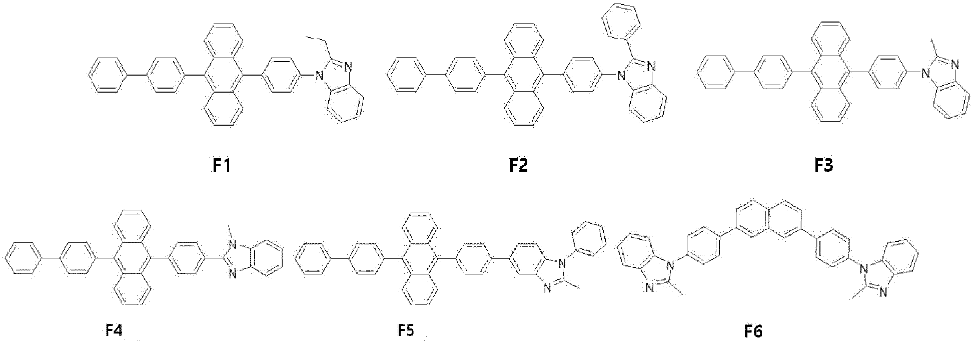

The HBL 250 may include at least one of the hole blocking material in Formula 11 and the hole blocking material in Formula 13.

In this instance, a thickness of EML 240 may be greater than each of that of the EBL 230 and the HBL 250 and may be smaller than that of the HTL 220. For example, the EML 240 may have a thickness of 150 to 250Å, each of the EBL 230 and the HBL 250 may have a thickness of 50 to 150Å, and the HTL 220 may have a thickness of 900 to 1100Å. The EBL 230 and the HBL 250 may have the same thickness.

The HBL 250 may include the compound in Formula 11 and the compound in Formula 13. For example, in the HBL 250, the compound in Formula 11 and the compound in Formula 13 may have the same weight %.

In this instance, a thickness of the EML 240 may be greater than that of the EBL 250 and may be smaller than that of the HBL 250. In addition, the thickness of the HBL 250 may be smaller than that of the HTL 220. For example, the EML 240 may have a thickness of 200 to 300Å, and the EBL may have a thickness of 50 to 150Å. The HBL 250 may have a thickness of 250 to 350Å, and the HTL 220 may have a thickness of 800 to 1000Å.

The electron blocking material in Formula 11 and/or Formula 13 has excellent hole blocking property and excellent electron transporting property. Accordingly, an electron transporting layer may be presented, and the HBL 250 may directly contact the HIL 260 or the second electrode 164.

The EIL 260 may include at least one of an alkali metal, such as Li, an alkali halide compound, such as LiF, CsF, NaF, or BaF₂, and an organo-metallic compound, such as Liq, lithium benzoate, or sodium stearate, but it is not limited thereto. Alternatively, the EIL 260 may include a compound of Formula 17 as a host and an alkali metal as a dopant.

In the OLED D, the EML 240 includes the emitting compound 242 in Formula 1 such that the lifespan of the OLED D and the organic light emitting display device 100 is significantly improved.

### [Organic light emitting diode]

The anode (ITO, 0.5mm), the HIL (Formula 15 (97wt%) and Formula 16 (3wt%), 100 Å), the HTL (Formula 15, 1000 Å), the EBL (the compound EBL-11 in Formula 10, 100 Å), the EML (the compound H-1 in Formula 8 (host, 98wt%) and dopant (2wt%), 200 Å), the HBL (the compound E1 in Formula 12, 100 Å), the EIL (Formula 17 (98wt%) and Li (2wt%), 200 Å) and the cathode (Al, 500 Å) was sequentially deposited. An encapsulation film is formed by using an UV curable epoxy and a moisture getter to form the OLED.

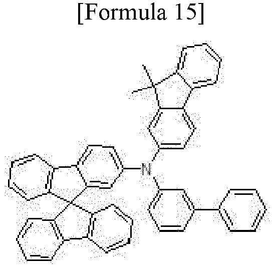

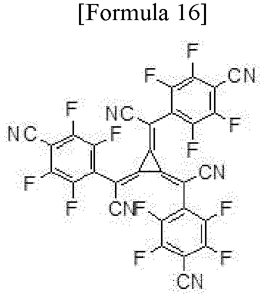

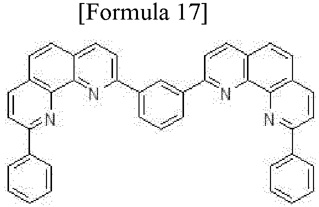

### (1) Comparative Examples 1 and 2 (Ref1 and Ref2)

The compound "Ref-1" in Formula 18 and the compound "Ref-2" in Formula 19 are respectively used as the dopant to form the EML.

### (2) Examples 1 to 21 (Ex1 to Ex21)

The compounds 1-1, 1-2, 1-4, 1-7 to 1-9, 2-1 to 2-4, 2-6, 3-1, 3-4, 3-7 to 3-9, 4-1, 4-3, 4-4, 4-7 and 4-9 in Formula 6 are respectively used as the dopant to form the EML.

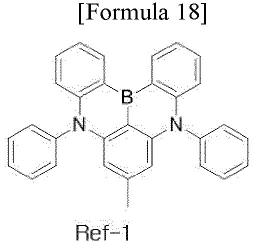

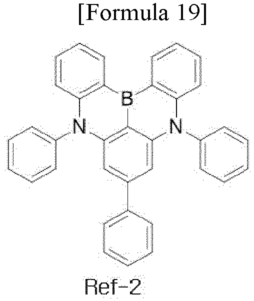

The properties, i.e., voltage (V), external quantum efficiency (EQE), color coordinate (CIE) and lifespan (T₉₅), of the OLEDs manufactured in Comparative Examples 1 and 2 and Examples 1 to 21 are measured and listed in Tables 1 and 2. The properties of the OLED were measured at the room temperature (25°C) using a current source (KEITHLEY) and a photometer (PR 650). The driving voltage, the external quantum efficiency, and the color coordinate were measured under the condition of a current density of 10 mA/cm², and the lifespan was measured at 40°C and the time to reach 95% of the lifespan under the 22.5 mA/cm² condition.

**Table 1**

| | **Dopant** | **V** | **EQE (%)** | **CIE(x,y)** | **T₉₅ (hr)** |
|---|---|---|---|---|---|
| **Ref1** | **Ref-1** | **3.95** | **6.31** | **(0.140, 0.060)** | **76** |
| **Ref2** | **Ref-2** | **3.94** | **6.28** | **(0.140, 0.075)** | **72** |
| **Ex1** | **1-1** | **3.93** | **6.42** | **(0.141, 0.128)** | **115** |
| **Ex2** | **1-2** | **3.94** | **6.25** | **(0.140, 0.121)** | **109** |
| **Ex3** | **1-4** | **3.91** | **6.21** | **(0.140, 0.120)** | **114** |
| **Ex4** | **1-7** | **3.91** | **6.35** | **(0.140, 0.123)** | **120** |
| **Ex5** | **1-8** | **3.90** | **5.99** | **(0.141, 0.120)** | **115** |
| **Ex6** | **1-9** | **3.97** | **6.08** | **(0.140, 0.119)** | **103** |
| **Ex7** | **2-1** | **3.95** | **6.15** | **(0.140, 0.078)** | **105** |
| **Ex8** | **2-2** | **3.96** | **6.32** | **(0.140, 0.186)** | **111** |
| **Ex9** | **2-3** | **3.92** | **6.75** | **(0.141, 0.129)** | **117** |
| **Ex10** | **2-4** | **3.88** | **6.66** | **(0.140, 0.079)** | **101** |
| **Ex11** | **2-6** | **3.90** | **6.49** | **(0.142, 0.125)** | **105** |

**Table 2**

| | **Dopant** | **V** | **EQE (%)** | **CIE(x,y)** | **T₉₅ (hr)** |
|---|---|---|---|---|---|
| **Ex12** | **3-1** | **3.99** | **6.38** | **(0.141, 0.071)** | **110** |
| **Ex13** | **3-4** | **3.98** | **6.47** | **(0.140, 0.178)** | **106** |
| **Ex14** | **3-7** | **3.96** | **5.72** | **(0.140, 0.046)** | **108** |
| **Ex15** | **3-8** | **3.98** | **5.44** | **(0.141, 0.045)** | **102** |
| **Ex16** | **3-9** | **4.01** | **5.51** | **(0.140, 0.046)** | **99** |
| **Ex17** | **4-1** | **3.88** | **6.28** | **(0.140, 0.055)** | **111** |
| **Ex18** | **4-3** | **3.89** | **6.29** | **(0.140, 0.087)** | **114** |
| **Ex19** | **4-4** | **3.92** | **6.45** | **(0.141, 0.115)** | **109** |
| **Ex20** | **4-7** | **3.91** | **6.50** | **(0.140, 0.095)** | **102** |
| **Ex21** | **4-8** | **3.91** | **6.42** | **(0.140, 0.127)** | **118** |

As shown in Tables 1 and 2, in comparison to the OLED of Ref1 and Ref2, the lifespan of the OLED in Ex1 to Ex21 using the emitting compound of the present disclosure as the dopant is significantly improved.

Particularly, as seen from Examples 1, 3 to 5, and 12 to 14, when the compounds 1-1, 1-4, 1-7, 1-8, 3-1, 3-4 and 3-7, in which the carbon atom being adjacent to the nitrogen atom is substituted by D-substituted alkyl group, e.g., CD₃, are used as the dopant, the lifespan of the OLED is further increased.

In addition, as seen from Examples 8, 9 and 11, when the compounds 2-2, 2-3 and 2-6, in which the carbon atom being adjacent to the hetero-atom in the five-membered ring is substituted by D-substituted alkyl group, e.g., CD₃, are used as the dopant, the lifespan of the OLED is further increased.

FIG. 4 is a schematic cross-sectional view illustrating an OLED having a tandem structure of two emitting units for the organic light emitting display device according to the first aspect of the present disclosure.

As shown in FIG. 4, the OLED D includes the first and second electrodes 160 and 164 facing each other and the organic emitting layer 162 between the first and second electrodes 160 and 164. The organic emitting layer 162 includes a first emitting part 310 including a first EML 320, a second emitting part 330 including a second EML 340 and a charge generation layer (CGL) 350 between the first and second emitting parts 310 and 330. The organic light emitting display device 100 (of FIG. 2) includes a red pixel, a green pixel and a blue pixel, and the OLED D is positioned in the blue pixel.

One of the first and second electrodes 160 and 164 is an anode, and the other one of the first and second electrodes 160 and 164 is cathode. In addition, one of the first and second electrodes 160 and 164 may be a transparent (or a semi-transparent) electrode, and the other one of the first and second electrodes 160 and 164 may be a reflection electrode.

The CGL 350 is positioned between the first and second emitting parts 310 and 330, and the first emitting part 310, the CGL 350 and the second emitting part 330 are sequentially stacked on the first electrode 160. Namely, the first emitting part 310 is positioned between the first electrode 160 and the CGL 350, and the second emitting part 320 is positioned between the second electrode 160 and the CGL 350.

The first emitting part 310 includes a first EML 320. In addition, the first emitting part 310 may further include a first EBL 316 between the first electrode 160 and the first EML 320 and a first HBL 318 between the first EML 320 and the CGL 350.

In addition, the first emitting part 310 may further include a first HTL 314 between the first electrode 160 and the first EBL 316 and an HIL 312 between the first electrode 160 and the first HTL 314.

The first EML 320 includes the emitting compound in Formula 1 as a first compound 322 and provides blue emission. For example, the first compound 322 in the first EML 320 may be one of the compounds in Formula 6.

The EML 320 may further include a second compound 324. For example, the second compound 324 may be represented by Formula 7 and may be one of the compounds in Formula 8.

In the first EML 320, the first compound 322 has a weight % being smaller than the second compound 324. The first compound 322 may act as a dopant (an emitter), and the second compound 324 may act as a host. For example, in the first EML 320, the first compound 322 may have a weight % of 0.1 to 30. To provide sufficient emitting efficiency and lifespan, the weight % of the first compound 322 may be 0.1 to 10, or 1 to 5.

The first EBL 316 may include the compound in Formula 9 as the electron blocking material. In addition, the first HBL 318 may include at least one of the compounds in Formula 11 and Formula 13 as the hole blocking material.

The second emitting part 330 includes the second EML 340. In addition, the second emitting part 330 may further include a second EBL 334 between the CGL 350 and the second EML 340 and a second HBL 336 between the second EML 340 and the second electrode 164.

In addition, the second emitting part 330 may further include a second HTL 332 between the CGL 350 and the second EBL 334 and an EIL 338 between the second HBL 336 and the second electrode 164.

The second EML 340 includes the emitting compound in Formula 1 as a third compound 342 and provides blue emission. For example, the third compound 342 in the second EML 340 may be one of the compounds in Formula 6.

The second EML 340 may further include a fourth compound 344. For example, the fourth compound 344 may be represented by Formula 7 and may be one of the compounds in Formula 8.

In the second EML 340, the third compound 342 may have a weight % being less than the fourth compound 344. In the second EML 340, the third compound 342 may act as a dopant (an emitter), and the fourth compound 344 may act as a host. For example, in the second EML 340, the third compound 342 has a weight % of 0.1 to 30. To provide sufficient emitting efficiency and lifespan, the weight % of the third compound 342 may be 0.1 to 10, or 1 to 5.

The third compound 342 in the second EML 340 and the first compound 322 in the first EML 320 may be same or different, and the fourth compound 344 in the second EML 340 and the second compound 324 in the first EML 320 may be same or different. In addition, the weight % of the first compound 322 in the first EML 320 and the weight % of the third compound 342 in the second EML 340 may be same or different.

The second EBL 334 may include the electron blocking material in Formula 9. In addition, the second HBL 336 may include at least one of the hole blocking material in Formula 11 and the hole blocking material in Formula 13.

The CGL 350 is positioned between the first and second emitting parts 310 and 330. Namely, the first and second emitting parts 310 and 330 are connected through the CGL 350. The CGL 350 may be a P-N junction CGL of an N-type CGL 352 and a P-type CGL 354.

The N-type CGL 352 is positioned between the first HBL 318 and the second HTL 332, and the P-type CGL 354 is positioned between the N-type CGL 352 and the second HTL 332.

In the OLED D, since each of the first and second EMLs 320 and 340 includes the emitting compound in Formula 1 as the first and third compounds 322 and 342, respectively, the emitting efficiency and the lifespan of the OLED D and the organic light emitting display device 100 are improved.

In addition, since the first and second emitting parts 310 and 330 for emitting blue light are stacked, the organic light emitting display device 100 provides an image having high color temperature.

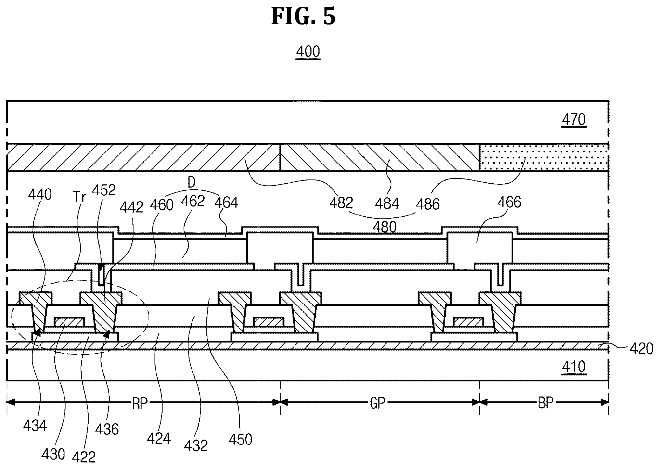

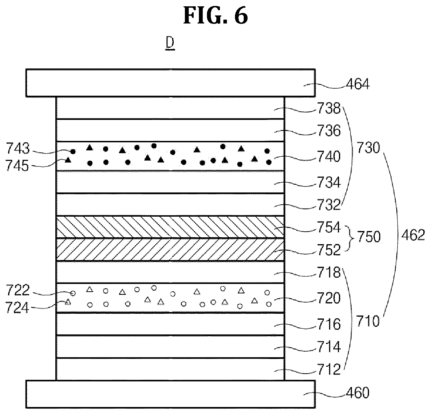

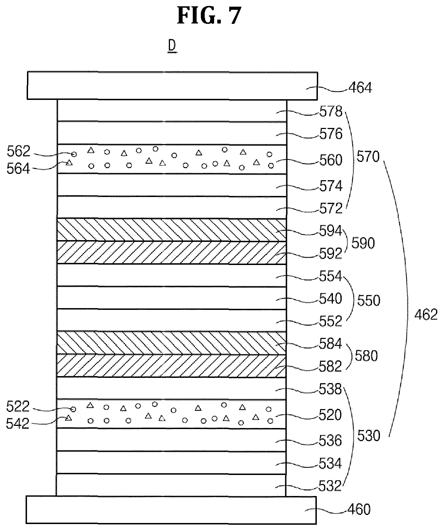

FIG. 5 is a schematic cross-sectional view illustrating an organic light emitting display device according to a second aspect of the present disclosure, and FIG. 6 is a schematic cross-sectional view illustrating an OLED having a tandem structure of two emitting parts for the organic light emitting display device according to the second aspect of the present disclosure. FIG. 7 is a schematic cross-sectional view illustrating an OLED having a tandem structure of three emitting parts for the organic light emitting display device according to the second aspect of the present disclosure.

As shown in FIG. 5, the organic light emitting display device 400 includes a first substrate 410, where a red pixel BP, a green pixel GP and a blue pixel BP are defined, a second substrate 470 facing the first substrate 410, an OLED D, which is positioned between the first and second substrates 410 and 470 and providing white emission, and a color filter layer 480 between the OLED D and the second substrate 470.

Each of the first and second substrates 410 and 470 may be a glass substrate or a flexible substrate. For example, each of the first and second substrates 410 and 470 may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 420 is formed on the substrate, and the TFT Tr corresponding to each of the red, green and blue pixels RP, GP and BP is formed on the buffer layer 420. The buffer layer 420 may be omitted.

A semiconductor layer 422 is formed on the buffer layer 420. The semiconductor layer 422 may include an oxide semiconductor material or polycrystalline silicon.

A gate insulating layer 424 is formed on the semiconductor layer 422. The gate insulating layer 424 may be formed of an inorganic insulating material such as silicon oxide or silicon nitride.

A gate electrode 430, which is formed of a conductive material, e.g., metal, is formed on the gate insulating layer 424 to correspond to a center of the semiconductor layer 422.

An interlayer insulating layer 432, which is formed of an insulating material, is formed on the gate electrode 430. The interlayer insulating layer 432 may be formed of an inorganic insulating material, e.g., silicon oxide or silicon nitride, or an organic insulating material, e.g., benzocyclobutene or photo-acryl.

The interlayer insulating layer 432 includes first and second contact holes 434 and 436 exposing both sides of the semiconductor layer 422. The first and second contact holes 434 and 436 are positioned at both sides of the gate electrode 430 to be spaced apart from the gate electrode 430.

A source electrode 440 and a drain electrode 442, which are formed of a conductive material, e.g., metal, are formed on the interlayer insulating layer 432.

The source electrode 440 and the drain electrode 442 are spaced apart from each other with respect to the gate electrode 430 and respectively contact both sides of the semiconductor layer 422 through the first and second contact holes 434 and 436.

The semiconductor layer 422, the gate electrode 430, the source electrode 440 and the drain electrode 442 constitute the TFT Tr. The TFT Tr serves as a driving element. Namely, the TFT Tr may correspond to the driving TFT Td (of FIG. 1).

Although not shown, the gate line and the data line cross each other to define the pixel, and the switching TFT is formed to be connected to the gate and data lines. The switching TFT is connected to the TFT Tr as the driving element.

In addition, the power line, which may be formed to be parallel to and spaced apart from one of the gate and data lines, and the storage capacitor for maintaining the voltage of the gate electrode of the TFT Tr in one frame may be further formed.

A passivation layer 450, which includes a drain contact hole 452 exposing the drain electrode 442 of the TFT Tr, is formed to cover the TFT Tr.

A first electrode 460, which is connected to the drain electrode 442 of the TFT Tr through the drain contact hole 452, is separately formed in each pixel and on the passivation layer 450. The first electrode 460 may be an anode and may be formed of a conductive material, e.g., a transparent conductive oxide (TCO), having a relatively high work function. For example, the first electrode 460 may be formed of indium-tin-oxide (ITO), indium-zinc-oxide (IZO), indium-tin-zinc-oxide (ITZO), tin oxide (SnO), zinc oxide (ZnO), indium-copper-oxide (ICO) or aluminum-zinc-oxide (Al:ZnO, AZO).

When the organic light emitting display device 400 is operated in a bottom-emission type, the first electrode 460 may have a single-layered structure of the transparent conductive material layer. When the Organic light emitting display device 400 is operated in a top-emission type, a reflection electrode or a reflection layer may be formed under the first electrode 160. For example, the reflection electrode or the reflection layer may be formed of silver (Ag) or aluminum-palladium-copper (APC) alloy. In this instance, the first electrode 460 may have a triple-layered structure of ITO/Ag/ITO or ITO/APC/ITO.

A bank layer 466 is formed on the passivation layer 450 to cover an edge of the first electrode 460. Namely, the bank layer 466 is positioned at a boundary of the pixel and exposes a center of the first electrode 460 in the pixel. Since the OLED D emits the white light in the red, green and blue pixels RP, GP and BP, the organic emitting layer 162 may be formed as a common layer in the red, green and blue pixels RP, GP and BP without separation. The bank layer 466 may be formed to prevent a current leakage at an edge of the first electrode 460 and may be omitted.

An organic emitting layer 462 is formed on the first electrode 460.

Referring to FIG. 6, the OLED D includes the first and second electrodes 460 and 464 facing each other and the organic emitting layer 462 between the first and second electrodes 460 and 464. The organic emitting layer 462 includes a first emitting part 710 including a first EML 720, a second emitting part 730 including a second EML 740 and a charge generation layer (CGL) 750 between the first and second emitting parts 710 and 730.

The first electrode 460 may be formed of a conductive material having a relatively high work function to serve as an anode for injecting a hole into the organic emitting layer 462. The second electrode 464 may be formed of a conductive material having a relatively low work function to serve as a cathode for injecting an electron into the organic emitting layer 462.

The CGL 750 is positioned between the first and second emitting parts 710 and 730, and the first emitting part 710, the CGL 750 and the second emitting part 730 are sequentially stacked on the first electrode 460. Namely, the first emitting part 710 is positioned between the first electrode 460 and the CGL 750, and the second emitting part 720 is positioned between the second electrode 460 and the CGL 750.

The first emitting part 710 includes a first EML 720. In addition, the first emitting part 710 may further include a first EBL 716 between the first electrode 460 and the first EML 720 and a first HBL 718 between the first EML 720 and the CGL 750.

In addition, the first emitting part 710 may further include a first HTL 714 between the first electrode 460 and the first EBL 716 and an HIL 712 between the first electrode 460 and the first HTL 714.

The first EML 720 includes the emitting compound in Formula 1 as a first compound 722 and provides blue emission. For example, the first compound 722 in the first EML 720 may be one of the compounds in Formula 6.

The EML 720 may further include a second compound 724. For example, the second compound 724 may be represented by Formula 7 and may be one of the compounds in Formula 8.

In the first EML 720, the first compound 722 has a weight % being smaller than the second compound 724. The first compound 722 may act as a dopant (an emitter), and the second compound 724 may act as a host. For example, in the first EML 720, the first compound 722 may have a weight % of 0.1 to 30. To provide sufficient emitting efficiency and lifespan, the weight % of the first compound 722 may be 0.1 to 10, or 1 to 5.

The first EBL 716 may include the compound in Formula 9 as the electron blocking material. In addition, the first HBL 718 may include at least one of the compounds in Formula 11 and Formula 13 as the hole blocking material.

The second emitting part 730 includes the second EML 740. In addition, the second emitting part 730 may further include a second EBL 734 between the CGL 750 and the second EML 740 and a second HBL 736 between the second EML 740 and the second electrode 464.

In addition, the second emitting part 730 may further include a second HTL 732 between the CGL 750 and the second EBL 734 and an EIL 738 between the second HBL 736 and the second electrode 464.

The second EML 740 may be a yellow-green EML. For example, the second EML 740 may include a yellow-green dopant 743 and a host 745. The yellow-green dopant 743 may be one of a yellow-green fluorescent compound, a yellow-green phosphorescent compound and a yellow-green delayed fluorescent compound.

In the second EML 740, the host 745 may have a weight % of 70 to 99.9, and the yellow-green dopant 743 may have a weight % of 0.1 to 30. To provide sufficient emitting efficiency, the yellow-green dopant 744 may have a weight % of 0.1 to 10, or 1 to 5.

The second EBL 734 may include the compound in Formula 9 as the electron blocking material. In addition, the second HBL 736 may include at least one of the compounds in Formula 11 and Formula 13 as the hole blocking material.

The CGL 750 is positioned between the first and second emitting parts 710 and 730. Namely, the first and second emitting parts 710 and 730 are connected through the CGL 750. The CGL 750 may be a P-N junction CGL of an N-type CGL 752 and a P-type CGL 754.

The N-type CGL 752 is positioned between the first HBL 718 and the second HTL 732, and the P-type CGL 754 is positioned between the N-type CGL 752 and the second HTL 732.

In FIG. 6, the first EML 720, which is positioned between the first electrode 460 and the CGL 750, includes the first compound 722 being the emitting compound of the present disclosure and the second compound 724 being the anthracene derivative, and the second EML 740, which is positioned between the second electrode 464 and the CGL 750, is the yellow-green EML. Alternatively, the first EML 720, which is positioned between the first electrode 460 and the CGL 750, may be the yellow-green EML, and the second EML 740, which is positioned between the second electrode 464 and the CGL 750, may include the emitting compound of the present disclosure and the anthracene derivative to be a blue EML.

In the OLED D, since the first EML 720 includes the emitting compound 722 of the present disclosure such that the emitting efficiency and the lifespan of the OLED D and the organic light emitting display device 400 are significantly improved.

The OLED D including the first emitting part 710 providing the blue emission and the second emitting part 730 providing the yellow-green emission, emits a white light.

Referring to FIG. 7, the organic emitting layer 462 includes a first emitting part 530 including a first EML 520, a second emitting part 550 including a second EML 540, a third emitting part 570 including a third EML 560, a first CGL 580 between the first and second emitting parts 530 and 550 and a second CGL 590 between the second and third emitting parts 550 and 570.

The first CGL 580 is positioned between the first and second emitting parts 530 and 550, and the second CGL 590 is positioned between the second and third emitting parts 550 and 570. Namely, the first emitting part 530, the first CGL 580, the second emitting part 550, the second CGL 590 and the third emitting part 570 are sequentially stacked on the first electrode 460. In other words, the first emitting part 530 is positioned between the first electrode 460 and the first CGL 570, the second emitting part 550 is positioned between the first and second CGLs 580 and 590, and the third emitting part 570 is positioned between the second electrode 460 and the second CGL 590.

The first emitting part 530 may include an HIL 532, a first HTL 534, a first EBL 536, the first EML 520 and a first HBL 538 sequentially stacked on the first electrode 460. For example, the HIL 532, the first HTL 534 and the first EBL 536 are positioned between the first electrode 460 and the first EML 520, and the first HBL 538 is positioned between the first EML 520 and the first CGL 580.

The first EML 520 includes the emitting compound in Formula 1 as a first compound 522 and provides blue emission. For example, the first compound 522 in the first EML 520 may be one of the compounds in Formula 6.

The EML 520 may further include a second compound 524. For example, the second compound 524 may be represented by Formula 7 and may be one of the compounds in Formula 8.

In the first EML 520, the first compound 522 has a weight % being smaller than the second compound 524. The first compound 522 may act as a dopant (an emitter), and the second compound 524 may act as a host. For example, in the first EML 520, the first compound 522 may have a weight % of 0.1 to 30. To provide sufficient emitting efficiency and lifespan, the weight % of the first compound 522 may be 0.1 to 10, or 1 to 5.

The first EBL 536 may include the compound in Formula 9 as the electron blocking material. In addition, the first HBL 538 may include at least one of the compounds in Formula 11 and Formula 13 as the hole blocking material.

The second EML 550 may include a second HTL 552, the second EML 540 and an electron transporting layer (ETL) 554. The second HTL 552 is positioned between the first CGL 580 and the second EML 540, and the ETL 554 is positioned between the second EML 540 and the second CGL 590.

The second EML 540 may be a yellow-green EML. For example, the second EML 540 may include a host and a yellow-green dopant.

Alternatively, the second EML 540 may include a host, a red dopant and a green dopant. In this instance, the second EML 540 may has a single-layered structure or a double-layered structure of a lower layer including the host and the red dopant (or the green dopant) and an upper layer including the host and the green dopant (or the red dopant).

The second EML 540 may have a triple-layered structure of a first layer, which includes a host and a red dopant, a second layer, which includes a host and a yellow-green dopant, and a third layer, which includes a host and a green dopant.

The third emitting part 570 may include a third HTL 572, a second EBL 574, the third EML 560, a second HBL 576 and an EIL 578.

The third EML 560 includes the emitting compound in Formula 1 as a third compound 562 and provides blue emission. For example, the third compound 562 in the third EML 560 may be one of the compounds in Formula 6.

The third EML 560 may further include a fourth compound 564. For example, the fourth compound 564 may be represented by Formula 7 and may be one of the compounds in Formula 8.

In the third EML 560, the third compound 562 may have a weight % being less than the fourth compound 564. In the third EML 560, the third compound 562 may act as a dopant (an emitter), and the fourth compound 564 may act as a host. For example, in the third EML 560, the third compound 562 has a weight % of 0.1 to 30. To provide sufficient emitting efficiency and lifespan, the weight % of the third compound 562 may be 0.1 to 10, or 1 to 5.

The third compound 562 in the third EML 560 and the first compound 522 in the first EML 520 may be same or different, and the fourth compound 564 in the third EML 560 and the second compound 524 in the first EML 520 may be same or different. In addition, the weight % of the first compound 522 in the first EML 520 and the weight % of the third compound 562 in the third EML 560 may be same or different.

The second EBL 574 may include the electron blocking material in Formula 9. In addition, the second HBL 576 may include at least one of the hole blocking material in Formula 11 and the hole blocking material in Formula 13.

The first CGL 580 is positioned between the first emitting part 530 and the second emitting part 550, and the second CGL 590 is positioned between the second emitting part 550 and the third emitting part 570. Namely, the first and second emitting stacks 530 and 550 are connected through the first CGL 580, and the second and third emitting stacks 550 and 570 are connected through the second CGL 590. The first CGL 580 may be a P-N junction CGL of a first N-type CGL 582 and a first P-type CGL 584, and the second CGL 590 may be a P-N junction CGL of a second N-type CGL 592 and a second P-type CGL 594.

In the first CGL 580, the first N-type CGL 582 is positioned between the first HBL 538 and the second HTL 552, and the first P-type CGL 584 is positioned between the first N-type CGL 582 and the second HTL 552.

In the second CGL 590, the second N-type CGL 592 is positioned between the ETL 554 and the third HTL 572, and the second P-type CGL 594 is positioned between the second N-type CGL 592 and the third HTL 572.

In the OLED D, since each of the first and third EMLs 520 and 560 includes the emitting compound in Formula 1 as the first and third compounds 522 and 562, respectively, the emitting efficiency and the lifespan of the OLED D and the organic light emitting display device 400 are improved.

In addition, the OLED D including the first and third emitting parts 530 and 570 with the second emitting part 550, which emits yellow-green light or red/green light, can emit white light.

In FIG. 7, the OLED D has a triple-stack structure of the first, second and third emitting parts 530, 550 and 570. Alternatively, the OLED D may further include additional emitting part and CGL.

Referring to FIG. 5 again, a second electrode 464 is formed over the substrate 410 where the organic emitting layer 462 is formed.

In the organic light emitting display device 400, since the light emitted from the organic emitting layer 462 is incident to the color filter layer 480 through the second electrode 464, the second electrode 464 has a thin profile for transmitting the light.

The first electrode 460, the organic emitting layer 462 and the second electrode 464 constitute the OLED D.

The color filter layer 480 is positioned over the OLED D and includes a red color filter 482, a green color filter 484 and a blue color filter 486 respectively corresponding to the red, green and blue pixels RP, GP and BP. The red color filter 482 may include at least one of red dye and red pigment, the green color filter 482 may include at least one of green dye and green pigment, and the blue color filter 482 may include at least one of blue dye and blue pigment.

Although not shown, the color filter layer 480 may be attached to the OLED D by using an adhesive layer. Alternatively, the color filter layer 480 may be formed directly on the OLED D.

An encapsulation film (not shown) may be formed to prevent penetration of moisture into the OLED D. For example, the encapsulation film may include a first inorganic insulating layer, an organic insulating layer and a second inorganic insulating layer sequentially stacked, but it is not limited thereto. The encapsulation film may be omitted.

A polarization plate (not shown) for reducing an ambient light reflection may be disposed over the top-emission type OLED D. For example, the polarization plate may be a circular polarization plate.

In the OLED of FIG. 5, the first and second electrodes 460 and 464 are a reflection electrode and a transparent (or semi-transparent) electrode, respectively, and the color filter layer 480 is disposed over the OLED D. Alternatively, when the first and second electrodes 460 and 464 are a transparent (or semi-transparent) electrode and a reflection electrode, respectively, the color filter layer 480 may be disposed between the OLED D and the first substrate 410.

A color conversion layer (not shown) may be formed between the OLED D and the color filter layer 480. The color conversion layer may include a red color conversion layer, a green color conversion layer and a blue color conversion layer respectively corresponding to the red, green and blue pixels RP, GP and BP. The white light from the OLED D is converted into the red light, the green light and the blue light by the red, green and blue color conversion layer, respectively. For example, the color conversion layer may include a quantum dot. Accordingly, the color purity of the organic light emitting display device 400 may be further improved.

The color conversion layer may be included instead of the color filter layer 480.

As described above, in the organic light emitting display device 400, the OLED D in the red, green and blue pixels RP, GP and BP emits the white light, and the white light from the organic light emitting diode D passes through the red color filter 482, the green color filter 484 and the blue color filter 486. As a result, the red light, the green light and the blue light are provided from the red pixel RP, the green pixel GP and the blue pixel BP, respectively.

In FIGs. 5 to 7, the OLED D emitting the white light is used for a display device. Alternatively, the OLED D may be formed on an entire surface of a substrate without at least one of the driving element and the color filter layer to be used for a lightening device. The display device and the lightening device each including the OLED D of the present disclosure may be referred to as an organic light emitting device.

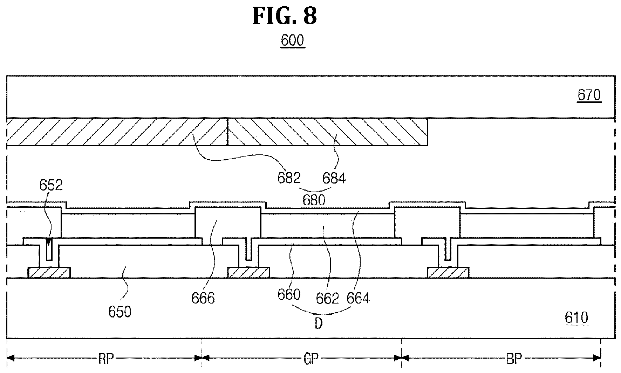

FIG. 8 is a schematic cross-sectional view illustrating an organic light emitting display device according to a third aspect of the present disclosure.

As shown in FIG. 8, the organic light emitting display device 600 includes a first substrate 610, where a red pixel BP, a green pixel GP and a blue pixel BP are defined, a second substrate 670 facing the first substrate 610, an OLED D, which is positioned between the first and second substrates 610 and 670 and providing white emission, and a color conversion layer 680 between the OLED D and the second substrate 670.

Although not shown, a color filter may be formed between the second substrate 670 and each color conversion layer 680.

Each of the first and second substrates 610 and 670 may be a glass substrate or a flexible substrate. For example, each of the first and second substrates 410 and 470 may be a polyimide (PI) substrate, a polyethersulfone (PES) substrate, a polyethylenenaphthalate (PEN) substrate, a polyethylene terephthalate (PET) substrate or a polycarbonate (PC) substrate.

A TFT Tr, which corresponding to each of the red, green and blue pixels RP, GP and BP, is formed on the first substrate 610, and a passivation layer 650, which has a drain contact hole 652 exposing an electrode, e.g., a drain electrode, of the TFT Tr is formed to cover the TFT Tr.

The OLED D including a first electrode 660, an organic emitting layer 662 and a second electrode 664 is formed on the passivation layer 650. In this instance, the first electrode 660 may be connected to the drain electrode of the TFT Tr through the drain contact hole 652.

A bank layer 666 is formed on the passivation layer 650 to cover an edge of the first electrode 660. Namely, the bank layer 666 is positioned at a boundary of the pixel and exposes a center of the first electrode 460 in the pixel. Since the OLED D emits the blue light in the red, green and blue pixels RP, GP and BP, the organic emitting layer 162 may be formed as a common layer in the red, green and blue pixels RP, GP and BP without separation. The bank layer 466 may be formed to prevent a current leakage at an edge of the first electrode 460 and may be omitted.

The OLED D emits a blue light and may have a structure shown in FIG. 3 or FIG. 4. Namely, the OLED D is formed in each of the red, green and blue pixels RP, GP and BP and provides the blue light.

The color conversion layer 680 includes a first color conversion layer 682 corresponding to the red pixel RP and a second color conversion layer 684 corresponding to the green pixel GP. For example, the color conversion layer 680 may include an inorganic color conversion material such as a quantum dot. The color conversion layer 680 is not presented in the blue pixel BP such that the OLED D in the blue pixel BP may directly face the second substrate 670.

The blue light from the OLED D is converted into the red light by the first color conversion layer 682 in the red pixel RP, and the blue light from the OLED D is converted into the green light by the second color conversion layer 684 in the green pixel GP.

Accordingly, the organic light emitting display device 600 can display a full-color image.

On the other hand, when the light from the OLED D passes through the first substrate 610, the color conversion layer 680 is disposed between the OLED D and the first substrate 610.

## Claims

1. An emitting compound represented by Formula 1: 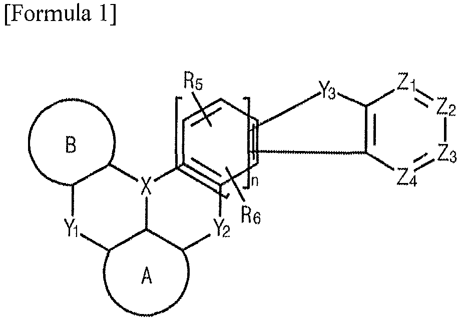
wherein n is 0 or 1,
X is one of B, P=O and P=S,
each of Y₁ and Y₂ is independently selected from the group consisting of NR₁, C(R₂)₂, O, S, Se and Si(R₃)₂, and
Y₃ is O or S,
wherein each of Z₁ to Z₄ is independently N or CR₄, and at least three of Z₁ to Z₄ are CR₄,
wherein each of R₁ to R₃ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl,
wherein each of R₄ to R₆ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, or adjacent two of R₄ to R₆ are connected to each other to form a fused ring, and at least one of R₄ to R₆ is C1 to C10 alkyl substituted with deuterium, and
wherein each of A and B rings is independently selected from the group consisting of substituted or unsubstituted six-membered cycloalkyl ring, substituted or unsubstituted six-membered aromatic ring and substituted or unsubstituted six-membered heteroaromatic ring,
wherein the Formula 1 is represented by one of Formula 2-1, Formula 3-1, Formula 4-1 and Formula 5-1: 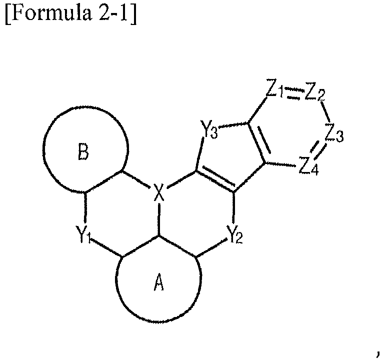 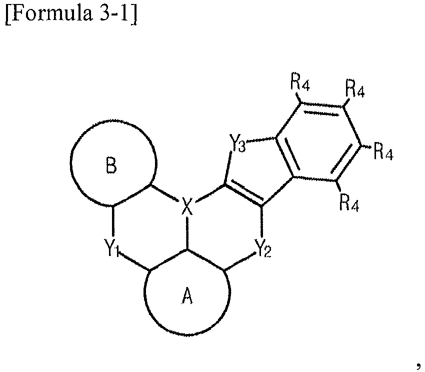 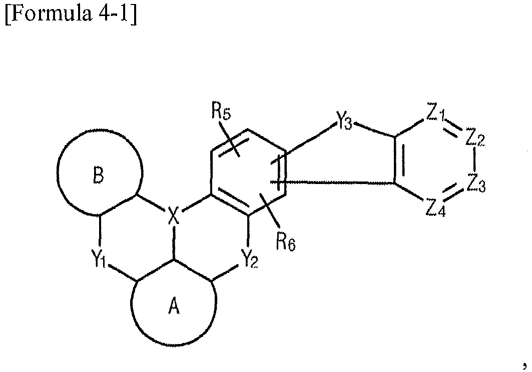 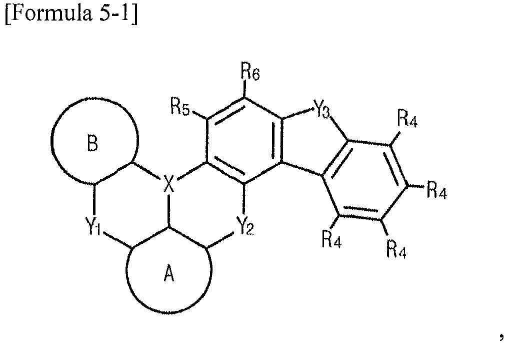
wherein in the Formula 2-1, one of Z₁ to Z₄ is N, three of Z₁ to Z₄ are CR₄, one of three R₄ is deuterium-substituted C1 to C10 alkyl group, and the rest of three R₄ are hydrogen,
wherein in the Formula 3-1, adjacent two of R₄ are connected to each other to form a fused ring, one of the other two R₄ is deuterium-substituted C1 to C10 alkyl, and the other of the other two of R₄ is hydrogen,
wherein in the Formula 4-1, one of Z₁ to Z₄ is N, three of Z₁ to Z₄ are CR₄, one of three R₄ is deuterium-substituted C1 to C10 alkyl group, and the rest of three R₄ are hydrogen, and
wherein in the Formula 5-1, adjacent two of four R₄ or R₅ and R₆ is connected to form a fused ring, one of the other four of R₄, R₅ and R₆ is deuterium-substituted C1 to C10 alkyl group, and the rest of the other four of R₄, R₅ and R₆ is hydrogen.

2. The emitting compound according to claim 1, wherein the Formula 2-1 is represented by Formula 2-2: 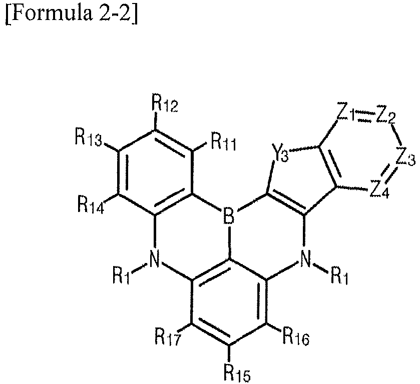 wherein each of R₁₁ to R₁₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

3. The emitting compound according to claim 1, wherein the Formula 3-1 is represented by Formula 3-2: 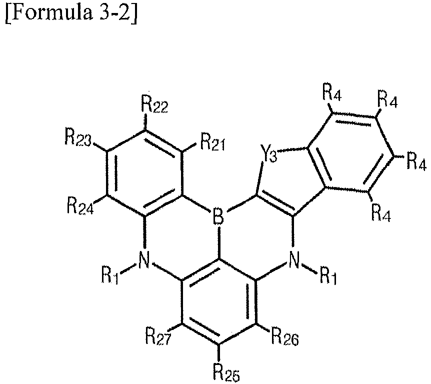 wherein each of R₂₁ to R₂₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

4. The emitting compound according to claim 1, wherein the Formula 4-1 is represented by one of Formulas 4-2 to 4-4: 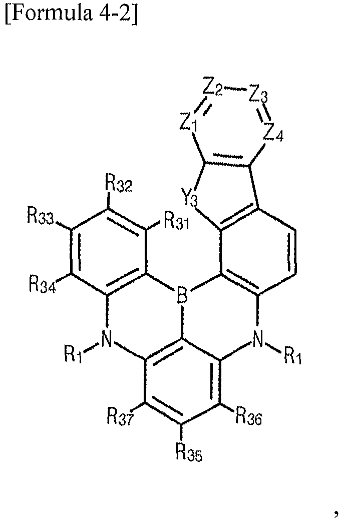 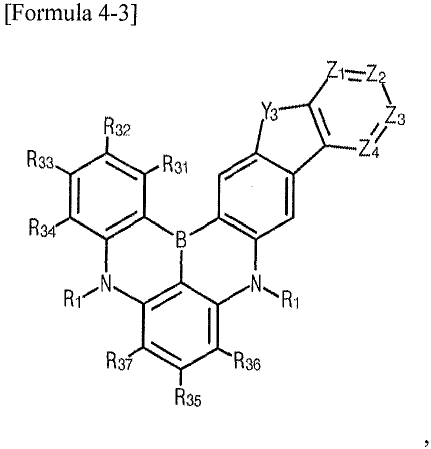 and 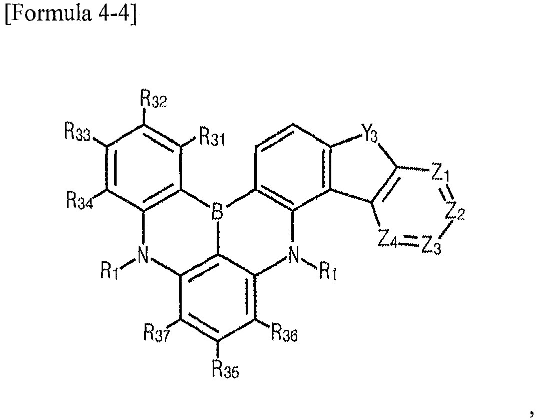 wherein each of R₃₁ to R₃₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

5. The emitting compound according to claim 4, wherein the Formulas 4-2 to 4-4 are respectively represented by Formulas 4-5 to 4-7: 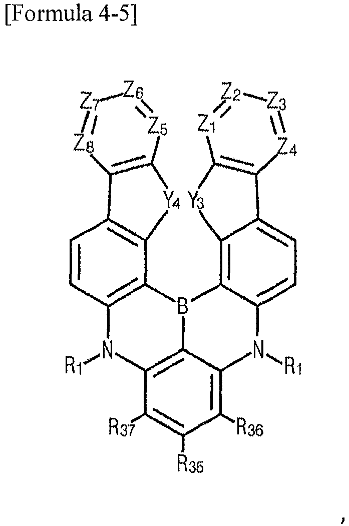 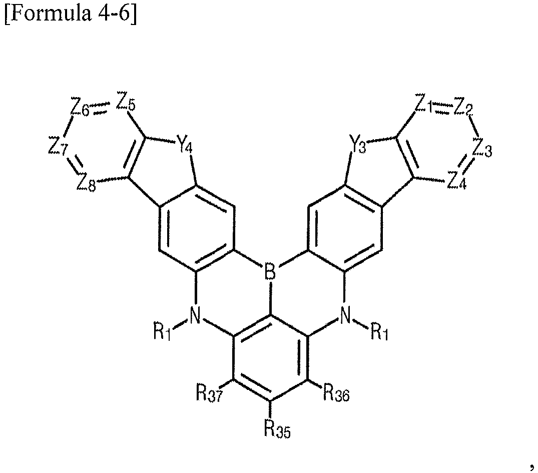 and 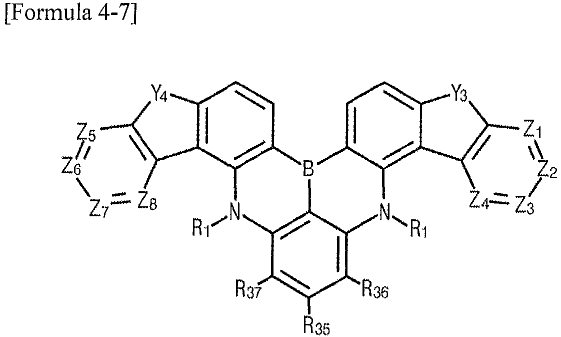
wherein in the Formulas 4-5 to 4-7, Y₄ is O or S,
wherein one of Z₅ to Z₈ is N, and the other three of Z₅ to Z₈ are CR₇,
wherein each of three R₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, and at least one of three R₇ is deuterium -substituted C1 to C10 alkyl group, and
wherein each of R₃₅ to R₃₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

6. The emitting compound according to claim 1, wherein the Formula 5-1 is represented by Formula 5-2: 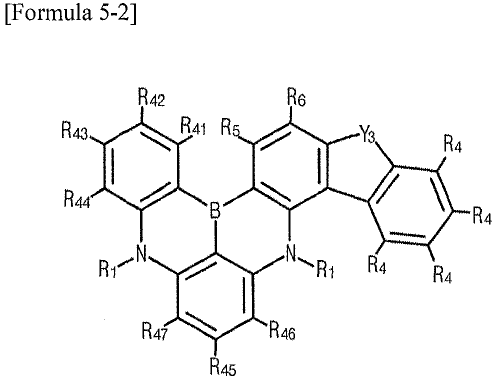 wherein each of R₄₁ to R₄₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

7. The emitting compound according to claim 1, wherein the Formula 5-1 is represented by Formula 5-3: 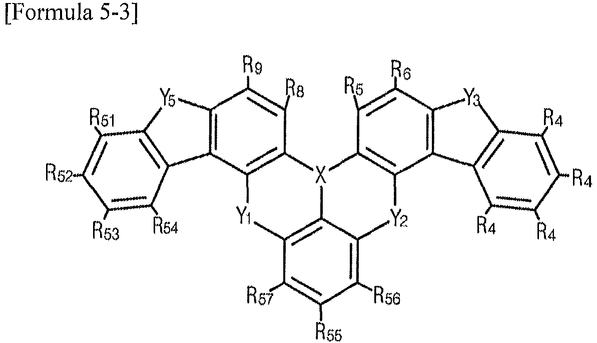
wherein in the Formula 5-3, Y₅ is O or S,
wherein adjacent two of four R₄ or R₅ and R₆ is connected to form a fused ring, and at least one of the other four of R₄, R₅ and R₆ is deuterium-substituted C1 to C10 alkyl group,
wherein each of R₈, R₉ and R₅₁ to R₅₄ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl, or adjacent two of R₅₁ to R₅₄ or R₈ and R₉ is connected to form a fused ring,
wherein at least one of the other four of R₈, R₉ and R₅₁ to R₅₄ is deuterium-substituted C1 to C10 alkyl group, and
wherein each of R₅₅ to R₅₇ is independently selected from the group consisting of hydrogen, deuterium, C1 to C10 alkyl group unsubstituted or substituted with deuterium, C6 to C30 arylamine group unsubstituted or substituted with deuterium or C1 to C10 alkyl, C6 to C30 aryl group unsubstituted or substituted with deuterium or C1 to C10 alkyl, and C5 to C30 heteroaryl group unsubstituted or substituted with deuterium or C1 to C10 alkyl.

8. The emitting compound according to claim 7, wherein the Formula 5-3 is represented by Formula 5-4:

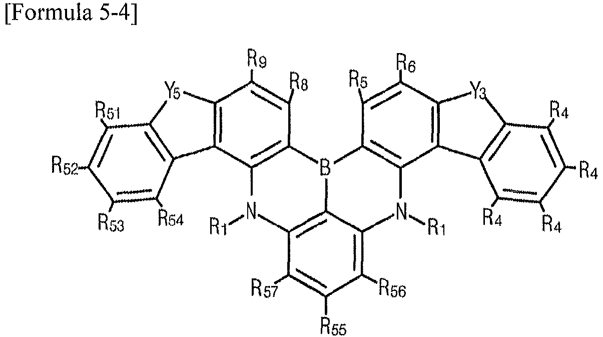

9. The emitting compound according to claim 1, wherein the emitting compound is one compound selected from the group of compounds represented by Formula 6:

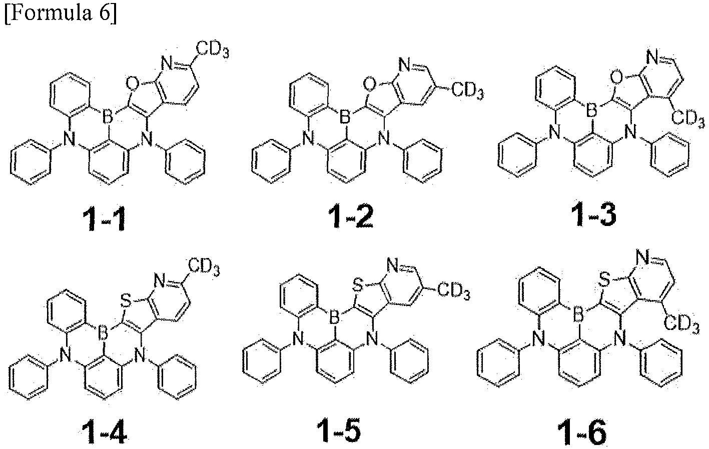

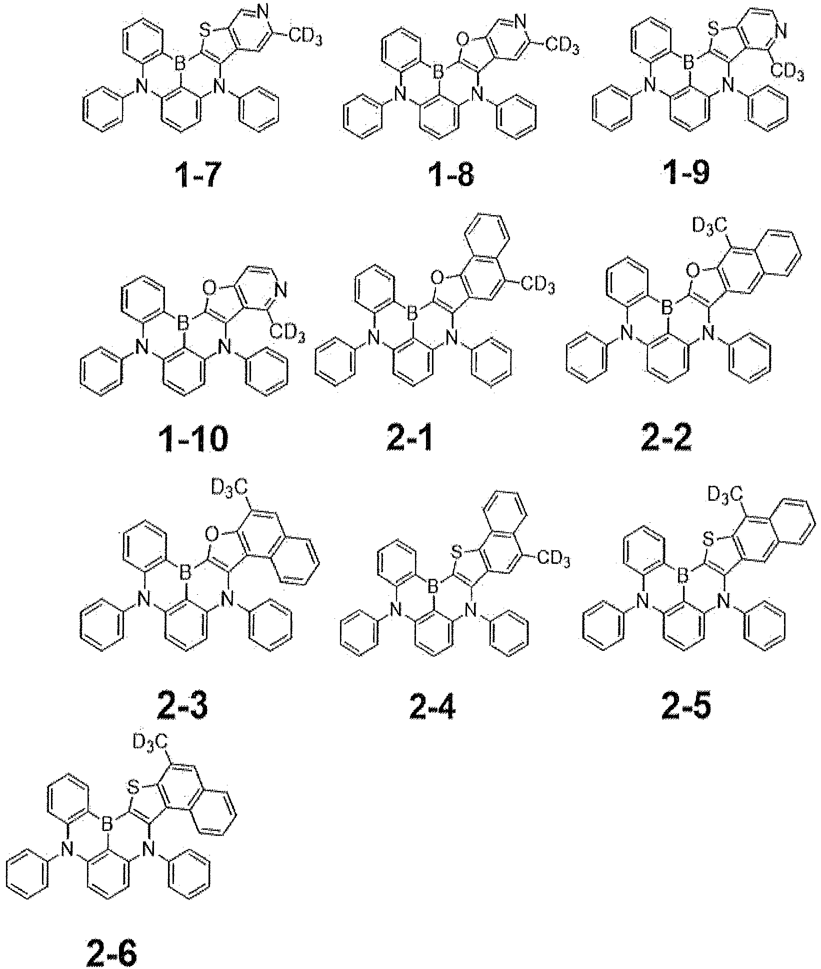

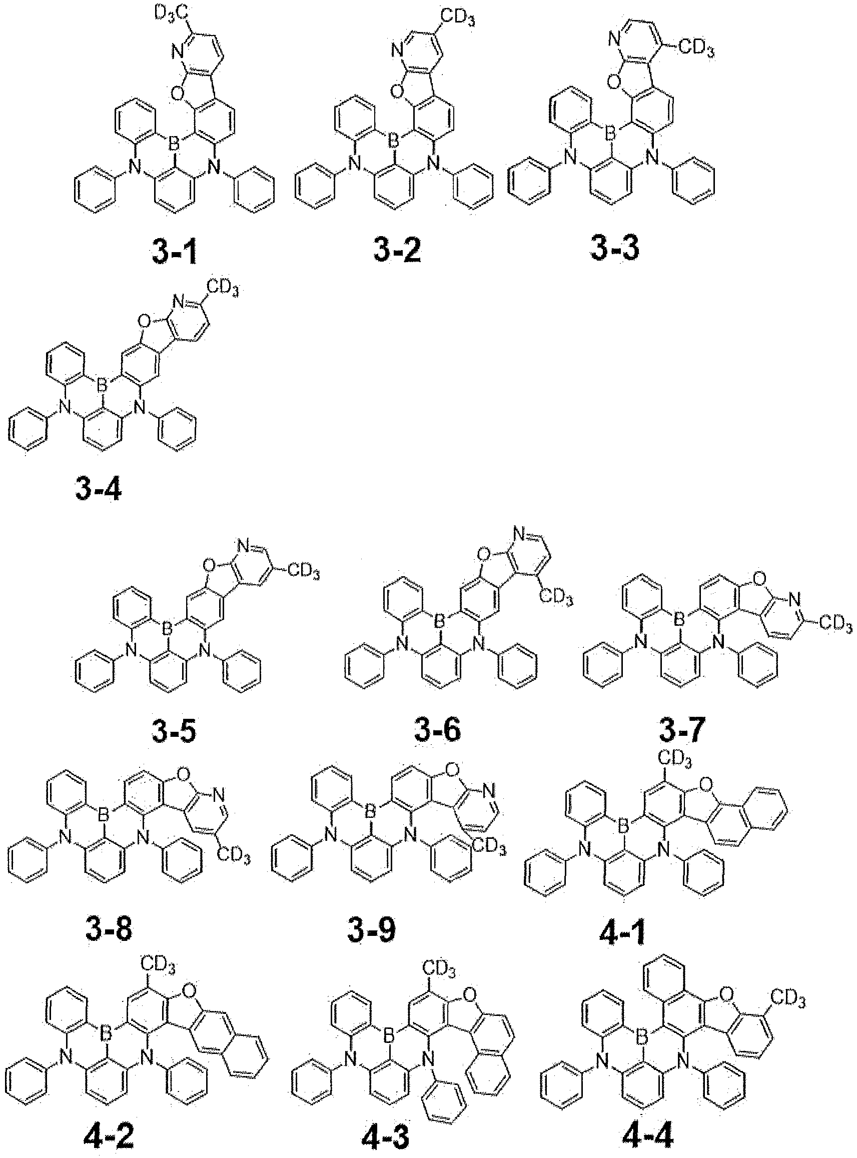

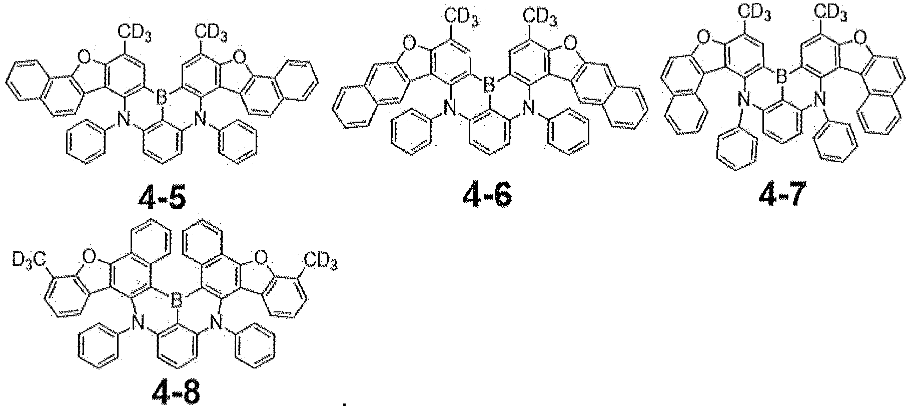

10. An organic light emitting device, comprising:
a substrate (110); and
an organic light emitting diode (D) positioned on the substrate and including a first electrode; a second electrode (164) facing the first electrode (160); and a first emitting material layer (162) including a first compound and positioned between the first and second electrodes,
wherein the first compound is the emitting compound according to any one of the preceding claims.

11. The organic light emitting device of claim 10,
wherein the first emitting material layer further includes a second compound,
wherein the second compound is represented by Formula 7: 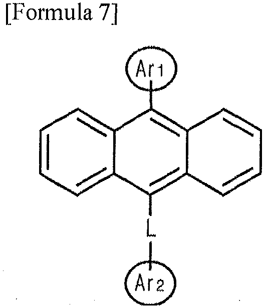
wherein each of Ar₁ and Ar₂ is independently C6 to C30 aryl group or C5 to C30 heteroaryl group, L is a single bond or C6 to C30 arylene group, and
wherein hydrogens are not deuterated or partially or wholly deuterated.

## Patentansprüche

1. Emissionsverbindung, die durch Formel 1 dargestellt ist: 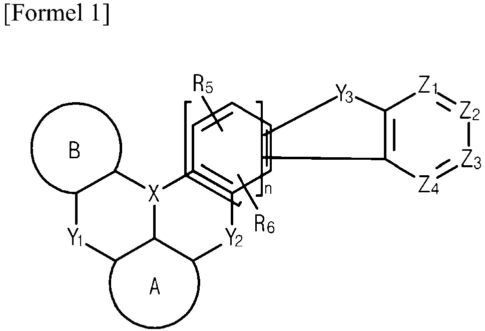 wobei n 0 oder 1 ist,
X eines von B, P=O und P=S ist,
jedes von Y₁ und Y₂ unabhängig aus der Gruppe ausgewählt ist, die aus NR₁, C(R₂)₂, O, S, Se und Si(R₃)₂ besteht, und
Y₃ O oder S ist,
wobei jedes von Z₁ bis Z₄ unabhängig N oder CR₄ ist und mindestens drei von Z₁ bis Z₄ CR₄ sind,
wobei jedes von R₁ bis R₃ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht,
wobei jedes von R₄ bis R₆ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht, oder benachbarte zwei von R₄ bis R₆ miteinander verbunden sind, um einen fusionierten Ring zu bilden, und mindestens eines von R₄ bis R₆ C1- bis C10-Alkyl ist, das mit Deuterium substituiert ist, und
wobei jeder von A- und B-Ringen unabhängig aus der Gruppe ausgewählt ist, die aus einem substituierten oder unsubstituierten sechsgliedrigen Cycloalkylring, einem substituierten oder unsubstituierten sechsgliedrigen aromatischen Ring und einem substituierten oder unsubstituierten sechsgliedrigen heteroaromatischen Ring besteht,
wobei die Formel 1 durch eine von Formel 2-1, Formel 3-1, Formel 4-1 und Formel 5-1 dargestellt ist: 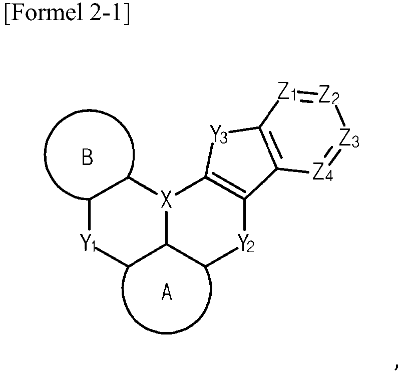 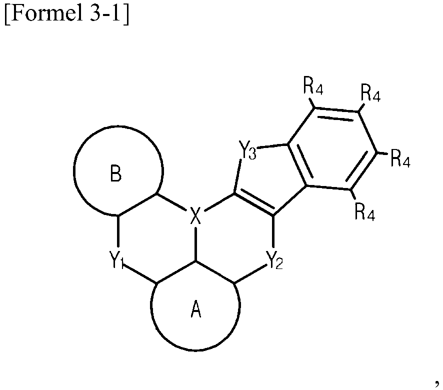 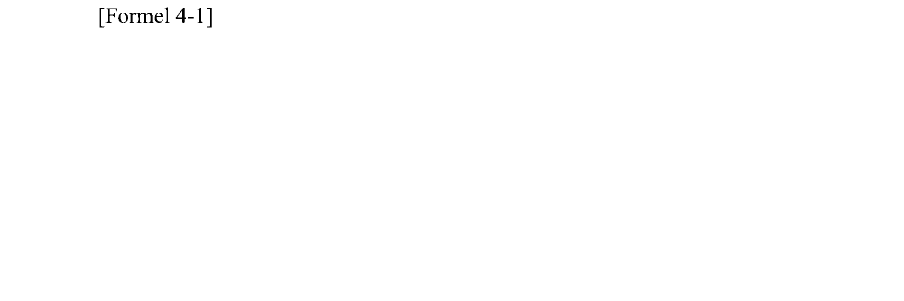 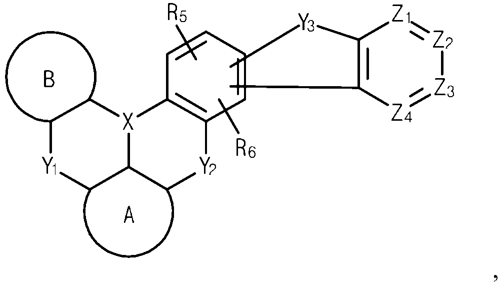 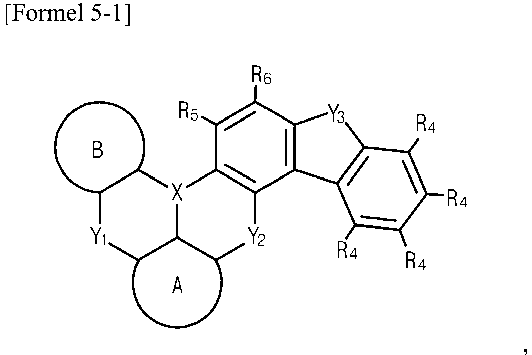
wobei in der Formel 2-1 eines von Z₁ bis Z₄ N ist, drei von Z₁ bis Z₄ CR₄ sind, eines von drei R₄ eine mit Deuterium substituierte C1- bis C10-Alkylgruppe ist und der Rest von drei R₄ Wasserstoff ist,
wobei in der Formel 3-1 benachbarte zwei von R₄ miteinander verbunden sind, um einen fusionierten Ring zu bilden, eines der anderen zwei R₄ mit Deuterium substituiertes C1- bis C10-Alkyl ist, und das andere der anderen zwei von R₄ Wasserstoff ist,
wobei in der Formel 4-1 eines von Z₁ bis Z₄ N ist, drei von Z₁ bis Z₄ CR₄ sind, eines von drei R₄ eine mit Deuterium substituierte C1- bis C10-Alkylgruppe ist und der Rest von drei R₄ Wasserstoff ist, und
wobei in der Formel 5-1 benachbarte zwei von vier R₄ oder R₅ und R₆ verbunden sind, um einen fusionierten Ring zu bilden, eines der anderen vier von R₄, R₅ und R₆ eine mit Deuterium substituierte C1- bis C10-Alkylgruppe ist und der Rest der anderen vier von R₄, R₅ und R₆ Wasserstoff ist.

2. Emissionsverbindung nach Anspruch 1, wobei die Formel 2-1 durch Formel 2-2 dargestellt ist: 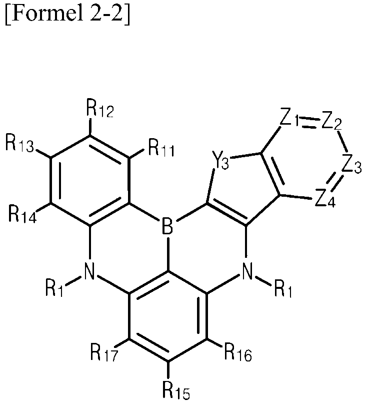 wobei jedes von R₁₁ bis R₁₇ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht.

3. Emissionsverbindung nach Anspruch 1, wobei die Formel 3-1 durch Formel 3-2 dargestellt ist: 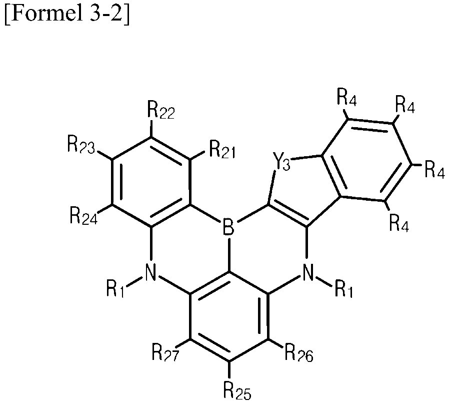 wobei jedes von R₂₁ bis R₂₇ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht.

4. Emissionsverbindung nach Anspruch 1, wobei die Formel 4-1 durch eine der Formeln 4-2 bis 4-4 dargestellt ist: 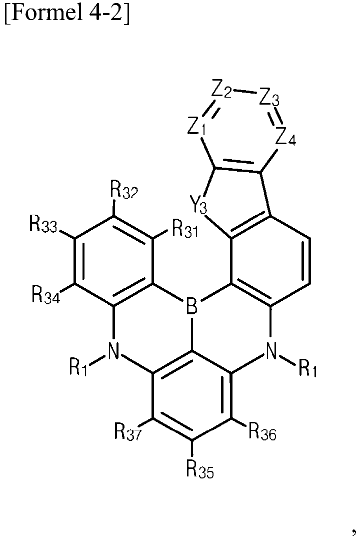 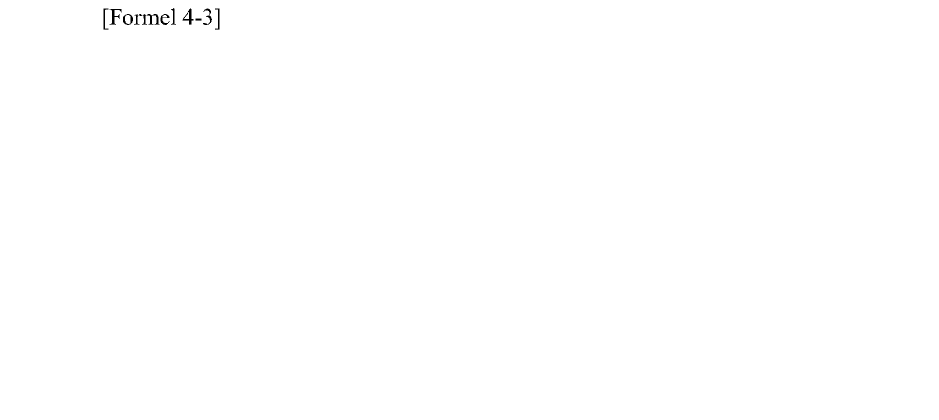 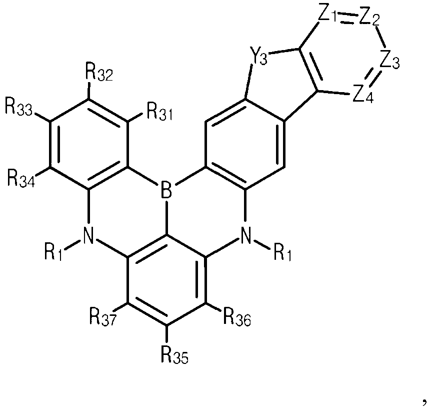 und 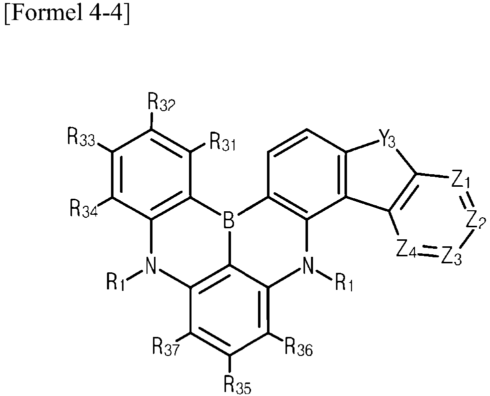 , wobei jedes von R₃₁ bis R₃₇ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht.

5. Emissionsverbindung nach Anspruch 4, wobei die Formeln 4-2 bis 4-4 jeweils durch die Formeln 4-5 bis 4-7 dargestellt sind: 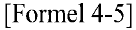 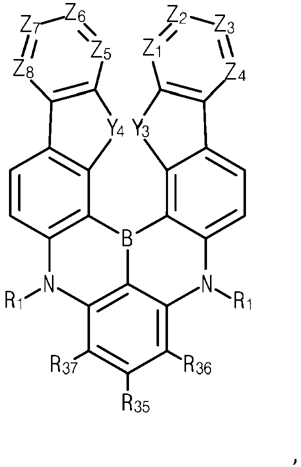 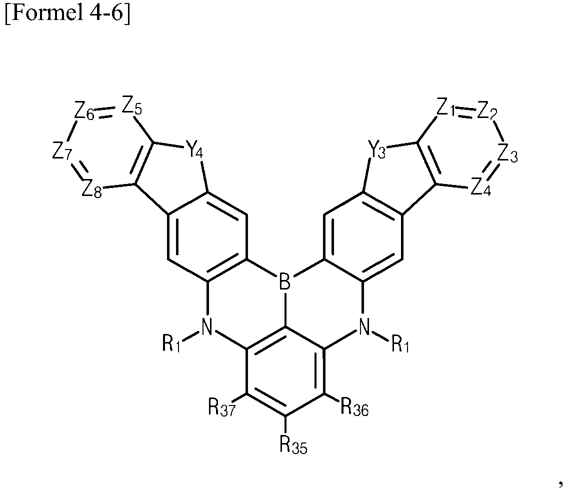 und 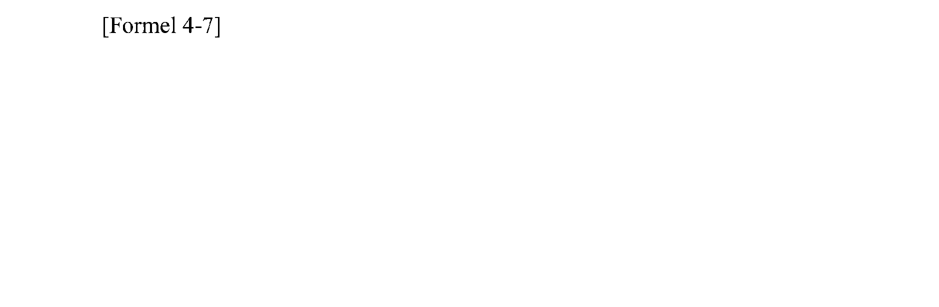 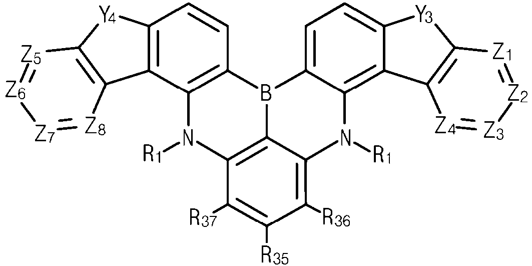
wobei in den Formeln 4-5 bis 4-7 Y₄ O oder S ist,
wobei eines von Z₅ bis Z₈ N ist und die anderen drei von Z₅ bis Z₈ CR₇ sind,
wobei jedes von drei R₇ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht, und mindestens eines von drei R₇ eine mit Deuterium substituierte C1- bis C10-Alkylgruppe ist, und
wobei jedes von R₃₅ bis R₃₇ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht.

6. Emissionsverbindung nach Anspruch 1, wobei die Formel 5-1 durch Formel 5-2 dargestellt ist: 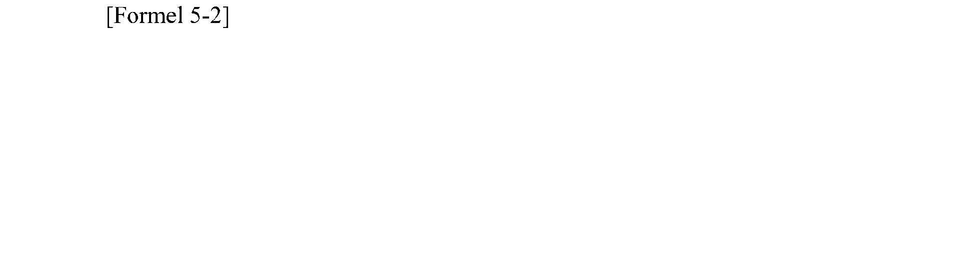 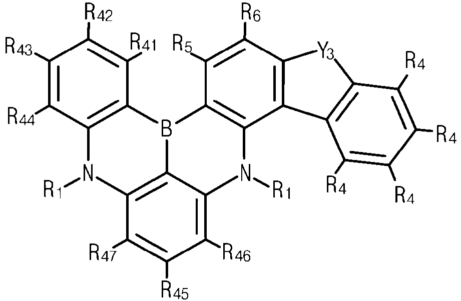 wobei jedes von R₄₁ bis R₄₇ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht.

7. Emissionsverbindung nach Anspruch 1, wobei die Formel 5-1 durch die Formel 5-3 dargestellt ist: 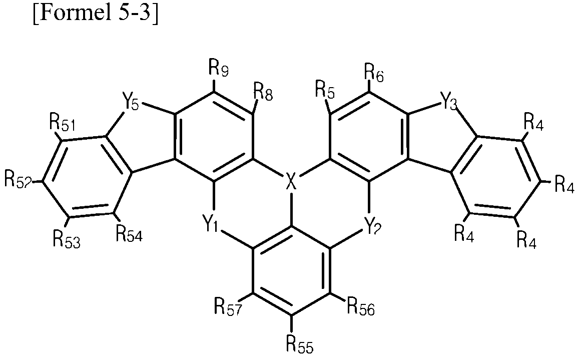
wobei in der Formel 5-3 Y₅ O oder S ist,
wobei benachbarte zwei von vier R₄ oder R₅ und R₆ verbunden sind, um einen fusionierten Ring zu bilden, und mindestens eines der anderen vier von R₄, R₅ und R₆ eine mit Deuterium substituierte C1- bis C10-Alkylgruppe ist,
wobei jedes von R₈, R₉ und R₅₁ bis R₅₄ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht, oder benachbarte zwei von R₅₁ bis R₅₄ oder R₈ und R₉ verbunden sind, um einen fusionierten Ring zu bilden,
wobei mindestens eines der anderen vier von R₈, R₉ und R₅₁ bis R₅₄ eine mit Deuterium substituierte C1- bis C10-Alkylgruppe ist, und
wobei jedes von R₅₅ bis R₅₇ unabhängig aus der Gruppe ausgewählt ist, die aus Wasserstoff, Deuterium, einer C1- bis C10-Alkylgruppe, die unsubstituiert oder mit Deuterium substituiert ist, einer C6- bis C30-Arylamingruppe, die unsubstituiert oder mit Deuterium oder C1- bis C10-Alkyl substituiert ist, einer C6- bis C30-Arylgruppe, die unsubstituiert oder mit Deuterium oder C1- bis C10-Alkyl substituiert ist, und einer C5-bis C30-Heteroarylgruppe, die unsubstituiert oder mit Deuterium oder C1- bis C10-Alkyl substituiert ist, besteht.

8. Emissionsverbindung nach Anspruch 7, wobei die Formel 5-3 durch Formel 5-4 dargestellt ist:

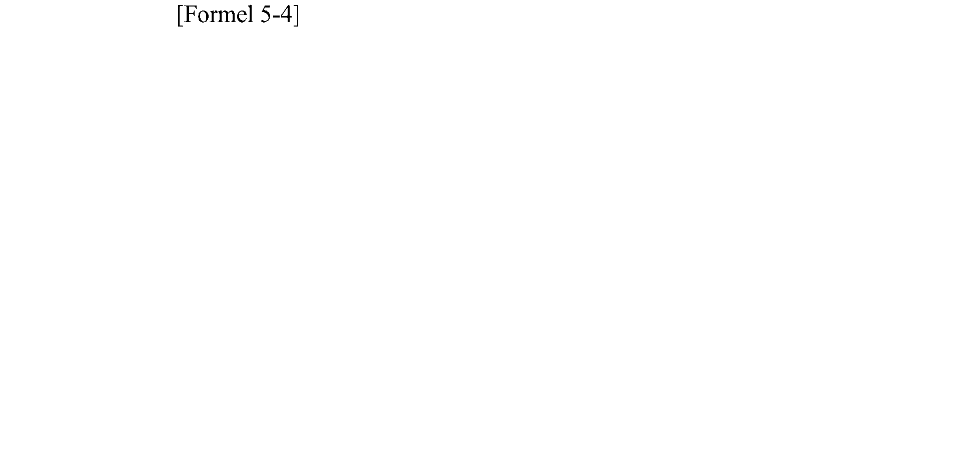

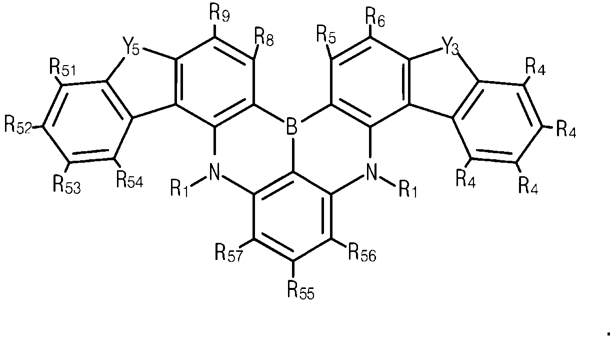

9. Emissionsverbindung nach Anspruch 1, wobei die Emissionsverbindung eine Verbindung ist, die aus der Gruppe von Verbindungen ausgewählt ist, die durch Formel 6 dargestellt sind:

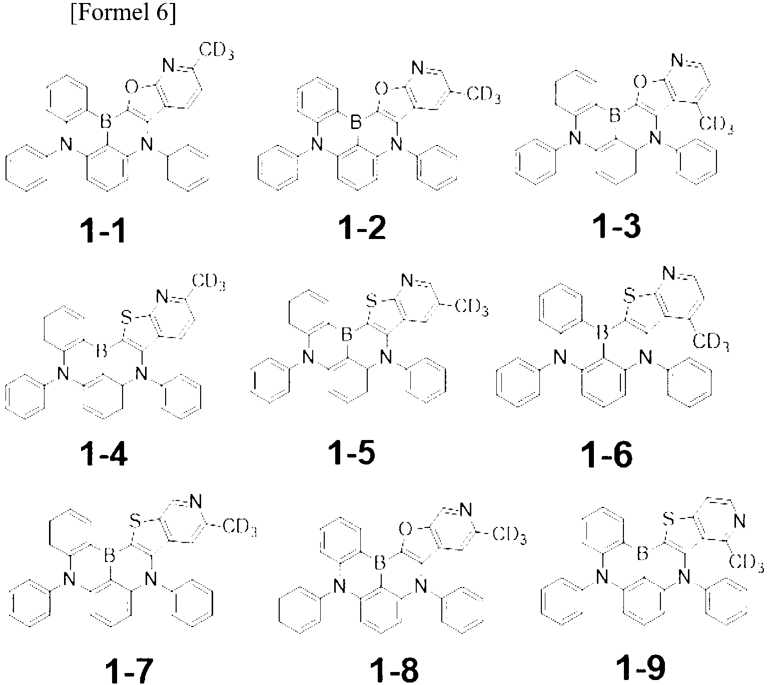

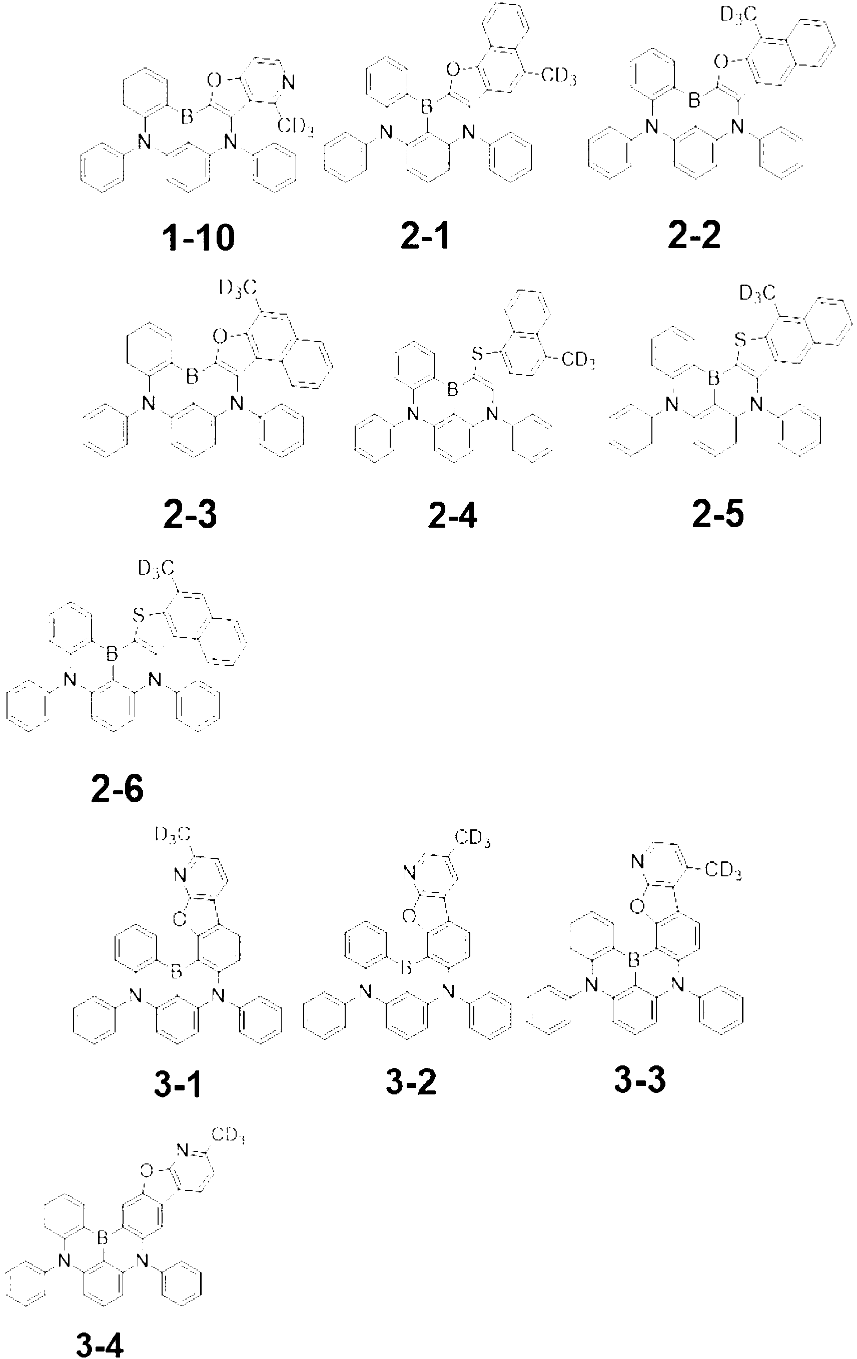

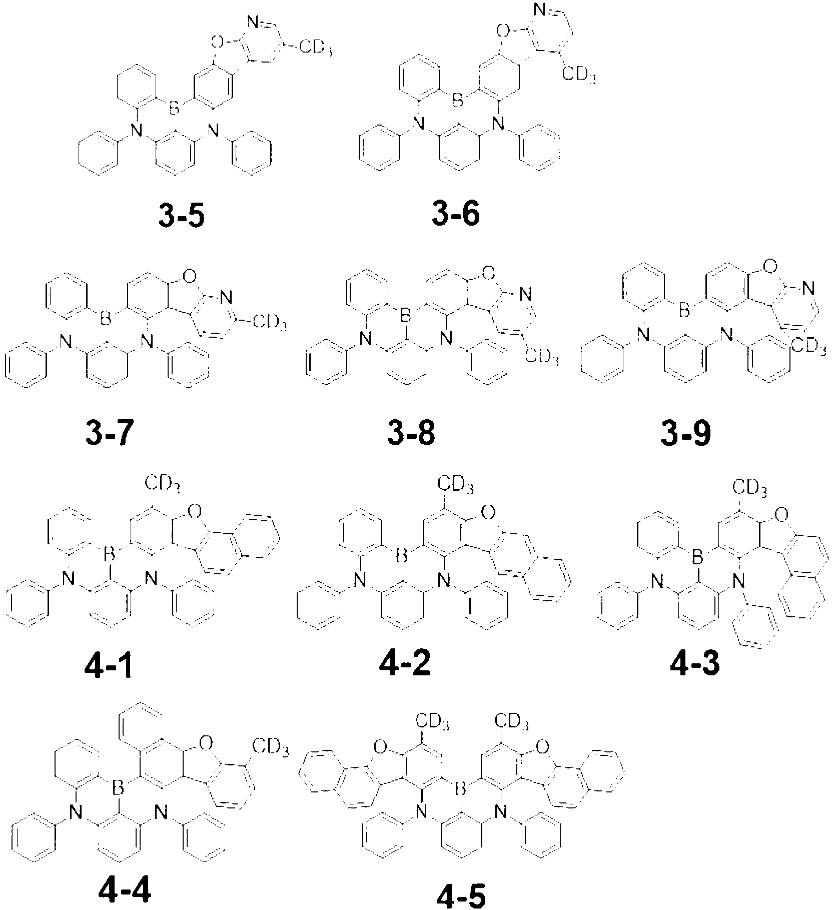

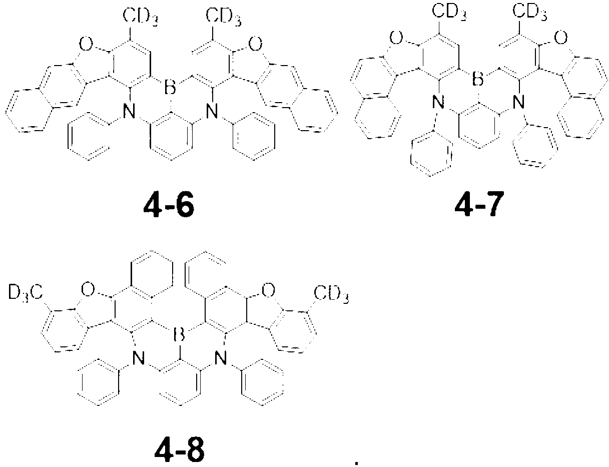

10. Organische Lichtemissionsvorrichtung, die umfasst:
ein Substrat (110); und
eine organische Leuchtdiode (D), die auf dem Substrat positioniert ist und eine erste Elektrode umfasst;
eine zweite Elektrode (164), die der ersten Elektrode (160) zugewandt ist;
und eine erste Emissionsmaterialschicht (162) mit einer ersten Verbindung, die zwischen der ersten und der zweiten Elektrode positioniert ist,
wobei die erste Verbindung die Emissionsverbindung nach einem der vorangehenden Ansprüche ist.

11. Organische Lichtemissionsvorrichtung nach Anspruch 10, wobei die erste Emissionsmaterialschicht ferner eine zweite Verbindung umfasst,
wobei die zweite Verbindung durch Formel 7 dargestellt ist: 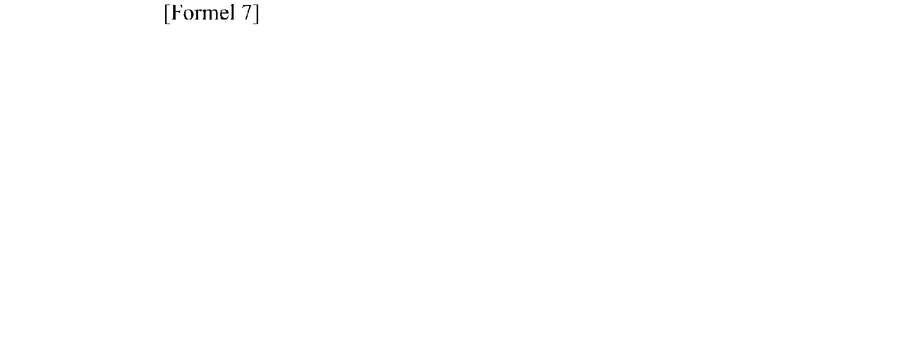 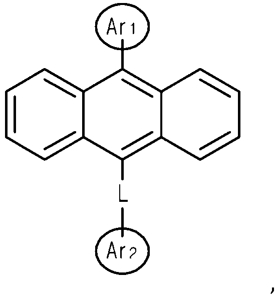
wobei jedes von Ar₁ und Ar₂ unabhängig eine C6- bis C30-Arylgruppe oder C5-bis C30-Heteroarylgruppe ist, L eine Einfachbindung oder eine C6- bis C30-Arylengruppe ist, und
wobei Wasserstoffe nicht deuteriert oder teilweise oder vollständig deuteriert sind.

## Revendications

1. Composé d'émission représenté par la Formule 1 : 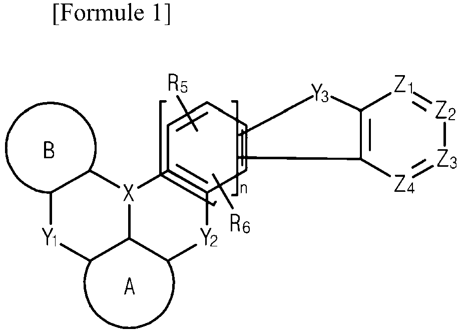
dans laquelle n vaut 0 ou 1,
X est un élément parmi B, P=O et P=S,
chaque élément parmi Y₁ et Y₂ est choisi indépendamment parmi le groupe constitué de NR₁, C(R₂)₂, O, S, Se et Si(R₃)₂, et
Y₃ est O ou S,
dans laquelle chaque élément de Z₁ à Z₄ est indépendamment N ou CR₄, et au moins trois éléments de Z₁ à Z₄ sont CR₄,
dans laquelle chaque élément de R₁ à R₃ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀,
dans laquelle chaque élément de R₄ à R₆ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀, ou deux éléments adjacents de R₄ à R₆ sont liés l'un à l'autre pour former un cycle fusionné, et au moins un élément de R₄ à R₆ est un alkyle en C₁ à C₁₀ substitué par du deutérium, et
dans laquelle chacun des cycles A et B est choisi indépendamment parmi le groupe constitué d'un cycle cycloalkyle à six chaînons substitué ou non substitué, d'un cycle aromatique à six chaînons substitué ou non substitué, et d'un cycle hétéroaromatique à six chaînons substitué ou non substitué,
la Formule 1 étant représentée par une formule parmi la Formule 2-1, la Formule 3-1, la Formule 4-1 et la Formule 5-1 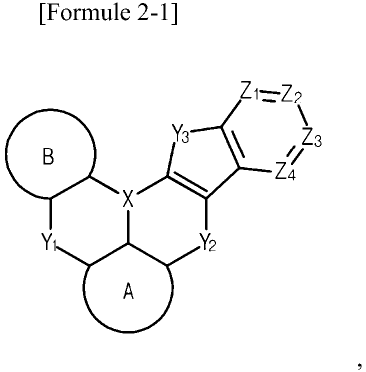 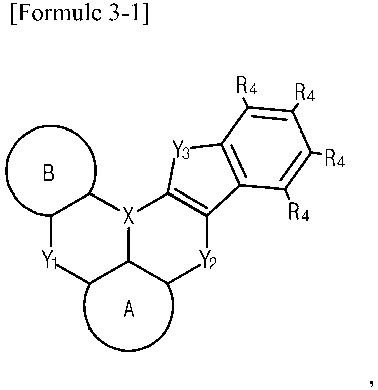 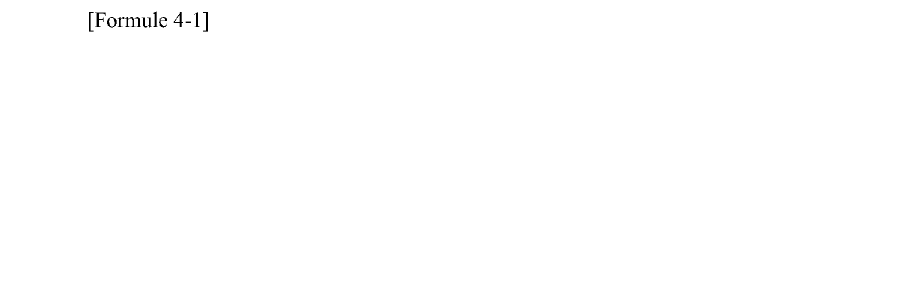 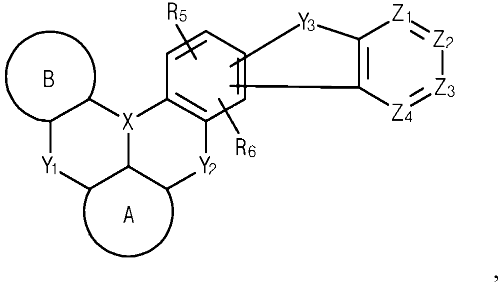 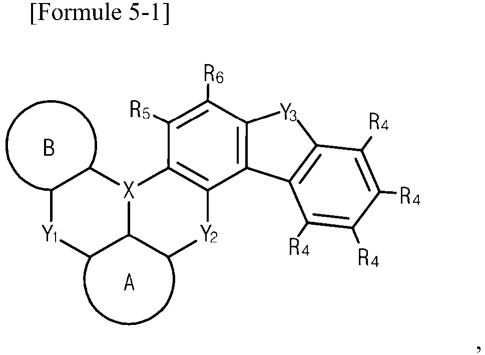
dans la Formule 2-1, un élément de Z₁ à Z₄ étant N, trois éléments de Z₁ à Z₄ étant CR₄, l'un des trois R₄ étant un groupe alkyle en C₁ à C₁₀ substitué par du deutérium, et le reste des trois R₄ étant l'hydrogène,
dans la Formule 3-1, deux éléments adjacents de R₄ étant liés l'un à l'autre pour former un cycle fusionné, l'un des deux autres R₄ étant un alkyle en C₁ à C₁₀ substitué par du deutérium, et l'autre des deux autres R₄ étant l'hydrogène,
dans la Formule 4-1, l'un des Z₁ à Z₄ étant N, trois des Z₁ à Z₄ étant CR₄, l'un des trois R₄ étant un groupe alkyle en C₁ à C₁₀ substitué par du deutérium, et le reste des trois R₄ étant l'hydrogène, et
dans la Formule 5-1, deux éléments adjacents des quatre R₄ ou R₅ et R₆ étant liés pour former un cycle fusionné, l'un des quatre autres éléments parmi R₄, R₅ et R₆ étant un groupe alkyle en C₁ à C₁₀ substitué par du deutérium, et le reste des quatre autres éléments parmi R₄, R₅ et R₆ étant l'hydrogène.

2. Composé d'émission selon la revendication 1, dans lequel la Formule 2-1 est représentée par la Formule 2-2 : 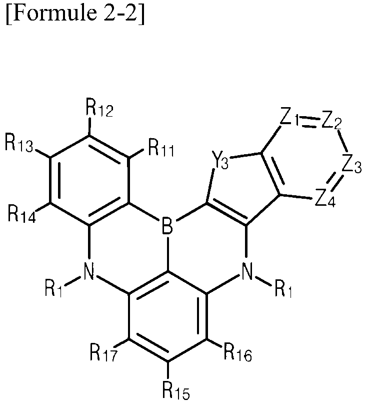 dans laquelle chaque élément de R₁₁ à R₁₇ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀.

3. Composé d'émission selon la revendication 1, dans lequel la Formule 3-1 est représentée par la Formule 3-2 : 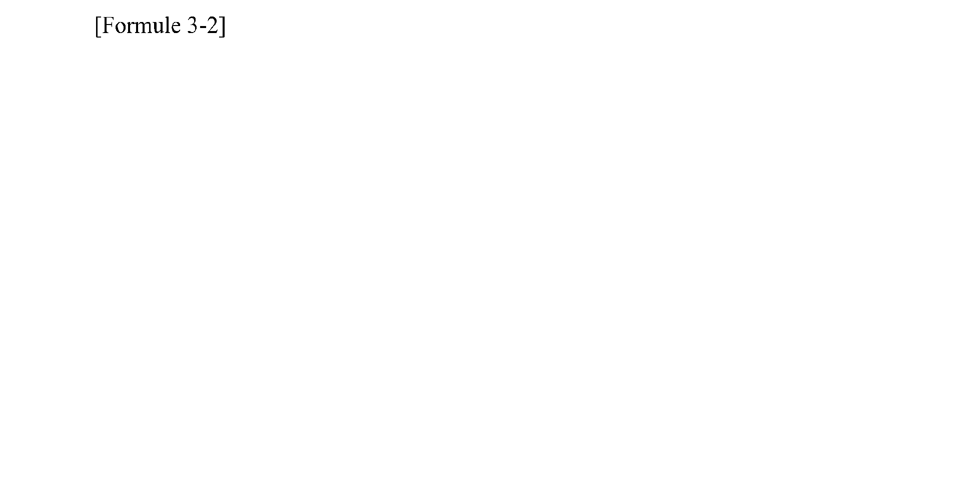 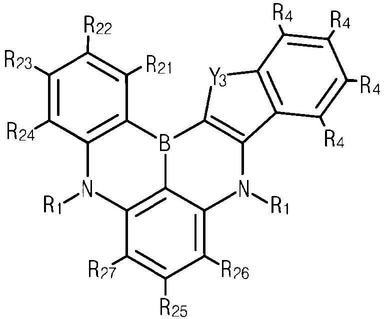 dans laquelle chaque élément de R₂₁ à R₂₇ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀.

4. Composé d'émission selon la revendication 1, dans lequel la Formule 4-1 est représentée par l'une des Formules 4-2 à 4-4 : 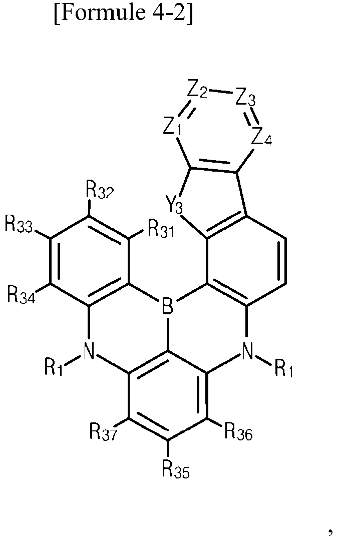 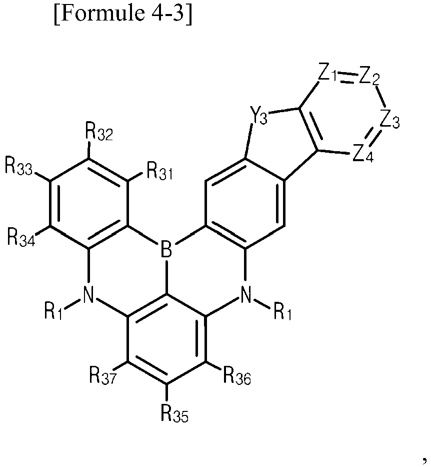 et 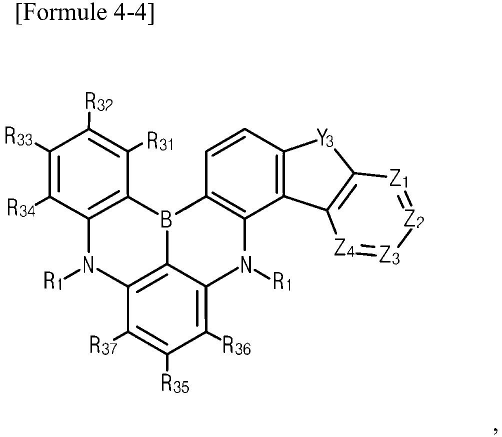 dans lesquelles chaque élément de R₃₁ à R₃₇ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀.

5. Composé d'émission selon la revendication 4, dans lequel les Formules 4-2 à 4-4 sont respectivement représentées par les Formules 4-5 à 4-7 : 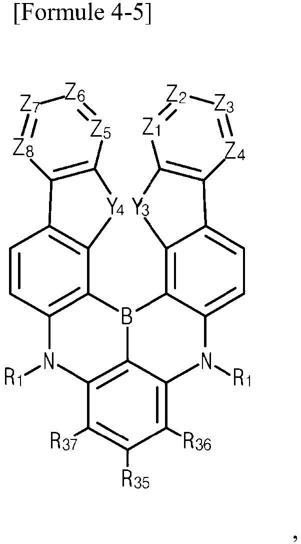 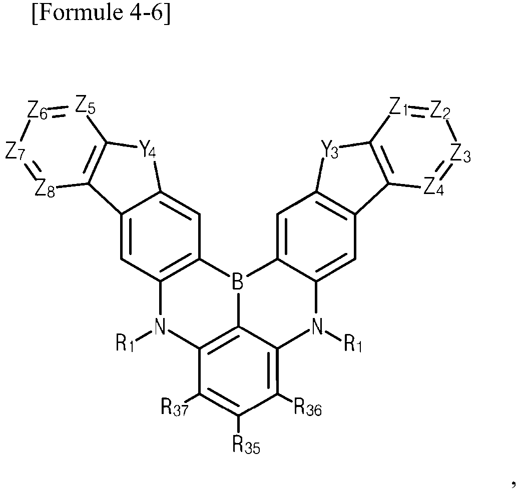 et 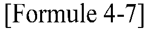 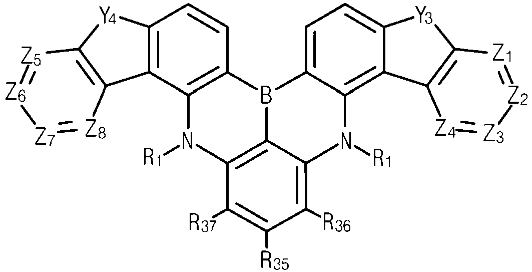
dans les Formules 4-5 à 4-7, Y₄ étant O ou S,
dans lesquelles un élément de Z₅ à Z₈ est N, et les trois autres éléments de Z₅ à Z₈ sont CR₇,
dans lesquelles chacun des trois R₇ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀, et au moins un des trois R₇ est un groupe alkyle en C₁ à C₁₀ substitué par du deutérium, et
dans lesquelles chaque élément de R₃₅ à R₃₇ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀.

6. Composé d'émission selon la revendication 1, dans lequel la Formule 5-1 est représentée par la Formule 5-2 : 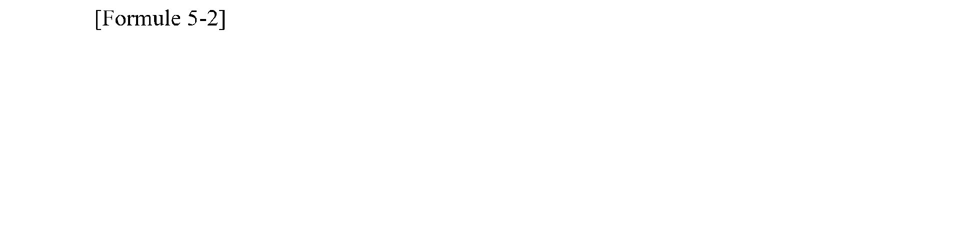 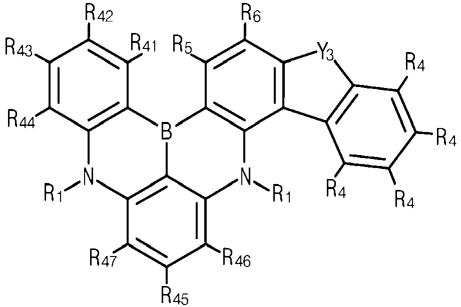 dans laquelle chaque élément de R₄₁ à R₄₇ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀.

7. Composé d'émission selon la revendication 1, dans lequel la Formule 5-1 est représentée par la Formule 5-3 : 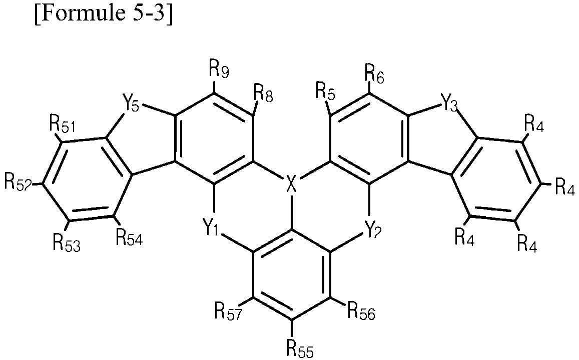
dans la Formule 5-3, Y₅ étant O ou S,
dans laquelle deux éléments adjacents des quatre R₄ ou R₅ et R₆ sont liés pour former un cycle fusionné, et au moins un des quatre autres R₄, R₅ et R₆ est un groupe alkyle en C₁ à C₁₀ substitué par du deutérium,
dans laquelle chaque élément parmi R₈, R₉ et R₅₁ à R₅₄ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀, et d'un groupe hétéroaryle en C₅ à C₃₀ non substitué parmi du deutérium ou un alkyle en C₁ à C₁₀, ou deux éléments adjacents parmi R₅₁ à R₅₄ ou R₈ et R₉ sont liés pour former un cycle fusionné,
dans laquelle au moins un des quatre autres R₈, R₉ et R₅₁ à R₅₄ est un groupe alkyle en C₁ à C₁₀ substitué par du deutérium, et
dans laquelle chaque élément de R₅₅ à R₅₇ est choisi indépendamment parmi le groupe constitué de l'hydrogène, du deutérium, d'un groupe alkyle en C₁ à C₁₀ non substitué ou substitué par du deutérium, d'un groupe arylamine en C₆ à C₃₀ non substitué ou substitué par du deutérium ou un alkyle en C₁ à C₁₀, d'un groupe aryle en C₆ à C₃₀ non substitué ou substitué par du deutérium ou un alkyle en C₁ à C₁₀, et d'un groupe hétéroaryle en C₅ à C₃₀ non substitué ou substitué par du deutérium ou un alkyle en C₁ à C₁₀.

8. Composé d'émission selon la revendication 1, dans lequel la Formule 5-3 est représentée par la Formule 5-4 :

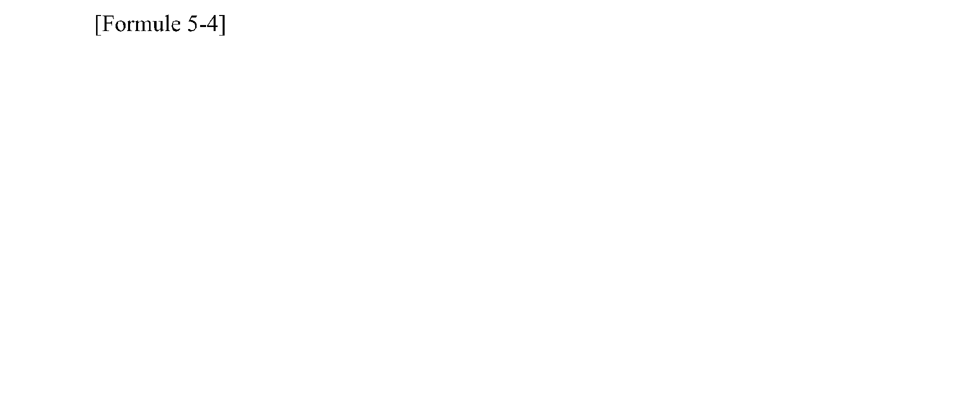

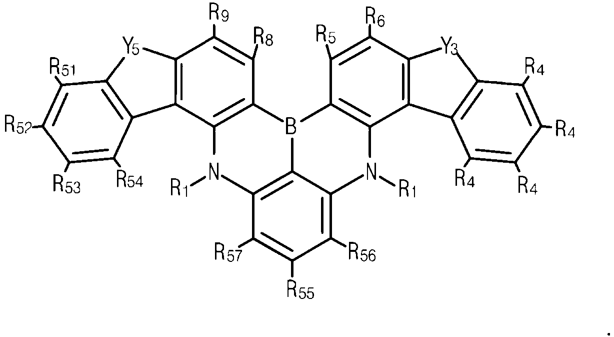

9. Composé d'émission selon la revendication 1, dans lequel le composé d'émission est un composé choisi parmi le groupe de composés représentés par la Formule 6 :

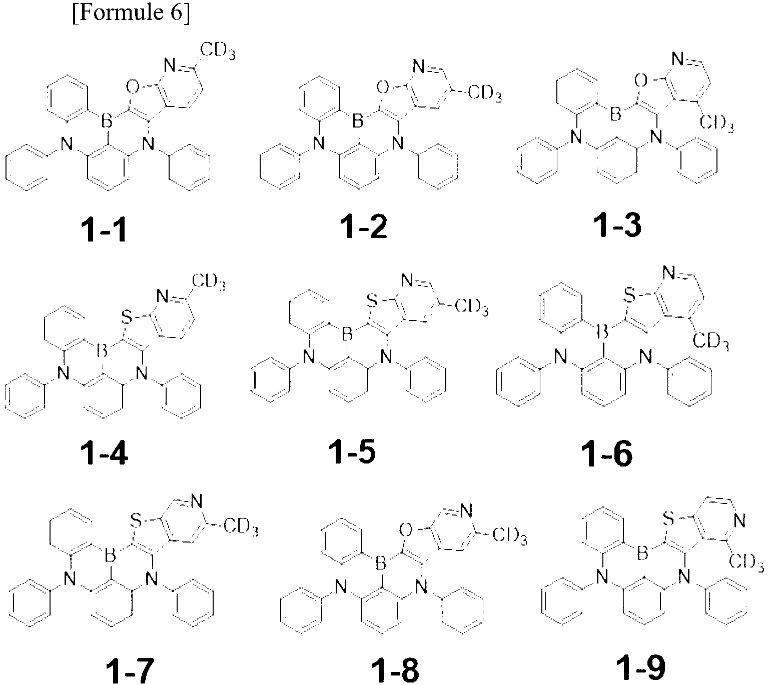

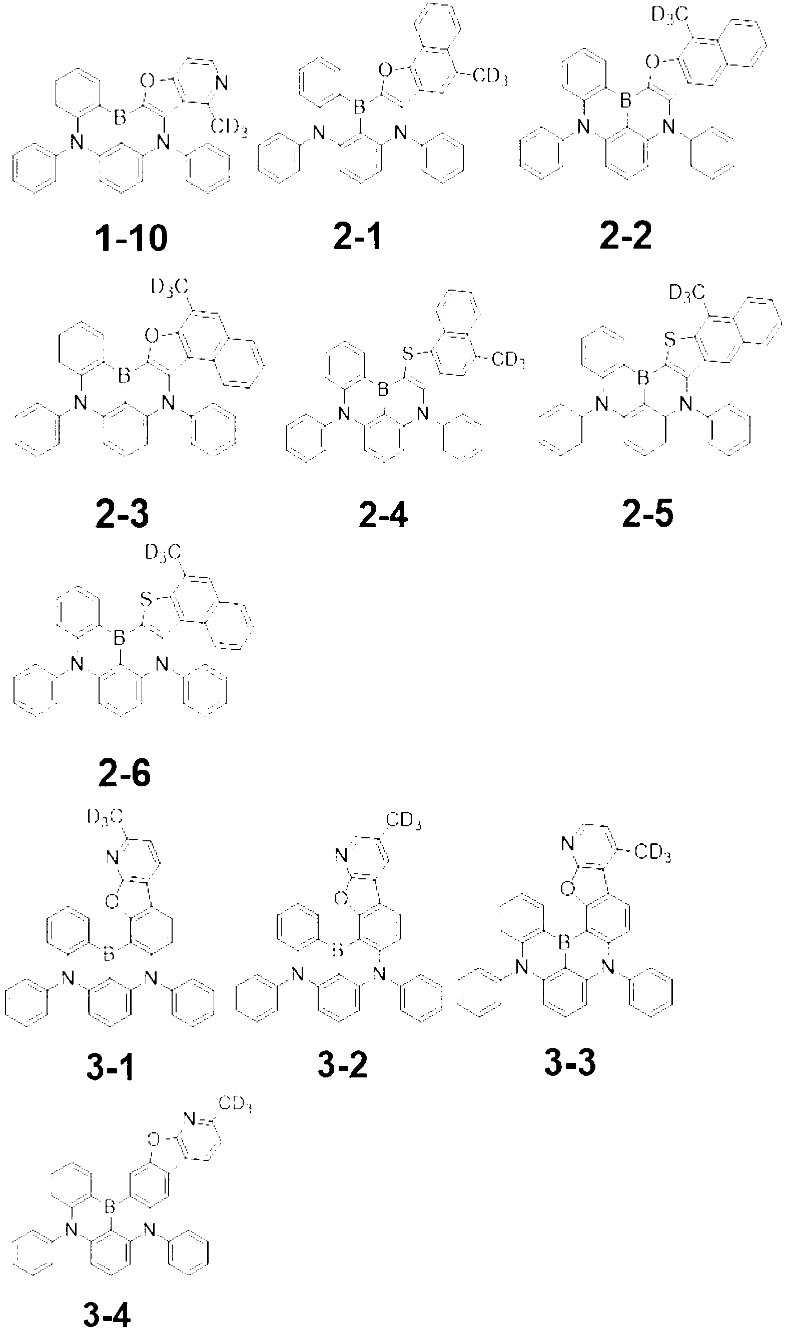

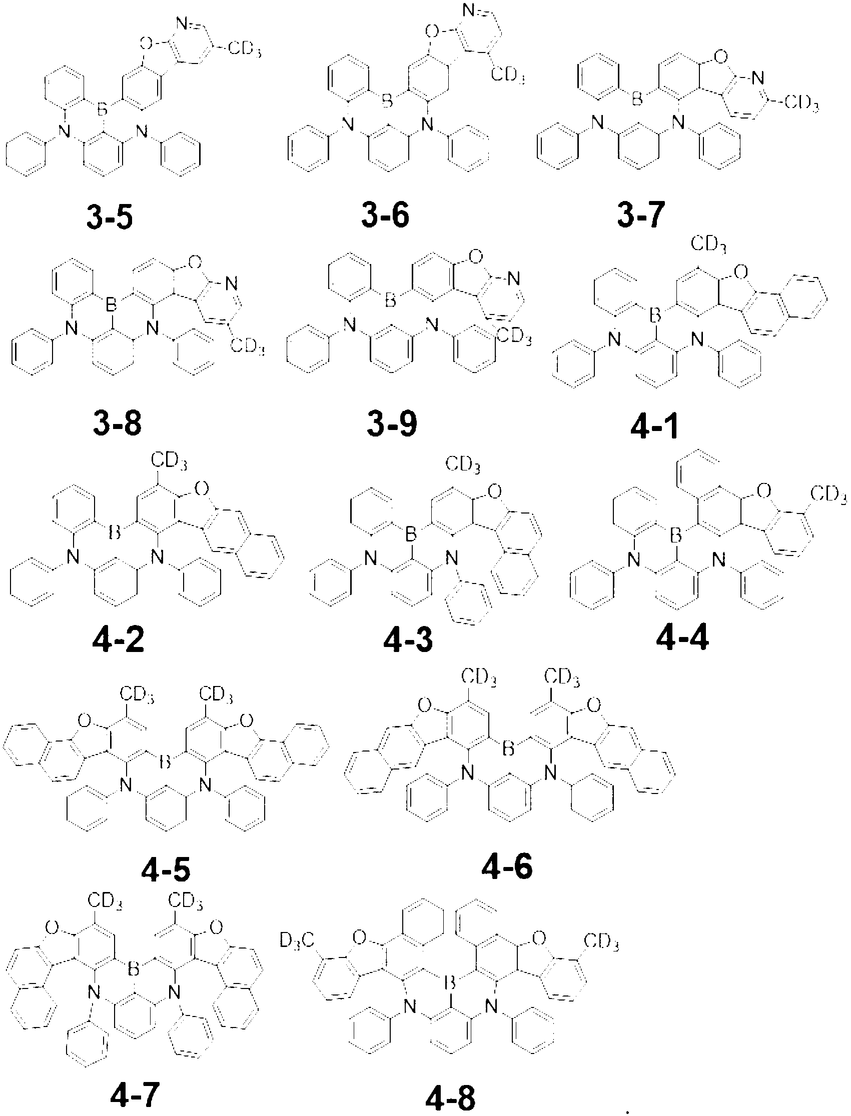

10. Dispositif électroluminescent organique, comportant :
un substrat (110) ; et
une diode électroluminescente organique (D) positionnée sur le substrat et incluant une première électrode ; une seconde électrode (164) dirigée vers la première électrode (160) ; et une première couche de matériau d'émission (162) incluant un premier composé et positionnée entre les première et seconde électrodes,
dans lequel le premier composé est le composé d'émission selon l'une quelconque des revendications précédentes.

11. Dispositif électroluminescent organique selon la revendication 10, dans lequel la première couche de matériau d'émission inclut en outre un second composé,
dans lequel le second composé est représenté par la Formule 7 : 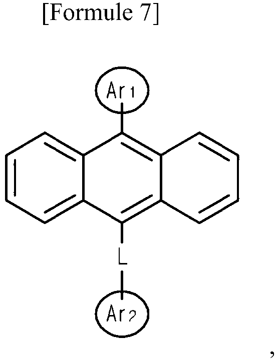
dans laquelle chacun élément parmi Ar₁ et Ar₂ est indépendamment un groupe aryle en C₆ à C₃₀ ou un groupe hétéroaryle en C₅ à C₃₀, L est une liaison simple ou un groupe arylène en C₆ à C₃₀, et
dans lequel les hydrogènes ne sont pas deutérés ou sont partiellement ou totalement deutérés.
